(19) Europäisches Patentamt
European Patent Office
Office européen des brevets

(11) EP 3 885 378 A1

(12) **EUROPEAN PATENT APPLICATION**
published in accordance with Art. 153(4) EPC

(43) Date of publication:
**29.09.2021 Bulletin 2021/39**

(21) Application number: **19887830.8**

(22) Date of filing: **12.11.2019**

(51) Int Cl.:
***C08F 220/28*** *(2006.01)* ***G03F 7/004*** *(2006.01)*
***G03F 7/038*** *(2006.01)* ***G03F 7/039*** *(2006.01)*
***G03F 7/20*** *(2006.01)*

(86) International application number:
**PCT/JP2019/044308**

(87) International publication number:
**WO 2020/105505 (28.05.2020 Gazette 2020/22)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.11.2018 JP 2018219441**

(71) Applicant: **FUJIFILM Corporation**
**Tokyo 106-8620 (JP)**

(72) Inventors:
- **OU Keiyu**
**Haibara-gun, Shizuoka 421-0396 (JP)**
- **TANGO Naohiro**
**Haibara-gun, Shizuoka 421-0396 (JP)**
- **TAKAHASHI Hidenori**
**Haibara-gun, Shizuoka 421-0396 (JP)**
- **GOTO Akiyoshi**
**Haibara-gun, Shizuoka 421-0396 (JP)**
- **KAWABATA Takeshi**
**Haibara-gun, Shizuoka 421-0396 (JP)**
- **YOSHIMURA Tsutomu**
**Haibara-gun, Shizuoka 421-0396 (JP)**

(74) Representative: **HGF**
**1 City Walk**
**Leeds LS11 9DX (GB)**

(54) **ACTINIC RAY-SENSITIVE OR RADIATION-SENSITIVE RESIN COMPOSITION, RESIST FILM, PATTERN FORMATION METHOD, AND PRODUCTION METHOD FOR ELECTRONIC DEVICE**

(57) An object of the present invention is to provide an actinic ray-sensitive or radiation-sensitive resin composition, in which the cross-sectional shape of a pattern thus formed has excellent rectangularity and a dimensional variation of the line width of the pattern thus formed hardly occurs even over time after preparation. Furthermore, another object of the present invention is to provide a resist film, a pattern forming method, and a method for manufacturing an electronic device, each using the actinic ray-sensitive or radiation-sensitive resin composition.

The actinic ray-sensitive or radiation-sensitive resin composition of an embodiment of the present invention includes a resin having a polarity that increases through decomposition by an action of an acid, a compound that generates an acid upon irradiation with actinic rays or radiation, and a halogen-based solvent, in which a content of the halogen-based solvent is from 1 ppb by mass to 50 ppm by mass with respect to a total mass of the composition.

FIG. 2

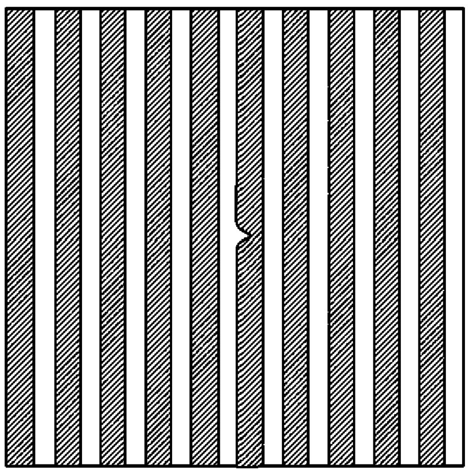



Printed by Jouve, 75001 PARIS (FR)

## Description

## BACKGROUND OF THE INVENTION

1. Field of the Invention

The present invention relates to an actinic ray-sensitive or radiation-sensitive resin composition, a resist film, a pattern forming method, and a method for manufacturing an electronic device.

2. Description of the Related Art

In processes for manufacturing semiconductor devices such as an integrated circuit (IC) and a large scale integrated circuit (LSI) in the related art, microfabrication by lithography using a chemically amplified resist composition has been performed.

For example, JP2011-227509A discloses a resist composition that includes an acid-decomposable resin including a repeating unit derived from 1-ethyl-1-cyclohexyl methacrylate, a repeating unit derived from $\gamma$-butyrolactone methacrylate, and a repeating unit derived from 3-hydroxy-1-adamantyl methacrylate, and a triarylsulfonium salt type photoacid generator such as diphenyl-3-methylphenylsulfonium nonafluorobutane sulfonate.

## SUMMARY OF THE INVENTION

The present inventors have investigated the resist composition described in JP2011-227509A, and have clarified that in a case where the resist composition is stored for a long period of time, a variation in the dimension of the line width of a pattern obtained after exposure and development occurs. That is, the present inventors have found that there was room for a further improvement of the temporal stability of the resist composition.

On the other hand, it has also been required that the cross-sectional shape of a pattern formed with the resist composition has excellent rectangularity.

Therefore, an object of the present invention is to provide an actinic ray-sensitive or radiation-sensitive resin composition, in which the cross-sectional shape of a pattern thus formed has excellent rectangularity and a dimensional variation of the line width of the pattern thus formed hardly occurs even with the lapse of time after preparation.

In addition, another object of the present invention is to provide a resist film, a pattern forming method, and a method for manufacturing an electronic device, each of which uses the actinic ray-sensitive or radiation-sensitive resin composition.

The present inventors have conducted intensive investigations to accomplish the objects, and as a result, they have found that the objects can be accomplished with an actinic ray-sensitive or radiation-sensitive resin composition having a predetermined composition, thereby completing the present invention.

[1] An actinic ray-sensitive or radiation-sensitive resin composition comprising:

a resin having a polarity that increases through decomposition by an action of an acid;
a compound that generates an acid upon irradiation with actinic rays or radiation; and
a halogen-based solvent,
in which a content of the halogen-based solvent is from 1 ppb by mass to 50 ppm by mass with respect to a total mass of the composition.

[2] The actinic ray-sensitive or radiation-sensitive resin composition as described in [1],
in which the content of the halogen-based solvent is from 1 ppb by mass to 10 ppm by mass with respect to the total mass of the composition.

[3] The actinic ray-sensitive or radiation-sensitive resin composition as described in [1] or [2],
in which the content of the halogen-based solvent is from 1 ppb by mass to 1 ppm by mass with respect to the total mass of the composition.

[4] The actinic ray-sensitive or radiation-sensitive resin composition as described in any one of [1] to [3], further comprising metal atoms,
in which a content of the metal atoms is from 1 ppt by mass to 30 ppb by mass with respect to the total mass of the composition.

[5] The actinic ray-sensitive or radiation-sensitive resin composition as described in [4],
in which the content of the metal atoms is from 1 ppt by mass to 10 ppb by mass with respect to the total mass of the composition.

[6] The actinic ray-sensitive or radiation-sensitive resin composition as described in [4] or [5],
in which the content of the metal atoms is from 1 ppt by mass to 1,000 ppt by mass with respect to the total mass of the composition.
[7] The actinic ray-sensitive or radiation-sensitive resin composition as described in any one of [1] to [6],
in which the resin includes one or more selected from the group consisting of Resins X1 to X3:

Resin X1: a resin including a repeating unit A derived from one or more monomers selected from a monomer group A which will be described later, and a repeating unit B derived from one or more monomers selected from a monomer group B which will be described later,
Resin X2: a resin including a repeating unit A derived from one or more monomers selected from a monomer group A which will be described later, a repeating unit B derived from one or more monomers selected from a monomer group B which will be described later, and a repeating unit C derived from one or more monomers selected from a monomer group C which will be described later, and
Resin X3: a resin including a repeating unit including an aromatic ring, and at least one repeating unit of a repeating unit A derived from one or more monomers selected from a monomer group A which will be described later or a repeating unit B derived from one or more monomers selected from a monomer group B which will be described later.

[8] The actinic ray-sensitive or radiation-sensitive resin composition as described in [7],
in which the monomer group A is a monomer group A1 which will be described later.
[9] The actinic ray-sensitive or radiation-sensitive resin composition as described in [7] or [8],
in which the monomer group B is a monomer group B1 which will be described later.
[10] The actinic ray-sensitive or radiation-sensitive resin composition as described in any one of [7] to [9],
in which the monomer group C is a monomer group C1 which will be described later.
[11] The actinic ray-sensitive or radiation-sensitive resin composition as described in any one of [7] to [10],
in which the repeating unit including an aromatic ring includes a repeating unit derived from at least one monomer of Formula (d-1) or Formula (d-2) which will be described later.
[12] The actinic ray-sensitive or radiation-sensitive resin composition as described in any one of [1] to [11],
in which the resin is a resin selected from the group consisting of Formula (A-1) which will be described later, Formula (A-3) which will be described later, Formula (A-4) which will be described later, Formula (A-6) which will be described later, Formula (A-8) which will be described later, Formula (A-12) which will be described later, Formula (A-13) which will be described later, Formula (A-14) which will be described later, Formula (A-16) which will be described later, Formula (A-19) which will be described later, Formula (A-41) which will be described later, Formula (A-42) which will be described later, Formula (A-43) which will be described later, Formula (A-46) which will be described later, and Formula (A-48) which will be described later.
[13] The actinic ray-sensitive or radiation-sensitive resin composition as described in any one of [1] to [12],
in which the compound that generates an acid upon irradiation with actinic rays or radiation includes one or more compounds selected from the group consisting of Formulae (P-1) to (P-14) which will be described later.
[14] The actinic ray-sensitive or radiation-sensitive resin composition as described in any one of [1] to [13], further comprising an acid diffusion control agent.
[15] The actinic ray-sensitive or radiation-sensitive resin composition as described in any one of [1] to [14],
in which the actinic ray-sensitive or radiation-sensitive resin composition includes methylene chloride as the halogen-based solvent.
[16] A resist film obtained using the actinic ray-sensitive or radiation-sensitive resin composition as described in any one of [1] to [15].
[17] A pattern forming method comprising:

a step of forming a resist film on a substrate, using the actinic ray-sensitive or radiation-sensitive resin composition as described in any one of [1] to [15];
a step of exposing the resist film; and
a step of developing the exposed resist film using a developer to form a pattern.

[18] A method for manufacturing an electronic device, comprising the pattern forming method as described in [17].

According to the present invention, it is possible to provide an actinic ray-sensitive or radiation-sensitive resin composition, in which the cross-sectional shape of a pattern thus formed has excellent rectangularity and a dimensional variation of the line width of the pattern thus formed hardly occurs even with the lapse of time after preparation.
In addition, according to the present invention, it is possible to provide a resist film, a pattern forming method,

and a method for manufacturing an electronic device, each using the actinic ray-sensitive or radiation-sensitive resin composition.

## BRIEF DESCRIPTION OF THE DRAWINGS

Fig. 1 is a schematic view for illustrating an evaluation method for evaluation of a shape after pattern formation.
Fig. 2 is a schematic view for illustrating an evaluation method for defect evaluation after pattern formation, and is an example of a defect observed by a length-measuring scanning electron microscope (SEM).
Fig. 3 is a schematic view for illustrating an evaluation method for defect evaluation after pattern formation, and is another example of a defect observed by a length-measuring scanning electron microscope (SEM).

## DESCRIPTION OF THE PREFERRED EMBODIMENTS

Hereinafter, an example of forms for carrying out the present invention will be described.
In the present specification, a numerical value range expressed using "to" means a range that includes the preceding and succeeding numerical values of "to" as a lower limit value and an upper limit value, respectively.
"Actinic rays" or "radiation" in the present specification means, for example, a bright line spectrum of a mercury lamp, far ultraviolet rays typified by an excimer laser, extreme ultraviolet rays (EUV light), X-rays, electron beams (EB), or the like. "Light" in the present specification means actinic rays or radiation.
Unless otherwise specified, "exposure" in the present specification encompasses not only exposure by a bright line spectrum of a mercury lamp, far ultraviolet rays typified by an excimer laser, extreme ultraviolet rays, X-rays, EUV light, or the like, but also lithography by particle beams such as electron beams and ion beams.
In citations for a group (atomic group) in the present specification, in a case where the group is cited without specifying whether it is substituted or unsubstituted, the group includes both a group having no substituent and a group having a substituent. For example, an "alkyl group" includes not only an alkyl group having no substituent (unsubstituted alkyl group), but also an alkyl group having a substituent (substituted alkyl group).
An "organic group" in the present specification is intended to be a group including one or more carbon atoms.
In the present specification, "(meth)acryl" is a generic term encompassing acryl and methacryl, and means "at least one of acryl or methacryl". Similarly, "(meth)acrylic acid" means "at least one of acrylic acid or methacrylic acid". Similarly, "(meth)acrylate" also means "at least one of acrylate or methacrylate".
In the present specification, the weight-average molecular weight (Mw), the number-average molecular weight (Mn), and the dispersity (also referred to as a molecular weight distribution) (Mw/Mn) of a resin are each defined as a value expressed in terms of polystyrene by means of gel permeation chromatography (GPC) measurement (solvent: tetrahydrofuran, flow amount (amount of a sample injected): 10 μL, columns: TSK gel Multipore HXL-M manufactured by Tosoh Corporation, column temperature: 40°C, flow rate: 1.0 mL/min, detector: refractive index detector) using a GPC device (HLC-8120 GPC manufactured by Tosoh Corporation).
The acid dissociation constant pKa in the present specification refers to an acid dissociation constant pKa in an aqueous solution, and is defined, for example, in Chemical Handbook (II) (Revised 4th Edition, 1993, compiled by the Chemical Society of Japan, Maruzen Company, Ltd.). A lower value of the acid dissociation constant pKa indicates a higher acid strength. Specifically, the acid dissociation constant pKa in an aqueous solution can be actually measured by using an infinite-dilution aqueous solution and measuring the acid dissociation constant at 25°C. Alternatively, the acid dissociation constant pKa can also be determined using the following software package 1 by computation from a value based on a Hammett substituent constant and the database of publicly known literature values. Any of the values of pKa described in the present specification indicate values determined by computation using the software package.
Software Package 1: Advanced Chemistry Development (ACD/Labs) Software V 8.14 for Solaris (1994 - 2007 ACD/Labs).
In addition in the present specification, "ppm" means "parts-per-million", "ppb" means "parts-per-billion", and "ppt" means "parts-per-trillion".
1 Å is $1 \times 10^{-10}$ m.

[Actinic Ray-Sensitive or Radiation-Sensitive Resin Composition]

As a characteristic feature of the actinic ray-sensitive or radiation-sensitive resin composition of an embodiment of the present invention (hereinafter also referred to as a "resist composition"), it may be mentioned that the actinic ray-sensitive or radiation-sensitive resin composition includes a halogen-based solvent and the content of the halogen-based solvent is from 1 ppb by mass to 50 ppm by mass with respect to the total mass of the composition.

Recently, the present inventors have found that a halogen-based solvent such as methylene chloride is a factor capable of affecting the temporal stability of a resist composition (in particular, a dimensional variation of the line width of a pattern) and the cross-sectional shape of a pattern thus formed. It is presumed that the halogen-based solvent such as methylene chloride is generally widely used in the synthesis of a photoacid generator (in particular, a sulfonium salt structure type photoacid generator), and is often incorporated into the resist composition through the photoacid generator.
The present inventors have found that a dimensional variation of the line width of a pattern thus formed hardly occurs even in a case where the resist composition is left over time after preparation by repeating purification before adding the photoacid generator to the resist composition to adjust the content of a halogen-based solvent in the resist composition to 50 ppm by mass or less with respect to the total mass of the composition. On the other hand, the present inventors have found that the cross-sectional shape of a pattern formed with the resist composition deteriorates in a case where the content of the halogen-based solvent is less than 1 ppb by mass with respect to the total mass of the composition. The mechanism of action is not clear, but it is considered that in a case where the halogen-based solvent is less than 1 ppb by mass, the solubility of the photoacid generator in the resist composition is reduced, leading to deterioration of the cross-sectional shape of a pattern thus formed.
In addition, the present inventors have recently confirmed that in a case where the resist composition includes metal atoms and the content of the metal atoms is from 1 ppt by mass to 30 ppb by mass with respect to a total mass of the composition, a pattern thus formed has excellent etching resistance and defects are hardly generated in a substrate (for example, a silicon wafer) to be etched using the upper pattern as a mask.
In a case where the content of the metal atoms is less than 1 ppt by mass with respect to the total mass of the composition, the etching resistance of the pattern thus formed is low, and as a result, the cross-sectional shape of the substrate after etching may be deteriorated. On the other hand, in a case where the content of the metal atoms is more than 30 ppb by mass with respect to the total mass of the composition, defects may be easily generated in the substrate after etching.
The resist composition of the embodiment of the present invention may be either a positive-tone resist composition or a negative-tone resist composition. In addition, the resist composition may be either a resist composition for alkali development or a resist composition for organic solvent development.
The resist composition of the embodiment of the present invention is typically a chemically amplified resist composition.
Hereinbelow, first, various components of the resist composition of the embodiment of the present invention will be described in detail.

[Resin (A)]

The resist composition of the embodiment of the present invention includes a resin (hereinafter also referred to as an "acid-decomposable resin" or a "resin (A)") having a polarity that increases through decomposition by the action of an acid.
That is, in the pattern forming method of an embodiment of the present invention which will be described later, typically, in a case where an alkaline developer is adopted as the developer, a positive-tone pattern is suitably formed, and in a case where an organic developer is adopted as the developer, a negative-tone pattern is suitably formed.
The resin (A) usually includes a repeating unit having a group having a polarity that increases through decomposition by the action of an acid (hereinafter also referred to as an "acid-decomposable group"), and preferably includes a repeating unit having an acid-decomposable group.

<Repeating Unit Having Acid-Decomposable Group>

The acid-decomposable group is a group that decomposes by the action of an acid to produce a polar group. The acid-decomposable group preferably has a structure in which the polar group is protected with a leaving group that leaves by the action of an acid. That is, the resin (A) has a repeating unit having a group that decomposes by the action of an acid to produce a polar group. A resin having this repeating unit has an increased polarity by the action of an acid, and thus has an increased solubility in an alkaline developer, and a decreased solubility in an organic solvent.
As the polar group, an alkali-soluble group is preferable, and examples thereof include an acidic group such as a carboxyl group, a phenolic hydroxyl group, a fluorinated alcohol group, a sulfonic acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)imide group, a tris(alkylcarbonyl)methylene group, and a tris(alkylsulfonyl)methylene group, and an alcoholic hydroxyl group.
Among those, as the polar group, the carboxyl group, the phenolic hydroxyl group, the fluorinated alcohol group (preferably a hexafluoroisopropanol group), or the sulfonic acid group is preferable.

Examples of the leaving group that leaves by the action of an acid include groups represented by Formulae (Y1) to (Y4).

Formula (Y1): $-C(Rx_1)(Rx_2)(Rx_3)$
Formula (Y2): $-C(=O)OC(Rx_1)(Rx_2)(Rx_3)$
Formula (Y3): $-C(R_{36})(R_{37})(OR_{38})$
Formula (Y4): -C(Rn)(H)(Ar)

In Formula (Y1) and Formula (Y2), $Rx_1$ to $Rx_3$ each independently represent an (linear or branched) alkyl group or a (monocyclic or polycyclic) cycloalkyl group. Further, in a case where all of $Rx_1$ to $Rx_3$ are (linear or branched) alkyl groups, it is preferable that at least two of $Rx_1$, $Rx_2$, or $Rx_3$ are methyl groups.
Above all, it is preferable that $Rx_1$ to $Rx_3$ each independently represent a linear or branched alkyl group, and it is more preferable that $Rx_1$ to $Rx_3$ each independently represent the linear alkyl group.
Two of $Rx_1$ to $Rx_3$ may be bonded to each other to form a monocycle or a polycycle.
As the alkyl group of each of $Rx_1$ to $Rx_3$, an alkyl group having 1 to 4 carbon atoms, such as a methyl group, an ethyl group, an n-propyl group, an isopropyl group, an n-butyl group, an isobutyl group, and a t-butyl group, is preferable.
As the cycloalkyl group of each of $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.
As the cycloalkyl group formed by the bonding of two of $Rx_1$ to $Rx_3$, a monocyclic cycloalkyl group such as a cyclopentyl group and a cyclohexyl group, and a polycyclic cycloalkyl group such as a norbornyl group, a tetracyclodecanyl group, a tetracyclododecanyl group, and an adamantyl group are preferable, and a monocyclic cycloalkyl group having 5 or 6 carbon atoms is more preferable.
In the cycloalkyl group formed by the bonding of two of $Rx_1$ to $Rx_3$, for example, one of the methylene groups constituting the ring may be substituted with a heteroatom such as an oxygen atom, or a group having a heteroatom, such as a carbonyl group.
With regard to the group represented by Formula (Y1) or Formula (Y2), for example, an aspect in which $Rx_1$ is a methyl group or an ethyl group, and $Rx_2$ and $Rx_3$ are bonded to each other to form a cycloalkyl group is preferable.
In Formula (Y3), $R_{36}$ to $R_{38}$ each independently represent a hydrogen atom or a monovalent organic group. $R_{37}$ and $R_{38}$ may be bonded to each other to form a ring. Examples of the monovalent organic group include an alkyl group, a cycloalkyl group, an aryl group, an aralkyl group, and an alkenyl group. It is also preferable that $R_{36}$ is the hydrogen atom.
As Formula (Y3), a group represented by Formula (Y3-1) is preferable.

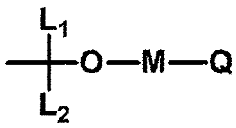
(Y3-1)

Here, $L_1$ and $L_2$ each independently represent a hydrogen atom, an alkyl group, a cycloalkyl group, an aryl group, or a group formed by combination thereof (for example, a group formed by combination of an alkyl group and an aryl group).
M represents a single bond or a divalent linking group.
Q represents an alkyl group which may include a heteroatom, a cycloalkyl group which may include a heteroatom, an aryl group which may include a heteroatom, an amino group, an ammonium group, a mercapto group, a cyano group, an aldehyde group, or a group formed by combination thereof (for example, a group formed by a combination of an alkyl group and a cycloalkyl group).
In the alkyl group and the cycloalkyl group, for example, one of the methylene groups may be substituted with a heteroatom such as an oxygen atom or a group having a heteroatom, such as a carbonyl group.
In addition, it is preferable that one of $L_1$ or $L_2$ is a hydrogen atom, and the other is an alkyl group, a cycloalkyl group, an aryl group, or a group formed by a combination of an alkylene group and an aryl group.
At least two of Q, M, or $L_1$ may be bonded to each other to form a ring (preferably a 5-membered or 6-membered ring).
From the viewpoint of pattern miniaturization, $L_2$ is preferably a secondary or tertiary alkyl group, and more preferably the tertiary alkyl group. Examples of the secondary alkyl group include an isopropyl group, a cyclohexyl group, and a norbornyl group, and examples of the tertiary alkyl group include a tert-butyl group and an adamantane group. In these aspects, since the glass transition temperature (Tg) and the activation energy are increased, it is possible to

suppress fogging in addition to ensuring film hardness.

In Formula (Y4), Ar represents an aromatic ring group. Rn represents an alkyl group, a cycloalkyl group, or an aryl group. Rn and Ar may be bonded to each other to form a non-aromatic ring. Ar is more preferably an aryl group.

The repeating unit having an acid-decomposable group is preferably the repeating unit represented by Formula (A).

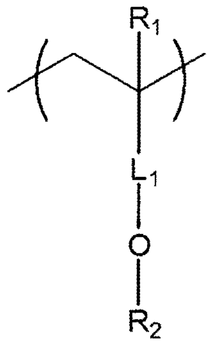

(A)

$L_1$ represents a divalent linking group which may have a fluorine atom or an iodine atom, $R_1$ represents a hydrogen atom, a fluorine atom, an iodine atom, an alkyl group which may have a fluorine atom or an iodine atom, or an aryl group which may have a fluorine atom or an iodine atom, and $R_2$ represents a leaving group that leaves by the action of an acid and may have a fluorine atom or an iodine atom. It should be noted that at least one of $L_1$, $R_1$, or $R_2$ has a fluorine atom or an iodine atom.

$L_1$ represents a divalent linking group which may have a fluorine atom or an iodine atom. Examples of the divalent linking group which may have a fluorine atom or an iodine atom include -CO-, -O-, -S-, -SO-, $-SO_2-$, a hydrocarbon group which may have a fluorine atom or an iodine atom (for example, an alkylene group, a cycloalkylene group, an alkenylene group, and an arylene group), and a linking group formed by the linking of a plurality of these groups. Among those, as $L_1$, -CO- or -arylene group-alkylene group having a fluorine atom or an iodine atom is preferable.

The arylene group is preferably a phenylene group.

The alkylene group may be linear or branched. The number of carbon atoms of the alkylene group is not particularly limited, but is preferably 1 to 10, and more preferably 1 to 3.

The total number of fluorine atoms and iodine atoms included in the alkylene group having a fluorine atom or an iodine atom is not particularly limited, but is preferably 2 or more, more preferably 2 to 10, and still more preferably 3 to 6.

$R_1$ represents a hydrogen atom, a fluorine atom, an iodine atom, an alkyl group which may have a fluorine atom or an iodine atom, or an aryl group which may have a fluorine atom or an iodine atom.

The alkyl group may be linear or branched. The number of carbon atoms of the alkyl group is not particularly limited, but is preferably 1 to 10, and more preferably 1 to 3.

The total number of fluorine atoms and iodine atoms included in the alkyl group having a fluorine atom or an iodine atom is not particularly limited, but is preferably 1 or more, more preferably 1 to 5, and still more preferably 1 to 3.

The alkyl group may include a heteroatom such as an oxygen atom other than a halogen atom.

$R_2$ represents a leaving group that leaves by the action of an acid and may have a fluorine atom or an iodine atom.

Among those, examples of the leaving group include groups represented by Formulae (Z1) to (Z4).

Formula (Z1): $-C(Rx_{11})(Rx_{12})(Rx_{13})$
Formula (Z2): $-C(=O)OC(Rx_{11})(Rx_{12})(Rx_{13})$
Formula (Z3): $-C(R_{136})(R_{137})(OR_{138})$
Formula (Z4): $-C(Rn_1)(H)(Ar_1)$

In Formulae (Z1) and (Z2), $Rx_{11}$ to $Rx_{13}$ each independently represent an (linear or branched) alkyl group which may have a fluorine atom or an iodine atom, or a (monocyclic or polycyclic) cycloalkyl group which may have a fluorine atom or an iodine atom. Further, in a case where all of $Rx_{11}$ to $Rx_{13}$ are (linear or branched) alkyl groups, it is preferable that at least two of $Rx_{11}$, $Rx_{12}$, or $Rx_{13}$ are methyl groups.

$Rx_{11}$ to $Rx_{13}$ are the same as $Rx_1$ to $Rx_3$ in (Y1) and (Y2) described above, respectively, except that they may have a fluorine atom or an iodine atom, and have the same definitions and suitable ranges as those of the alkyl group and the cycloalkyl group.

In Formula (Z3), $R_{136}$ to $R_{138}$ each independently represent a hydrogen atom, or a monovalent organic group which may have a fluorine atom or an iodine atom. $R_{137}$ and $R_{138}$ may be bonded to each other to form a ring. Examples of the monovalent organic group which may have a fluorine atom or an iodine atom include an alkyl group which may

have a fluorine atom or an iodine atom, a cycloalkyl group which may have a fluorine atom or an iodine atom, an aryl group which may have a fluorine atom or an iodine atom, an aralkyl group which may have a fluorine atom or an iodine atom, and a group formed by combination thereof (for example, a group formed by combination of the alkyl group and the cycloalkyl group are combined).

Incidentally, the alkyl group, the cycloalkyl group, the aryl group, and the aralkyl group may include a heteroatom such as an oxygen atom, in addition to the fluorine atom and the iodine atom. That is, in the alkyl group, the cycloalkyl group, the aryl group, and the aralkyl group, for example, one of the methylene groups may be substituted with a heteroatom such as an oxygen atom or a group having a heteroatom, such as a carbonyl group.

As Formula (Z3), a group represented by Formula (Z3-1) is preferable.

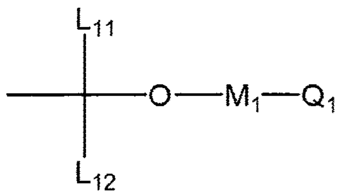

(Z3-1)

Here, $L_{11}$ and $L_{12}$ each independently represent a hydrogen atom; an alkyl group which may have a heteroatom selected from the group consisting of a fluorine atom, an iodine atom, and an oxygen atom; a cycloalkyl group which may have a heteroatom selected from the group consisting of a fluorine atom, an iodine atom, and an oxygen atom; an aryl group which may have a heteroatom selected from the group consisting of a fluorine atom, an iodine atom, and an oxygen atom; or a group formed by combination thereof (for example, a group formed by combination of an alkyl group and a cycloalkyl group, each of which may have a heteroatom selected from the group consisting of a fluorine atom, an iodine atom, and an oxygen atom).

$M_1$ represents a single bond or a divalent linking group.

$Q_1$ represents an alkyl group which may have a heteroatom selected from the group consisting of a fluorine atom, an iodine atom, and an oxygen atom; a cycloalkyl group which may have a heteroatom selected from the group consisting of a fluorine atom, an iodine atom, and an oxygen atom; an aryl group which may have a heteroatom selected from the group consisting of a fluorine atom, an iodine atom, and an oxygen atom; an amino group; an ammonium group; a mercapto group; a cyano group; an aldehyde group; a group formed by combination thereof (for example, a group formed by combination of the alkyl group and the cycloalkyl group, each of which may have a heteroatom selected from the group consisting of a fluorine atom, an iodine atom, and an oxygen atom).

In Formula (Y4), $Ar_1$ represents an aromatic ring group which may have a fluorine atom or an iodine atom. $Rn_1$ is an alkyl group which may have a fluorine atom or an iodine atom, a cycloalkyl group which may have a fluorine atom or an iodine atom, or an aryl group which may have a fluorine atom or an iodine atom. $Rn_1$ and $Ar_1$ may be bonded to each other to form a non-aromatic ring.

As the repeating unit having an acid-decomposable group, a repeating unit represented by General Formula (AI) is also preferable.

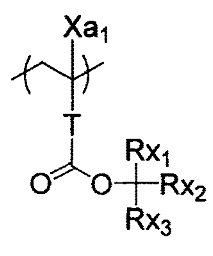

(A I)

In General Formula (AI),

$Xa_1$ represents a hydrogen atom, or an alkyl group which may have a substituent.

T represents a single bond or a divalent linking group.

$Rx_1$ to $Rx_3$ each independently represent an (linear or branched) alkyl group or a (monocyclic or polycyclic) cycloalkyl group. It should be noted that in a case where all of $Rx_1$ to $Rx_3$ are (linear or branched) alkyl groups, it is preferable that at least two of $Rx_1$, $Rx_2$, or $Rx_3$ are methyl groups.

Two of $Rx_1$ to $Rx_3$ may be bonded to each other to form a (monocyclic or polycyclic) cycloalkyl group.

Examples of the alkyl group which may have a substituent, represented by $Xa_1$, include a methyl group and a group represented by $-CH_2-R_{11}$. $R_{11}$ represents a halogen atom (a fluorine atom or the like), a hydroxyl group, or a monovalent organic group, examples thereof include an alkyl group having 5 or less carbon atoms, which may be substituted with a halogen atom, an acyl group having 5 or less carbon atoms, which may be substituted with a halogen atom, and an alkoxy group having 5 or less carbon atoms, which may be substituted with a halogen atom; and an alkyl group having 3 or less carbon atoms is preferable, and a methyl group is more preferable. $Xa_1$ is preferably a hydrogen atom, a methyl group, a trifluoromethyl group, or a hydroxymethyl group.

Examples of the divalent linking group of T include an alkylene group, an aromatic ring group, a -COO-Rt- group, and an -O-Rt- group. In the formulae, Rt represents an alkylene group or a cycloalkylene group.

T is preferably a single bond or the -COO-Rt- group. In a case where T represents the -COO-Rt-group, Rt is preferably an alkylene group having 1 to 5 carbon atoms, and more preferably a $-CH_2-$ group, a $-(CH_2)_2-$ group, or a $-(CH_2)_3-$ group.

As the alkyl group of each of $Rx_1$ to $Rx_3$, an alkyl group having 1 to 4 carbon atoms, such as a methyl group, an ethyl group, an n-propyl group, an isopropyl group, an n-butyl group, an isobutyl group, and a t-butyl group, is preferable.

As the cycloalkyl group of each of $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the cycloalkyl group formed by the bonding of two of $Rx_1$ to $Rx_3$, a monocyclic cycloalkyl group such as a cyclopentyl group and a cyclohexyl group is preferable, and in addition, a polycyclic cycloalkyl group such as a norbornyl group, a tetracyclodecanyl group, a tetracyclododecanyl group, and an adamantyl group is also preferable. Among those, a monocyclic cycloalkyl group having 5 or 6 carbon atoms is preferable.

In the cycloalkyl group formed by the bonding of two of $Rx_1$ to $Rx_3$, for example, one of the methylene groups constituting the ring may be substituted with a heteroatom such as an oxygen atom, or a group having a heteroatom, such as a carbonyl group.

With regard to the repeating unit represented by General Formula (AI), for example, an aspect in which $Rx_1$ is a methyl group or an ethyl group, and $Rx_2$ and $Rx_3$ are bonded to each other to form the above-mentioned cycloalkyl group is preferable.

In a case where each of the groups has a substituent, examples of the substituent include an alkyl group (having 1 to 4 carbon atoms), a halogen atom, a hydroxyl group, an alkoxy group (having 1 to 4 carbon atoms), a carboxyl group, and an alkoxycarbonyl group (having 2 to 6 carbon atoms). The substituent preferably has 8 or less carbon atoms.

The repeating unit represented by General Formula (AI) is preferably an acid-decomposable tertiary alkyl (meth)acrylate ester-based repeating unit (the repeating unit in which $Xa_1$ represents a hydrogen atom or a methyl group, and T represents a single bond).

The content of the repeating unit having an acid-decomposable group is preferably 15% by mole or more, more preferably 20% by mole or more, and still more preferably 30% by mole or more with respect to all the repeating units in the resin (A). In addition, an upper limit value thereof is preferably 80% by mole or less, more preferably 70% by mole or less, and still more preferably 60% by mole or less.

Specific examples of the repeating unit having an acid-decomposable group are shown below, but the present invention is not limited thereto. Further, in the formulae, $Xa_1$ represents H, $CH_3$, $CF_3$, or $CH_2OH$, and Rxa and Rxb each represent a linear or branched alkyl group having 1 to 4 carbon atoms.

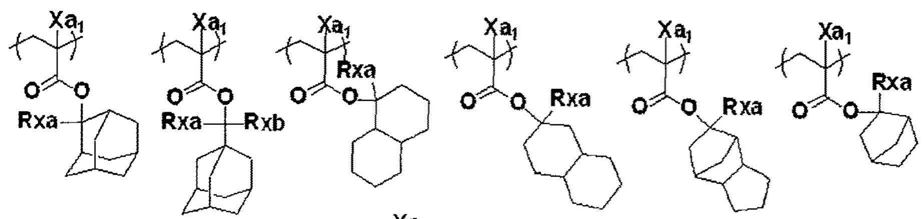

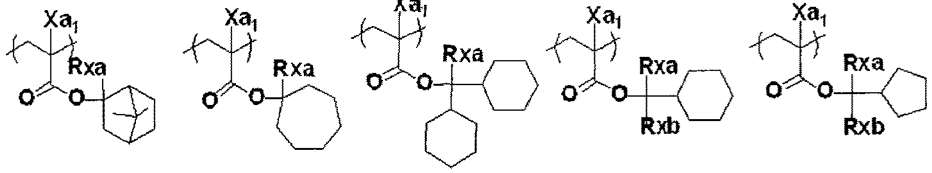

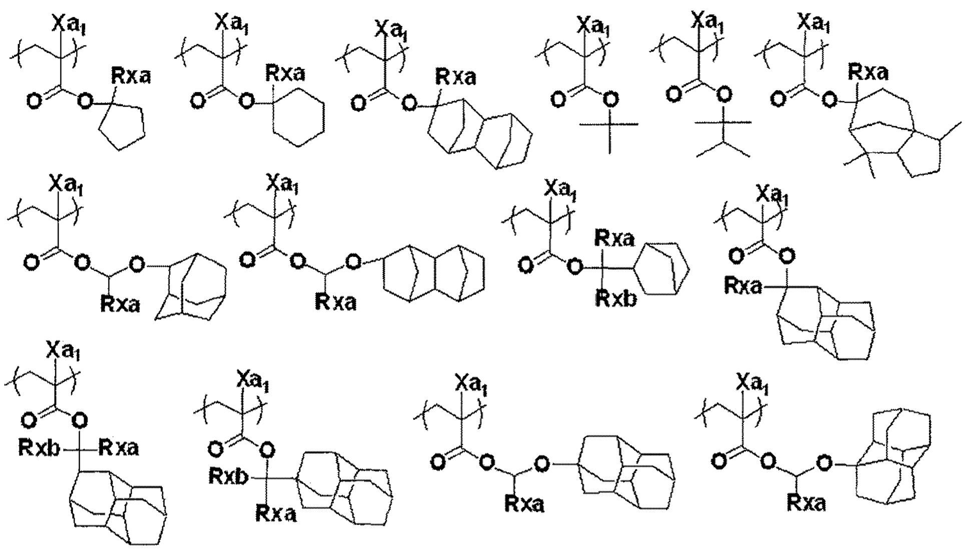

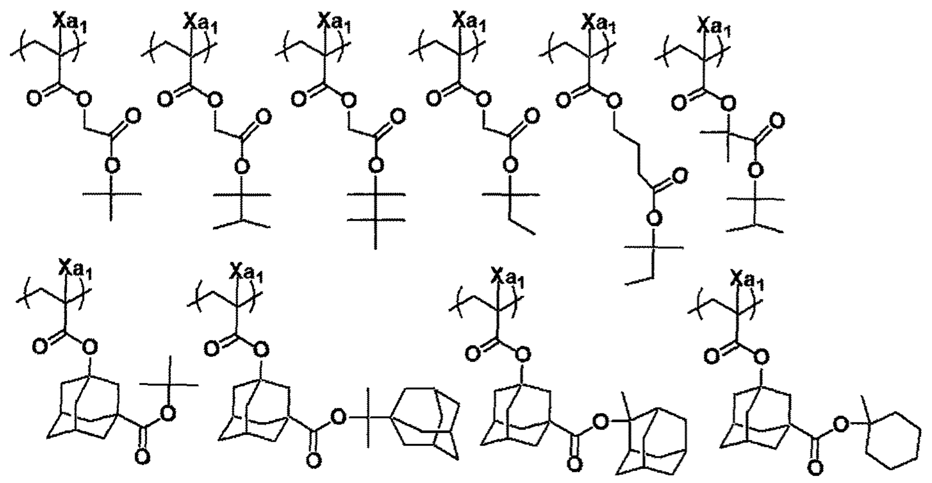

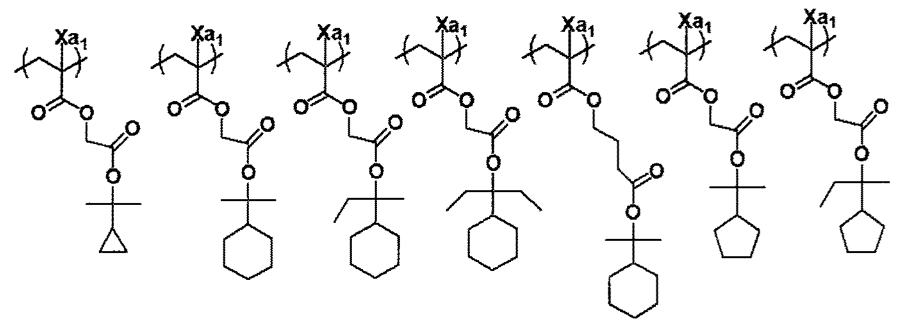

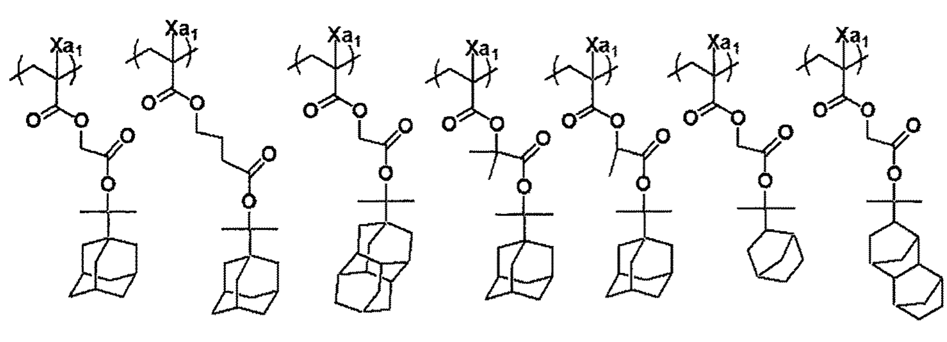

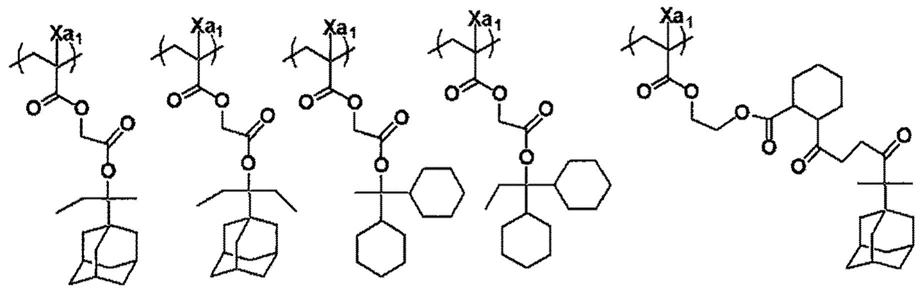

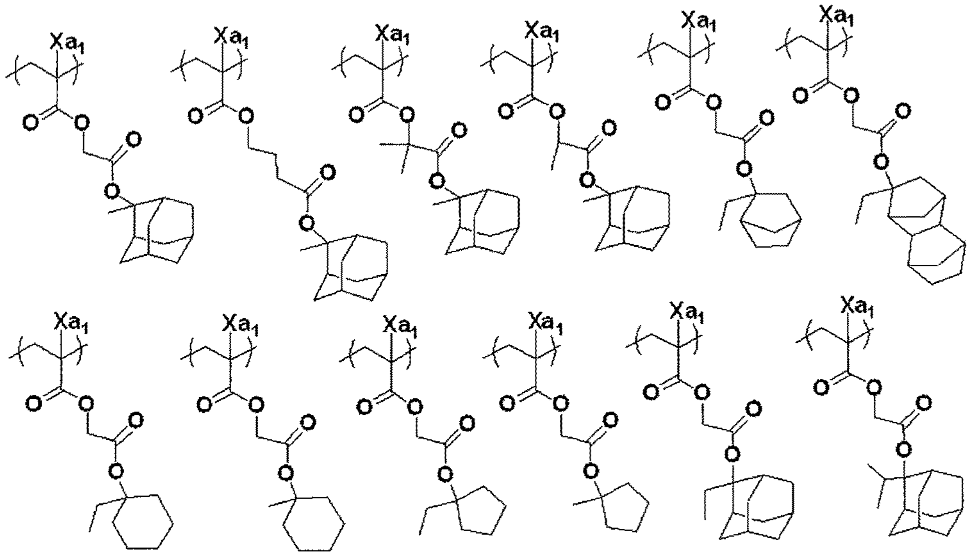

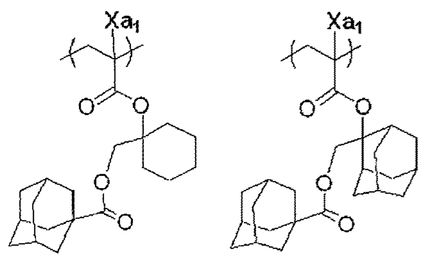

The resin (A) may include a repeating unit other than the above-mentioned repeating units.

For example, the resin (A) may include at least one repeating unit selected from the group consisting of the following group A and/or at least one repeating unit selected from the group consisting of the following group B.

Group A: A group consisting of the following repeating units (20) to (29).

(20) A repeating unit having an acid group, which will be described later
(21) A repeating unit having a fluorine atom or an iodine atom, which will be described later
(22) A repeating unit having a lactone group, which will be described later
(23) A repeating unit having a photoacid generating group, which will be described later
(24) A repeating Unit represented by General Formula (V-1) or General Formula (V-2), which will be described later
(25) A repeating unit represented by Formula (A), which will be described later
(26) A repeating unit represented by Formula (B), which will be described later
(27) A repeating unit represented by Formula (C), which will be described later
(28) A repeating unit represented by Formula (D), which will be described later
(29) A repeating unit represented by Formula (E), which will be described later

Group B: A group consisting of the following repeating units (30) to (32).

(30) A repeating unit having at least one group selected from a lactone group, a hydroxyl group, a cyano group, or an alkali-soluble group, which will be described later
(31) A repeating unit having an alicyclic hydrocarbon structure and exhibiting no acid decomposability described later
(32) A repeating unit represented by General Formula (III) having neither a hydroxyl group nor a cyano group, which will be described later

In a case where the resist composition of the embodiment of the present invention is used as an actinic ray-sensitive or radiation-sensitive resin composition for EUV, it is preferable that the resin (A) has at least one repeating unit selected from the group consisting of the group A.

Furthermore, in a case where the resist composition is used as the actinic ray-sensitive or radiation-sensitive resin composition for EUV, it is preferable that the resin (A) includes a fluorine atom and an iodine atom. In a case where the resin (A) includes both a fluorine atom and an iodine atom, the resin (A) may have one repeating unit including both a fluorine atom and an iodine atom, and the resin (A) may include two kinds of repeating units, that is, a repeating unit having a fluorine atom and a repeating unit having an iodine atom.

In a case where the resist composition of the embodiment of the present invention is used as an actinic ray-sensitive or radiation-sensitive resin composition for ArF, it is preferable that the resin (A) has at least one repeating unit selected from the group consisting of the group B.

Furthermore, in a case where the resist composition is used as the actinic ray-sensitive or radiation-sensitive resin composition for ArF, it is preferable that the resin (A) includes neither a fluorine atom nor a silicon atom.

In addition, in a case where the resist composition is used as the actinic ray-sensitive or radiation-sensitive resin composition for ArF, it is preferable that the resin (A) does not have an aromatic group.

<Repeating Unit Having Acid Group>

The resin (A) may have a repeating unit having an acid group.

As the acid group, an acid group having a pKa of 13 or less is preferable.

The repeating unit having an acid group may have a fluorine atom or an iodine atom.

As the repeating unit having an acid group, a repeating unit represented by Formula (B) is preferable.

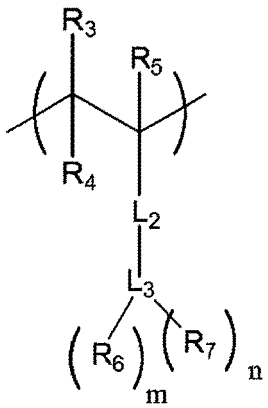

(B)

$R_3$ represents a hydrogen atom or a monovalent organic group which may have a fluorine atom or an iodine atom.

The monovalent organic group which may have a fluorine atom or an iodine atom is preferably a group represented by $-L_4-R_8$. $L_4$ represents a single bond or an ester group. $R_8$ is an alkyl group which may have a fluorine atom or an iodine atom, a cycloalkyl group which may have a fluorine atom or an iodine atom, an aryl group which may have a fluorine atom or an iodine atom, or a group formed by combination thereof.

$R_4$ and $R_5$ each independently represent a hydrogen atom, a fluorine atom, an iodine atom, or an alkyl group which may have a fluorine atom or an iodine atom.

$L_2$ represents a single bond or an ester group.

$L_3$ represents an (n + m + 1)-valent aromatic hydrocarbon ring group or an (n + m + 1)-valent alicyclic hydrocarbon ring group. Examples of the aromatic hydrocarbon ring group include a benzene ring group and a naphthalene ring group. The alicyclic hydrocarbon ring group may be either a monocycle or a polycycle, and examples thereof include a cycloalkyl ring group.

$R_6$ represents a hydroxyl group or a fluorinated alcohol group (preferably a hexafluoroisopropanol group). Further, in a case where $R_6$ is a hydroxyl group, $L_3$ is preferably the (n + m + 1)-valent aromatic hydrocarbon ring group.
$R_7$ represents a halogen atom. Examples of the halogen atom include a fluorine atom, a chlorine atom, a bromine atom, or an iodine atom.
m represents an integer of 1 or more. m is preferably an integer of 1 to 3 and more preferably an integer of 1 or 2.
n represents 0 or an integer of 1 or more. n is preferably an integer of 1 to 4.
Furthermore, (n + m + 1) is preferably an integer of 1 to 5.
As the repeating unit having an acid group, a repeating unit represented by General Formula (I) is also preferable.

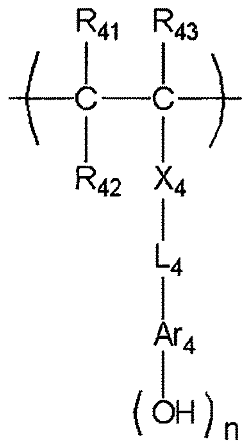

(I)

In General Formula (I),
$R_{41}$, $R_{42}$, and $R_{43}$ each independently represent a hydrogen atom, an alkyl group, a cycloalkyl group, a halogen atom, a cyano group, or an alkoxycarbonyl group. It should be noted that $R_{42}$ may be bonded to $Ar_4$ to form a ring, in which case $R_{42}$ represents a single bond or an alkylene group.
$X_4$ represents a single bond, -COO-, or -CONR$_{64}$-, and $R_{64}$ represents a hydrogen atom or an alkyl group.
$L_4$ represents a single bond or an alkylene group.
$Ar_4$ represents an (n + 1)-valent aromatic ring group, and in a case where $Ar_4$ is bonded to $R_{42}$ to form a ring, $Ar_4$ represents an (n + 2)-valent aromatic ring group.
n represents an integer of 1 to 5.
As the alkyl group represented by each of $R_{41}$, $R_{42}$, and $R_{43}$ in General Formula (I), an alkyl group having 20 or less carbon atoms, such as a methyl group, an ethyl group, a propyl group, an isopropyl group, an n-butyl group, a sec-butyl group, a hexyl group, a 2-ethylhexyl group, an octyl group, and a dodecyl group is preferable, an alkyl group having 8 or less carbon atoms is more preferable, and an alkyl group having 3 or less carbon atoms is still more preferable.
The cycloalkyl group of each of $R_{41}$, $R_{42}$, and $R_{43}$ in General Formula (I) may be monocyclic or polycyclic. Among those, a monocyclic cycloalkyl group having 3 to 8 carbon atoms, such as a cyclopropyl group, a cyclopentyl group, and a cyclohexyl group, is preferable.
Examples of the halogen atom of each of $R_{41}$, $R_{42}$, and $R_{43}$ in General Formula (I) include a fluorine atom, a chlorine atom, a bromine atom, and an iodine atom, and the fluorine atom is preferable.
As the alkyl group included in the alkoxycarbonyl group of each of $R_{41}$, $R_{42}$, and $R_{43}$ in General Formula (I), the same ones as the alkyl group in each of $R_{41}$, $R_{42}$, and $R_{43}$ are preferable.
Preferred examples of the substituent in each of the groups include an alkyl group, a cycloalkyl group, an aryl group, an amino group, an amide group, a ureide group, a urethane group, a hydroxyl group, a carboxyl group, a halogen atom, an alkoxy group, a thioether group, an acyl group, an acyloxy group, an alkoxycarbonyl group, a cyano group, and a nitro group. The substituent preferably has 8 or less carbon atoms.
$Ar_4$ represents an (n + 1)-valent aromatic ring group. The divalent aromatic ring group in a case where n is 1 is preferably, for example, an arylene group having 6 to 18 carbon atoms, such as a phenylene group, a tolylene group, a naphthylene group, and an anthracenylene group, or a divalent aromatic ring group including a heterocycle such as a thiophene ring, a furan ring, a pyrrole ring, a benzothiophene ring, a benzofuran ring, a benzopyrrole ring, a triazine ring, an imidazole ring, a benzimidazole ring, a triazole ring, a thiadiazole ring, and a thiazole ring. Furthermore, the aromatic ring group may have a substituent.
Specific examples of the (n + 1)-valent aromatic ring group in a case where n is an integer of 2 or more include groups formed by removing any (n-1) hydrogen atoms from the above-described specific examples of the divalent aromatic ring group.

The (n + 1)-valent aromatic ring group may further have a substituent.

Examples of the substituent which can be contained in the alkyl group, the cycloalkyl group, the alkoxycarbonyl group, the alkylene group, and the (n + 1)-valent aromatic ring group as mentioned above include the alkyl group; the alkoxy group such as a methoxy group, an ethoxy group, a hydroxyethoxy group, a propoxy group, a hydroxypropoxy group, and a butoxy group; an aryl group such as a phenyl group; and the like, as mentioned for each of $R_{41}$, $R_{42}$, and $R_{43}$ in General Formula (I).

Examples of the alkyl group of $R_{64}$ in -CONR$_{64}$- represented by $X_4$ ($R_{64}$ represents a hydrogen atom or an alkyl group) include an alkyl group having 20 or less carbon atoms, such as a methyl group, an ethyl group, a propyl group, an isopropyl group, an n-butyl group, a sec-butyl group, a hexyl group, a 2-ethylhexyl group, an octyl group, and a dodecyl group, and an alkyl group having 8 or less carbon atoms, is preferable.

As $X_4$, a single bond, -COO-, or -CONH- is preferable, and the single bond or -COO-is more preferable.

As the alkylene group in $L_4$, an alkylene group having 1 to 8 carbon atoms, such as a methylene group, an ethylene group, a propylene group, a butylene group, a hexylene group, and an octylene group, is preferable.

As $Ar_4$, an aromatic ring group having 6 to 18 carbon atoms is preferable, and a benzene ring group, a naphthalene ring group, and a biphenylene ring group are more preferable.

The repeating unit represented by General Formula (I) preferably has a hydroxystyrene structure. That is, $Ar_4$ is preferably the benzene ring group.

The repeating unit represented by General Formula (I) is preferably a repeating unit represented by General Formula (1).

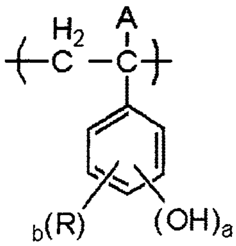

(1)

In General Formula (1),
A represents a hydrogen atom, an alkyl group, a cycloalkyl group, a halogen atom, or a cyano group.

R represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group, and in a case where a plurality of R's are present, R's may be the same as or different from each other. In a case where there are a plurality of R's, R's may be combined with each other to form a ring. As R, the hydrogen atom is preferable.

a represents an integer of 1 to 3.

b represents an integer of 0 to (5-a).

Specific examples of the repeating unit represented by General Formula (I) will be shown below, but the present invention is not limited thereto. In the formula, a represents 1 or 2.

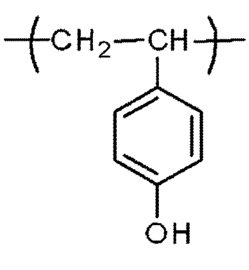

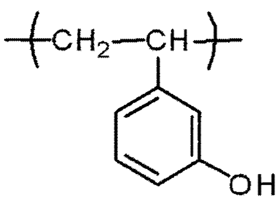

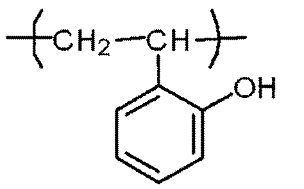

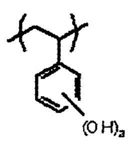

(B - 1)

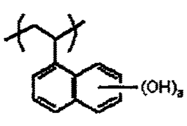

(B - 2)

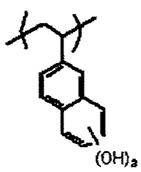

(B - 3)

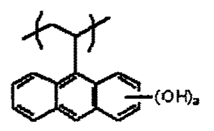

(B - 4)

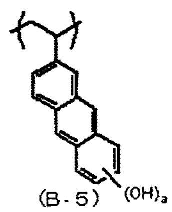

(B - 5)

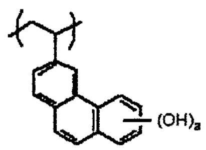
(B-6)

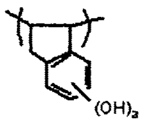
(B-7)

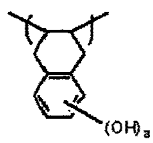
(B-8)

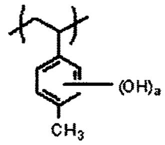
(B-9)

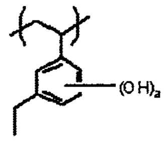
(B-10)

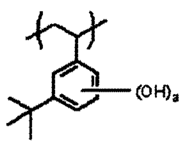
(B-11)

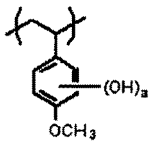
(B-12)

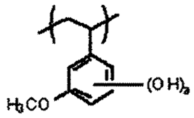
(B-13)

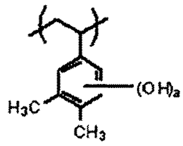
(B-14)

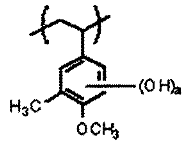
(B-15)

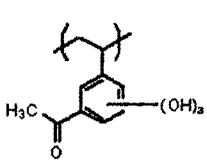
(B-16)

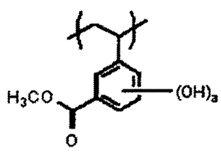
(B-17)

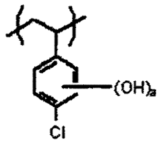
(B-18)

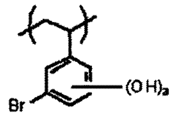
(B-19)

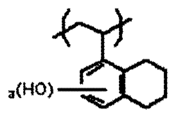
(B-20)

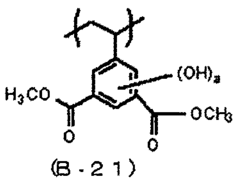
(B-21)

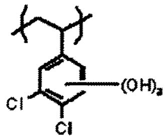
(B-22)

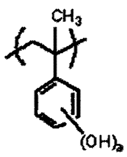
(B-23)

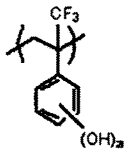
(B-24)

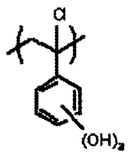
(B-25)

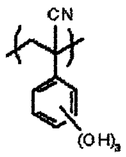
(B-26)

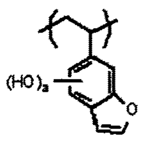
(B-27)

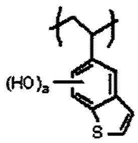
(B-28)

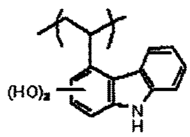
(B-29)

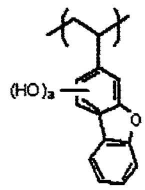
(B-30)

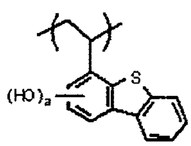
(B-31)

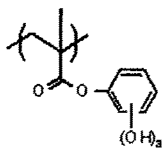
(B-32)

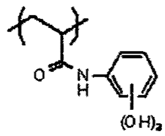
(B-33)

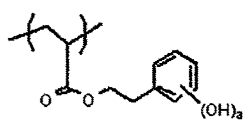
(B-34)

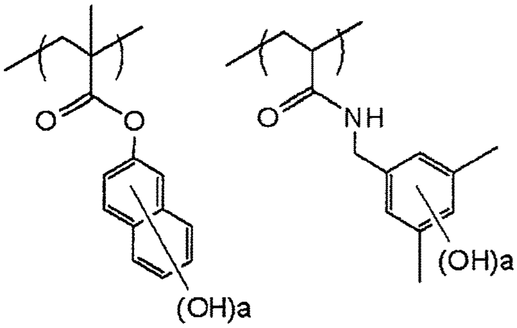

(B-35) (B-36)

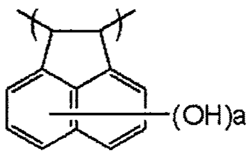

(B-37)

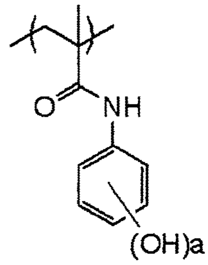

(B-38)

Moreover, among the repeating units, the repeating units specifically described below are preferable. In the formula, R represents a hydrogen atom or a methyl group, and a represents 2 or 3.

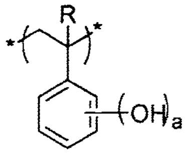

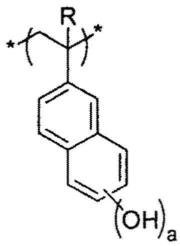

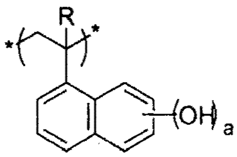

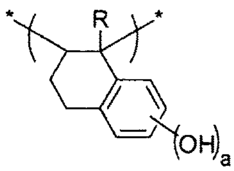

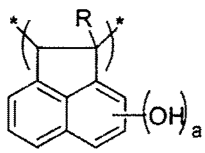

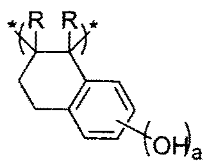

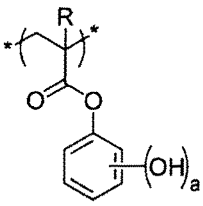

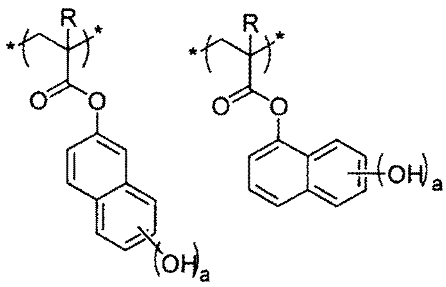

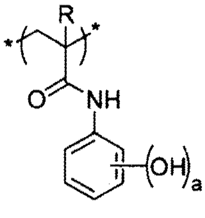

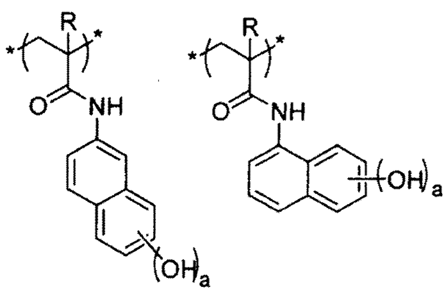

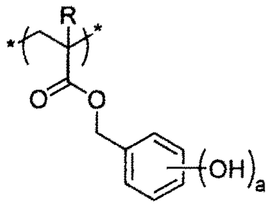 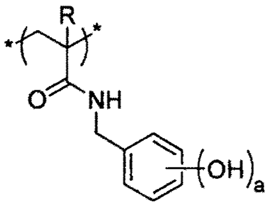

The content of the repeating unit having an acid group is preferably 10% by mole or more, more preferably 15% by mole or more, and still more preferably 20% by mole or more with respect to all the repeating units in the resin (A). In addition, an upper limit value thereof is preferably 70% by mole or less, more preferably 65% by mole or less, and still more preferably 60% by mole or less.

<Repeating Unit Having Fluorine Atom or Iodine Atom>

The resin (A) may have a repeating unit having a fluorine atom or an iodine atom in addition to the above-mentioned <Repeating Unit Having Acid-Decomposable Group> and <Repeating Unit Having Acid Group>.
As the repeating unit having a fluorine atom or an iodine atom, a repeating unit represented by Formula (C) is preferable.

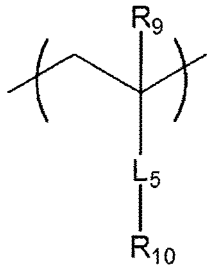

(C)

$L_5$ represents a single bond or an ester group.
$R_9$ represents a hydrogen atom or an alkyl group which may have a fluorine atom or an iodine atom.
$R_{10}$ represents a hydrogen atom, an alkyl group which may have a fluorine atom or an iodine atom, a cycloalkyl group which may have a fluorine atom or an iodine atom, an aryl group which may have a fluorine atom or an iodine atom, or a group formed by combination thereof.
The content of the repeating unit having a fluorine atom or an iodine atom is preferably 0% by mole or more, more preferably 5% by mole or more, and still more preferably 10% by mole or more with respect to all the repeating units in the resin (A). In addition, an upper limit value thereof is preferably 50% by mole or less, more preferably 45% by mole or less, and still more preferably 40% by mole or less.
Furthermore, since the repeating unit having a fluorine atom or an iodine atom does not include <Repeating Unit Having Acid-Decomposable Group>, and <Repeating Unit Having Acid Group> as described above, the content of the repeating unit having a fluorine atom or an iodine atom is also intended to be the content of the repeating unit having a fluorine atom or an iodine atom, excluding <Repeating Unit Having Acid-Decomposable Group> and <Repeating Unit Having Acid Group>
The total content of the repeating units including at least one of a fluorine atom or an iodine atom in the repeating units of the resin (A) is preferably 20% by mole or more, more preferably 30% by mole or more, and still more preferably 40% by mole or more with respect to all the repeating units of the resin (A). An upper limit value thereof is not particularly limited, but is, for example, 100% by mole or less.
In addition, examples of the repeating unit including at least one of a fluorine atom or an iodine atom include a repeating unit which has a fluorine atom or an iodine atom, and has an acid-decomposable group, a repeating unit which has a fluorine atom or an iodine atom, and has an acid group, and a repeating unit having a fluorine atom or an iodine atom.

<Repeating Unit Having Lactone Group>

The resin (A) may further have a repeating unit having a lactone group.
As the lactone group, any group may be used as long as it has a lactone structure, but the lactone group is preferably a group having a 5- to 7-membered ring lactone structure, and more preferably a group having a 5- to 7-membered ring lactone structure to which another ring structure is fused in the form of forming a bicyclo structure or a spiro structure. The resin (A) more preferably has a repeating unit having a group having a lactone structure represented by any of General Formulae (LC1-1) to (LC1-17). Further, a group having a lactone structure may be bonded directly to the main chain. As the lactone structure, a lactone structure represented by General Formula (LC1-1), General Formula (LC1-4), General Formula (LC1-5), General Formula (LC1-6), General Formula (LC1-13), or General Formula (LC1-14) is preferable.

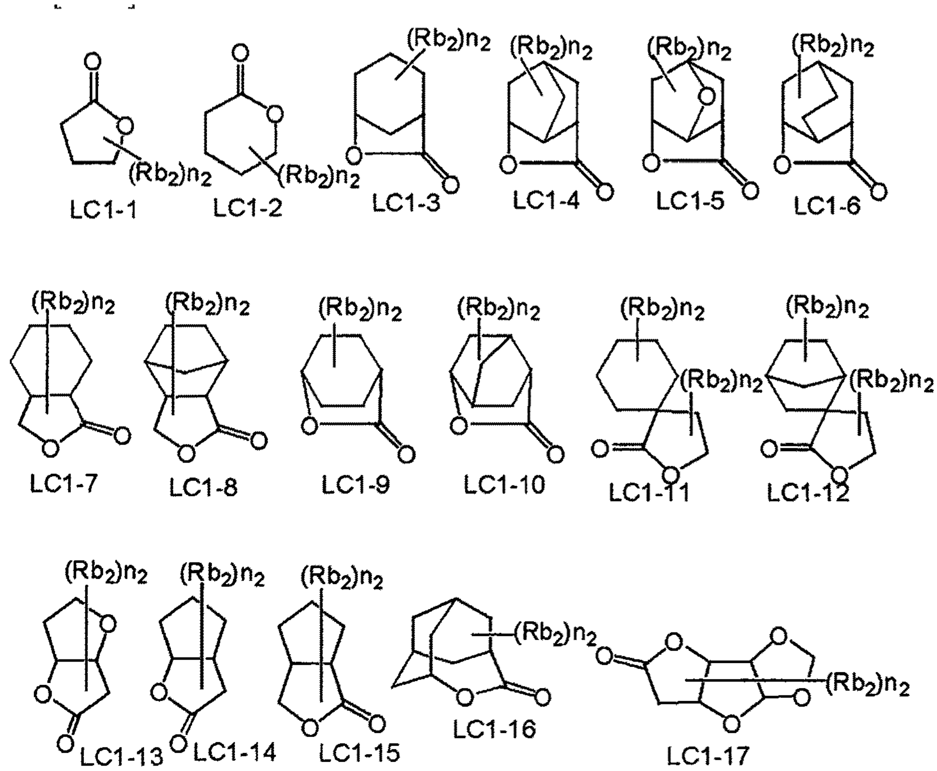

LC1-1 LC1-2 LC1-3 LC1-4 LC1-5 LC1-6

LC1-7 LC1-8 LC1-9 LC1-10 LC1-11 LC1-12

LC1-13 LC1-14 LC1-15 LC1-16 LC1-17

The lactone structure moiety may have a substituent ($Rb_2$). Preferred examples of the substituent ($Rb_2$) include an alkyl group having 1 to 8 carbon atoms, a cycloalkyl group having 4 to 7 carbon atoms, an alkoxy group having 1 to 8 carbon atoms, an alkoxycarbonyl group having 1 to 8 carbon atoms, a carboxyl group, a halogen atom, a hydroxyl group, and a cyano group. n2 represents an integer of 0 to 4. In a case where n2 is 2 or more, $Rb_2$'s which are present in a plural number may be different from each other, and $Rb_2$'s which are present in a plural number may be bonded to each other to form a ring.

Examples of the repeating unit having a group having a lactone structure represented by any of General Formulae (LC1-1) to (LC1-17) include a repeating unit represented by General Formula (AI).

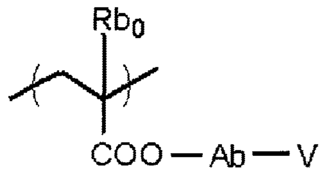

(AI)

In General Formula (AI), $Rb_0$ represents a hydrogen atom, a halogen atom, or an alkyl group having 1 to 4 carbon atoms.

Preferred examples of the substituent which may be contained in the alkyl group of $Rb_0$ include a hydroxyl group and a halogen atom.

Examples of the halogen atom of $Rb_0$ include a fluorine atom, a chlorine atom, a bromine atom, and an iodine atom. $Rb_0$ is preferably the hydrogen atom or a methyl group.

Ab represents a single bond, an alkylene group, a divalent linking group having a monocyclic or polycyclic alicyclic hydrocarbon structure, an ether group, an ester group, a carbonyl group, a carboxyl group, or a divalent group formed by combination thereof. Among those, the single bond or a linking group represented by $-Ab_1-CO_2-$ is preferable.

$Ab_1$ is a linear or branched alkylene group, or a monocyclic or polycyclic cycloalkylene group, and is preferably a methylene group, an ethylene group, a cyclohexylene group, an adamantylene group, or a norbornylene group.

V represents a group having a lactone structure represented by any of General Formulae (LC1-1) to (LC1-17).

The repeating unit having the group having a lactone structure usually has optical isomers, and any of optical isomers may be used. In addition, one kind of optical isomers may be used singly or a plurality of kinds of optical isomers may be mixed and used. In a case where one kind of optical isomers is mainly used, an optical purity (ee) thereof is preferably 90% or more, and more preferably 95% or more.

Specific examples of the repeating unit having the group having a lactone structure are shown below, but the present invention is not limited thereto.

(in the formulae, Rx represents H, $CH_3$, $CH_2OH$, or $CF_3$)

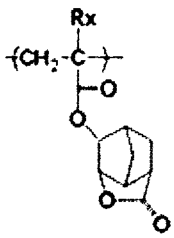
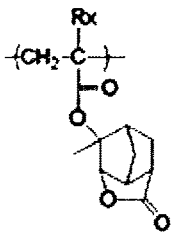
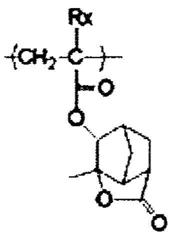
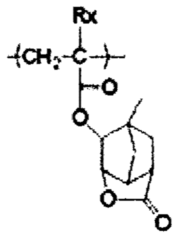
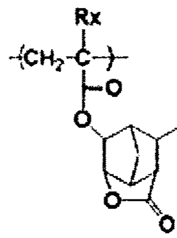
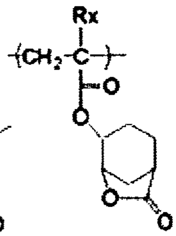

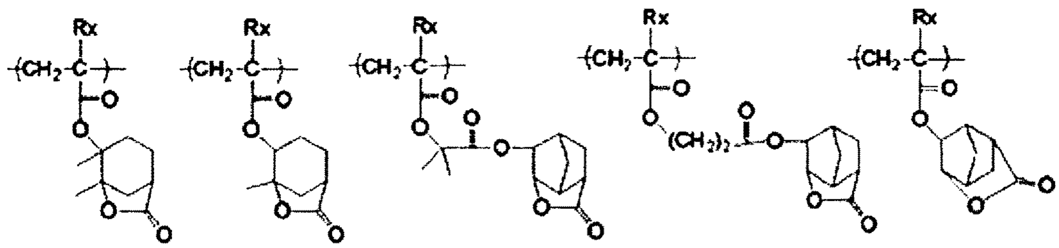

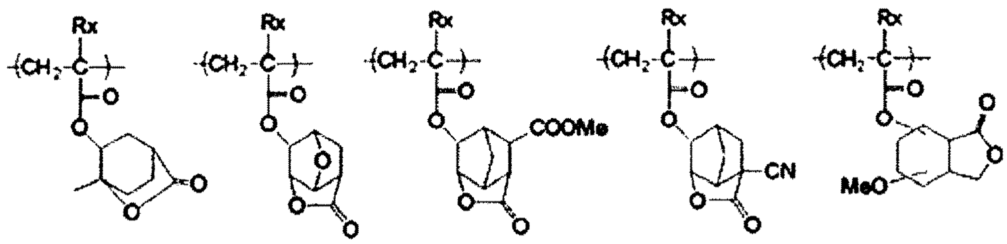

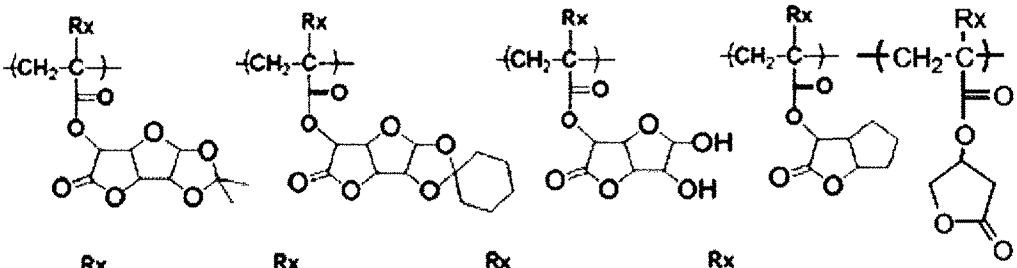

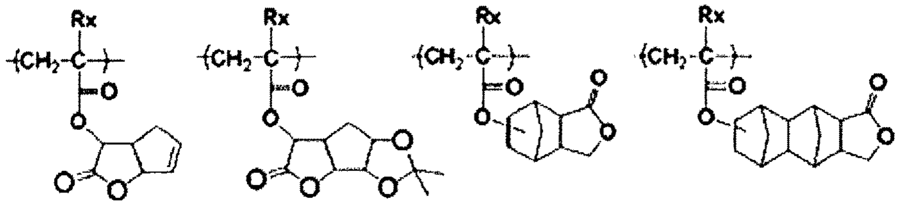

The content of the repeating unit having a lactone group is preferably 1% by mole or more, and more preferably

10% by mole or more with respect to all the repeating units in the resin (A). In addition, an upper limit value thereof is preferably 85% by mole or less, more preferably 80% by mole or less, still more preferably 70% by mole or less, and particularly preferably 60% by mole or less.

<Repeating Unit Having Photoacid Generating Group>

The resin (A) may have, as a repeating unit other than those above, a repeating unit having a group that generates an acid upon irradiation with actinic rays or radiation (hereinafter also referred to as a "photoacid generating group").

In this case, it can be considered that the repeating unit having a photoacid generating group corresponds to a compound that generates an acid upon irradiation with actinic rays or radiation which will be described later (also referred to as a "photoacid generator").

Examples of such the repeating unit include a repeating unit represented by General Formula (4).

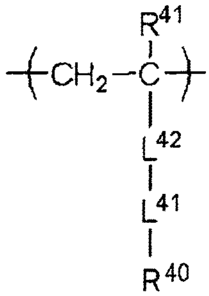

(4)

$R^{41}$ represents a hydrogen atom or a methyl group. $L^{41}$ represents a single bond or a divalent linking group. $L^{42}$ represents a divalent linking group. $R^{40}$ represents a structure moiety that decomposes upon irradiation with actinic rays or radiation to generate an acid in a side chain.

Specific examples of the repeating unit represented by General Formula (4) are shown below, but the present invention is not limited thereto.

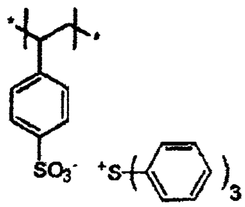
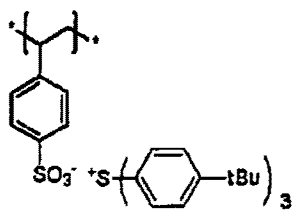
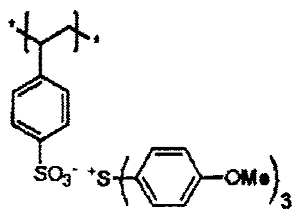
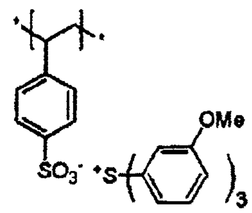
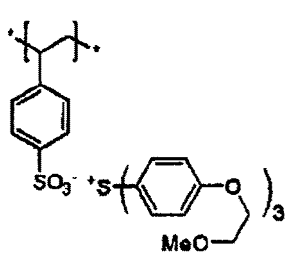
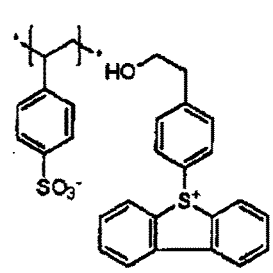

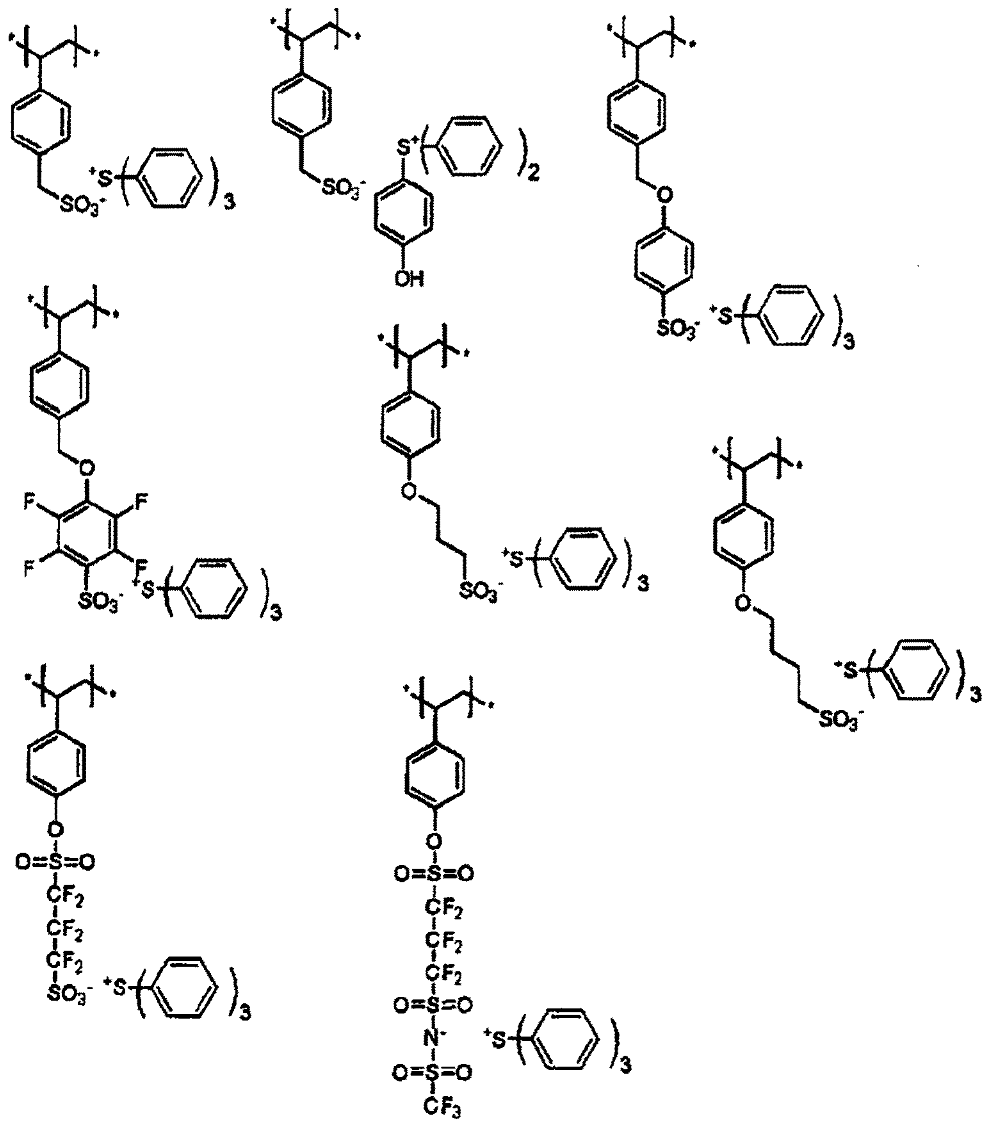

In addition, examples of the repeating unit represented by General Formula (4) include the repeating units described in paragraphs [0094] to [0105] of JP2014-041327A.

The content of the repeating unit having a photoacid generating group is preferably 1% by mole or more, and more preferably 5% by mole or more with respect to all the repeating units in the resin (A). In addition, an upper limit value thereof is preferably 40% by mole or less, more preferably 35% by mole or less, and still more preferably 30% by mole or less.

<Repeating Unit Represented by General Formula (V-1) or General Formula (V-2)>

The resin (A) may have a repeating unit represented by General Formula (V-1) or General Formula (V-2).

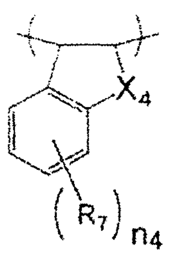

(V-1)

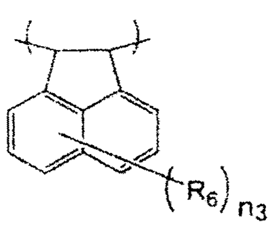

(V-2)

In the formula,

$R_6$ and $R_7$ each independently represent a hydrogen atom, a hydroxyl group, an alkyl group, an alkoxy group, an acyloxy group, a cyano group, a nitro group, an amino group, a halogen atom, an ester group (-OCOR or -COOR: R is an alkyl group or fluorinated alkyl group having 1 to 6 carbon atoms), or a carboxyl group. As the alkyl group, a linear, branched, or cyclic alkyl group having 1 to 10 carbon atoms is preferable.

$n_3$ represents an integer of 0 to 6.

$n_4$ represents an integer of 0 to 4.

$X^4$ is a methylene group, an oxygen atom, or a sulfur atom.

Specific examples of the repeating unit represented by General Formula (V-1) or (V-2) are shown below, but are not limited thereto.

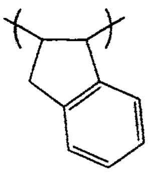
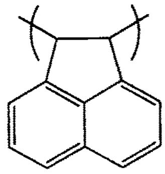
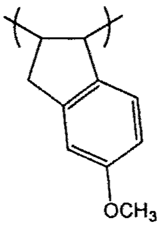
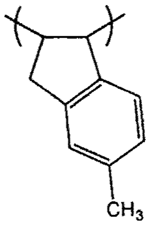
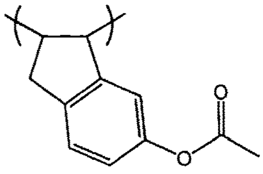

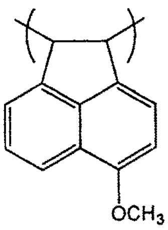
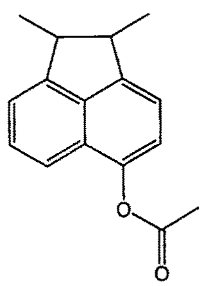
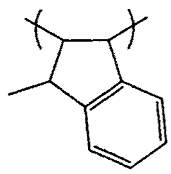

<Repeating Unit for Reducing Motility of Main Chain>

The resin (A) preferably has a high glass transition temperature (Tg) from the viewpoint that excessive diffusion of an acid generated or pattern collapse during development can be suppressed. Tg is preferably higher than 90°C, more preferably higher than 100°C, still more preferably higher than 110°C, and particularly preferably higher than 125°C. In addition, since an excessive increase in Tg causes a decrease in the dissolution rate in a developer, Tg is preferably 400°C or lower, and more preferably 350°C or lower.

Furthermore, in the present specification, the glass transition temperature (Tg) of a polymer such as the resin (A) is calculated by the following method. First, the Tg of a homopolymer consisting only of each repeating unit included in the polymer is calculated by a Bicerano method. Hereinafter, the calculated Tg is referred to as "the Tg of the repeating unit". Next, the mass proportion (%) of each repeating unit to all the repeating units in the polymer is calculated. Then, the Tg at each mass proportion is calculated using a Fox's equation (described in Materials Letters 62 (2008) 3152, and the like), and these are summed to obtain the Tg (°C) of the polymer.

A Bicerano method is described in Prediction of polymer properties, Marcel Dekker Inc., New York (1993) and the like. In addition, calculation of the Tg by the Bicerano method can be performed using a software for estimating physical properties of a polymer, MDL Polymer (MDL Information Systems, Inc.).

In order to adjust the Tg of the resin (A) to be higher than 90°C, it is preferable to reduce the motility of the main chain of the resin (A). Examples of a method for lowering the motility of the main chain of the resin (A) include the following (a) to (e) methods.

(a) Introduction of a bulky substituent into the main chain
(b) Introduction of a plurality of substituents into the main chain
(c) Introduction of a substituent that induces an interaction between the resins (A) near the main chain
(d) Formation of the main chain in a cyclic structure
(e) Linking of a cyclic structure to the main chain

Furthermore, the resin (A) preferably has a repeating unit having a Tg of a homopolymer exhibiting 130°C or

higher.

In addition, the type of the repeating unit having a Tg of the homopolymer exhibiting 130°C or higher is not particularly limited, and may be any of repeating units having a Tg of a homopolymer of 130°C or higher calculated by the Bicerano method. Further, it corresponds to a repeating unit having a Tg of a homopolymer exhibiting 130°C or higher, depending on the type of a functional group in the repeating units represented by Formulae (A) to (E) which will be described later.

(Repeating Unit Represented by Formula (A))

As an example of a specific unit for achieving (a) above, a method of introducing a repeating unit represented by Formula (A) into the resin (A) may be mentioned.

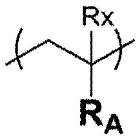

(A)

In Formula (A), $R_A$ represents a group having a polycyclic structure. $R_x$ represents a hydrogen atom, a methyl group, or an ethyl group. The group having a polycyclic structure is a group having a plurality of ring structures, and the plurality of ring structures may or may not be fused.

Specific examples of the repeating unit represented by Formula (A) include the following repeating units.

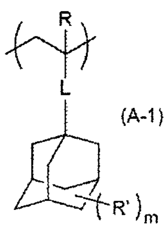

(A-1)

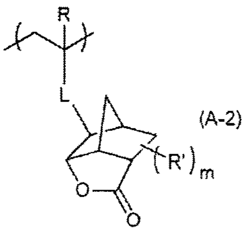

(A-2)

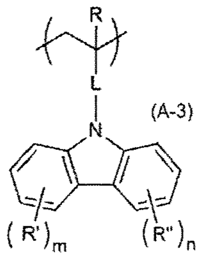

(A-3)

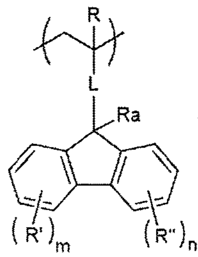

(A-4)

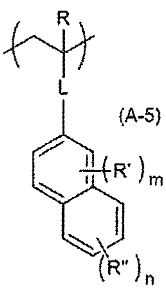

(A-5)

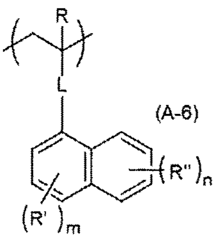

(A-6)

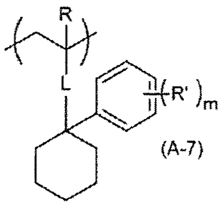

(A-7)

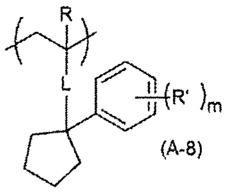

(A-8)

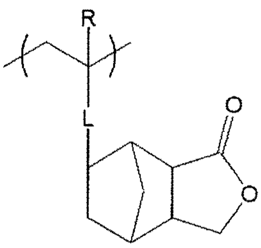

(A-9)

In the formulae, R represents a hydrogen atom, a methyl group, or an ethyl group.

Ra represents a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR''' or -COOR''': R''' is an alkyl group or fluorinated alkyl group having 1 to 20 carbon atoms), or a carboxyl group. Further, the alkyl group, the cycloalkyl group, the aryl group, the aralkyl group, and the alkenyl

group may each have a substituent. Incidentally, a hydrogen atom bonded to the carbon atom in the group represented by Ra may be substituted with a fluorine atom or an iodine atom.

Moreover, R' and R" each independently represent an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR'" or -COOR"': R'" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, a hydrogen atom bonded to the carbon atom in the groups represented by each of R' and R" may be substituted with a fluorine atom or an iodine atom.

L represents a single bond or a divalent linking group. Examples of the divalent linking group include -COO-, -CO-, -O-, -S-, -SO-, $-SO_2-$, an alkylene group, a cycloalkylene group, an alkenylene group, and a linking group in which a plurality of these groups are linked.

m and n each independently represent an integer of 0 or more. The upper limit of each of m and n is not particularly limited, but is 2 or less in many cases, and 1 or less in more cases.

(Repeating Unit Represented by Formula (B))

As an example of a specific unit for achieving (b) above, a method of introducing a repeating unit represented by Formula (B) into the resin (A) may be mentioned.

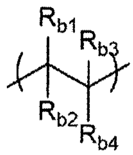
(B)

In Formula (B), $R_{b1}$ to $R_{b4}$ each independently represent a hydrogen atom or an organic group, and at least two or more of $R_{b1}$, ..., or $R_{b4}$ represent an organic group.

Furthermore, in a case where at least one of the organic groups is a group in which a ring structure is directly linked to the main chain in the repeating unit, the types of the other organic groups are not particularly limited.

In addition, in a case where none of the organic groups is a group in which a ring structure is directly linked to the main chain in the repeating unit, at least two or more of the organic groups are substituents having three or more constituent atoms excluding hydrogen atoms.

Specific examples of the repeating unit represented by Formula (B) include the following repeating units.

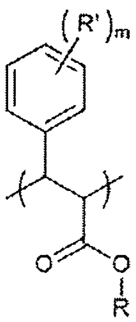
(B-1)
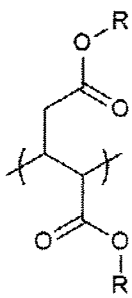
(B-2)
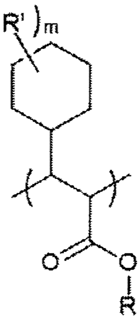
(B-3)
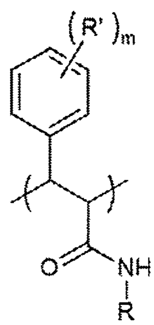
(B-4)

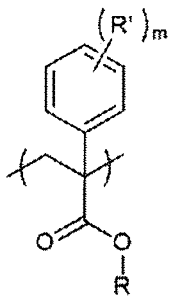
(B-5)
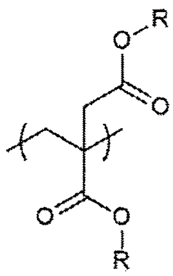
(B-6)

In the formula, R's each independently represent a hydrogen atom or an organic group. Examples of the organic

group include an organic group such as an alkyl group, a cycloalkyl group, an aryl group, an aralkyl group, and an alkenyl group, each of which may have a substituent.

R"s each independently represent an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. Incidentally, a hydrogen atom bonded to the carbon atom in the group represented by R' may be substituted with a fluorine atom or an iodine atom.

m represents an integer of 0 or more. The upper limit of m is not particularly limited, but is 2 or less in many cases, and 1 or less in more cases.

(Repeating Unit Represented by Formula (C))

As an example of a specific unit for achieving (c) above, a method of introducing a repeating unit represented by Formula (C) into the resin (A) may be mentioned.

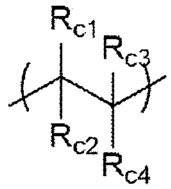 (C)

In Formula (C), $R_{c1}$ to $R_{c4}$ each independently represent a hydrogen atom or an organic group, and at least one of $R_{c1}$, ..., or $R_{c4}$ is a group having hydrogen-bonding hydrogen atoms with a number of 3 atoms or less from the main chain carbon. Among those, it is preferable that the group has hydrogen-bonding hydrogen atoms with a number of atoms of 2 or less (on a side closer to the vicinity of the main chain) to induce an interaction between the main chains of the resin (A).

Specific examples of the repeating unit represented by Formula (C) include the following repeating units.

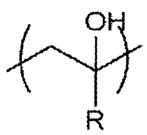 (C-1) 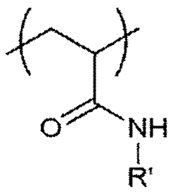 (C-2) 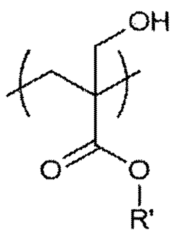 (C-3)

In the formula, R represents an organic group. The organic group may have a substituent, and examples thereof include an alkyl group, a cycloalkyl group, an aryl group, an aralkyl group, an alkenyl group, and an ester group (-OCOR or -COOR: R is an alkyl group or fluorinated alkyl group having 1 to 20 carbon atoms).

R' represents a hydrogen atom or an organic group. Examples of the organic group include an organic group such as an alkyl group, a cycloalkyl group, an aryl group, an aralkyl group, and an alkenyl group. In addition, a hydrogen atom in the organic group may be substituted with a fluorine atom or an iodine atom.

(Repeating Unit Represented by Formula (D))

As an example of a specific unit for achieving (d) above, a method of introducing a repeating unit represented by Formula (D) into the resin (A) may be mentioned.

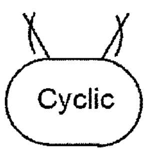 (D)

In Formula (D), "Cyclic" represents a group that forms a main chain with a cyclic structure. The number of the ring-constituting atoms is not particularly limited.

Specific examples of the repeating unit represented by Formula (D) include the following repeating units.

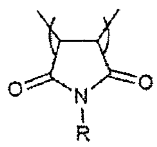 (D-1) 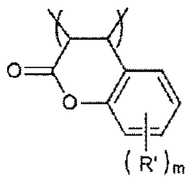 (D-2) 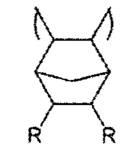 (D-3) 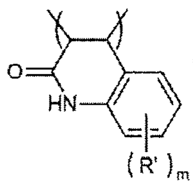 (D-4)

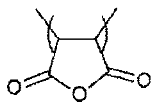 (D-5) 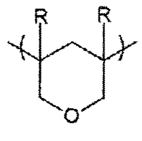 (D-6) 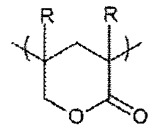 (D-7) 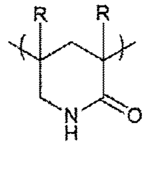 (D-8)

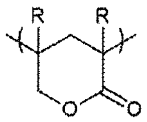 (D-9) 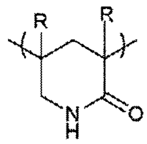 (D-10) 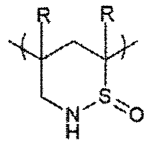 (D-11) 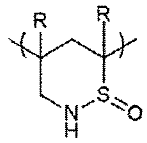 (D-12)

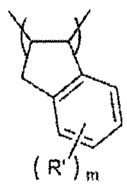 (D-13) 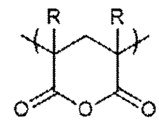 (D-14) 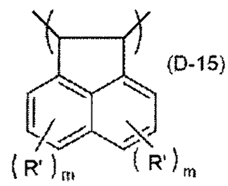 (D-15) 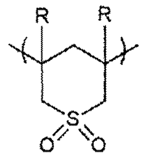 (D-16)

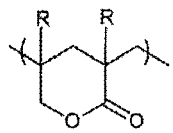 (D-17) 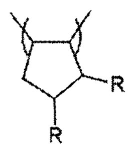 (D-18) 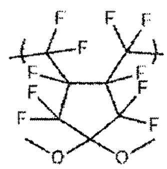 (D-19)

In the formula, R's each independently represent a hydrogen atom, an alkyl group, a cycloalkyl group, an aryl group, an aralkyl group, an alkenyl group, a hydroxyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, the hydrogen atom bonded to the carbon atom in the group represented by R may be substituted with a fluorine atom or an iodine atom.

In the formula, R"s each independently represent an alkyl group, a cycloalkyl group, an aryl group, an aralkyl group, an alkenyl group, a hydroxyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. Incidentally, a hydrogen atom bonded to the carbon atom in the group represented by R' may be substituted with a fluorine atom or an iodine atom.

m represents an integer of 0 or more. The upper limit of m is not particularly limited, but is 2 or less in many cases, and 1 or less in more cases.

(Repeating Unit Represented by Formula (E))

As an example of a specific unit for achieving (e) above, a method of introducing a repeating unit represented by Formula (E) into the resin (A) may be mentioned.

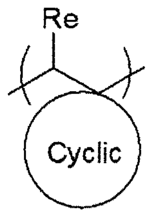

(E)

In Formula (E), Re's each independently represent a hydrogen atom or an organic group. Examples of the organic group include an alkyl group, a cycloalkyl group, an aryl group, an aralkyl group, and an alkenyl group, each of which may have a substituent.

"Cyclic" is a cyclic group including a carbon atom of the main chain. The number of atoms included in the cyclic group is not particularly limited.

Specific examples of the repeating unit represented by Formula (E) include the following repeating units.

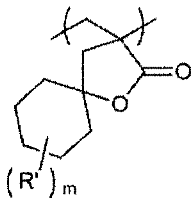 (E-1) 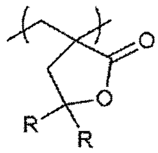 (E-2) 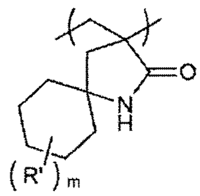 (E-3) 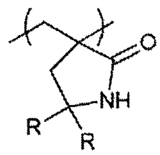 (E-4)

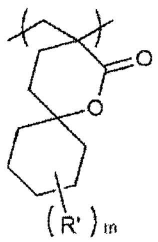 (E-5) 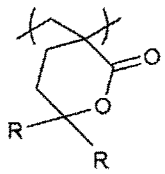 (E-6) 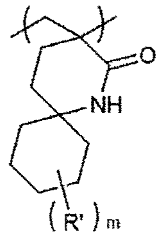 (E-7) 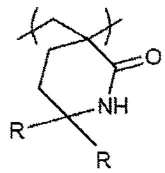 (E-8)

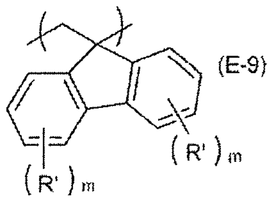 (E-9) 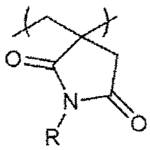 (E-10) 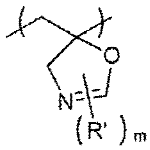 (E-11) 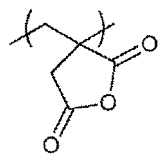 (E-12)

In the formula, R's each independently represent a hydrogen atom, an alkyl group, a cycloalkyl group, an aryl group, an aralkyl group, an alkenyl group, a hydroxyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, the hydrogen atom bonded to the carbon atom in the group represented by R may be substituted with a fluorine atom or an iodine atom.

R"s each independently represent a hydrogen atom, an alkyl group, a cycloalkyl group, an aryl group, an aralkyl group, an alkenyl group, a hydroxyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. Incidentally, a hydrogen atom bonded to the carbon atom in the group represented by R' may be substituted with a fluorine atom or an iodine atom.

m represents an integer of 0 or more. The upper limit of m is not particularly limited, but is 2 or less in many cases, and 1 or less in more cases.

In addition, in Formula (E-2), Formula (E-4), Formula (E-6), and Formula (E-8), two R's may be bonded to each other to form a ring.

<Repeating Unit Having at Least One Group selected from Lactone Group, Hydroxyl Group, Cyano Group, or Alkali-Soluble Group>

The resin (A) may have a repeating unit having at least one group selected from a lactone group, a hydroxyl group, a cyano group, or an alkali-soluble group.

Examples of the repeating unit having a lactone group contained in the resin (A) include the repeating unit described in <Repeating Unit Having Lactone Group> described above.

The resin (A) may have a repeating unit having a hydroxyl group or a cyano group. As a result, the adhesiveness to a substrate and the affinity for a developer are improved.

The repeating unit having a hydroxyl group or a cyano group is preferably a repeating unit having an alicyclic hydrocarbon structure substituted with a hydroxyl group or a cyano group.

The repeating unit having a hydroxyl group or a cyano group preferably has no acid-decomposable group. Examples of the repeating unit having a hydroxyl group or a cyano group include repeating units represented by General Formulae (AIIa) to (AIId).

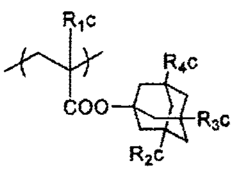
(AIIa)

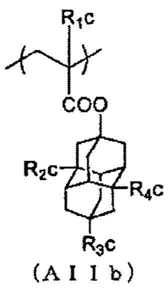
(AIIb)

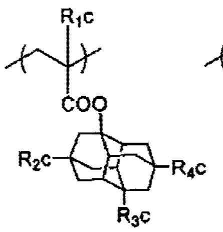
(AIIc)

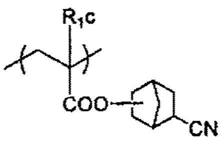
(AIId)

In General Formulae (AIIa) to (AIId),

$R_{1c}$ represents a hydrogen atom, a methyl group, a trifluoromethyl group, or a hydroxymethyl group.

$R_{2c}$ to $R_{4c}$ each independently represent a hydrogen atom, a hydroxyl group, or a cyano group. It should be noted that at least one of $R_{2c}$, ..., or $R_{4c}$ represents a hydroxyl group or a cyano group. Preferably, one or two of $R_{2c}$ to $R_{4c}$ are hydroxyl groups, and the rest are hydrogen atoms. More preferably, two of $R_{2c}$ to $R_{4c}$ are hydroxyl groups and the rest are hydrogen atoms.

The content of the repeating unit having a hydroxyl group or a cyano group is preferably 5% by mole or more, and more preferably 10% by mole or more with respect to all the repeating units in the resin (A). In addition, an upper limit value thereof is preferably 40% by mole or less, more preferably 30% by mole or less, and still more preferably 25% by mole or less.

Specific examples of the repeating unit having a hydroxyl group or a cyano group are shown below, but the present invention is not limited thereto.

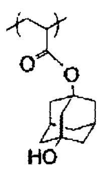
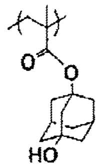
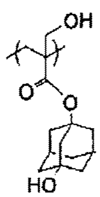
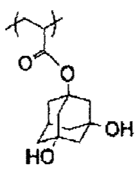
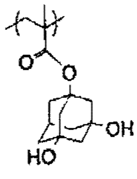
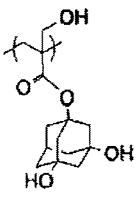

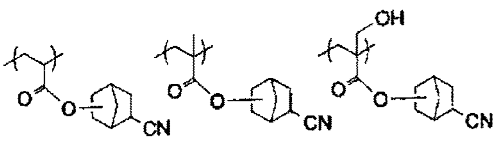
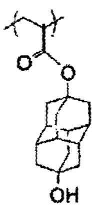
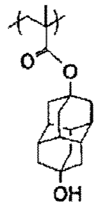
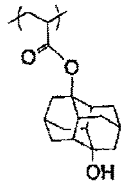
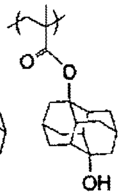

The resin (A) may have a repeating unit having an alkali-soluble group.

Examples of the alkali-soluble group include a carboxyl group, a sulfonamide group, a sulfonylimide group, a

bissulfonylimide group, or an aliphatic alcohol in which the α-position is substituted with an electron-withdrawing group (for example, a hexafluoroisopropanol group), and the carboxyl group is preferable. In a case where the resin (A) includes a repeating unit having an alkali-soluble group, the resolution for use in contact holes is increased.

Examples of the repeating unit having an alkali-soluble group include a repeating unit in which an alkali-soluble group is directly bonded to the main chain of a resin such as a repeating unit with acrylic acid and methacrylic acid, or a repeating unit in which an alkali-soluble group is bonded to the main chain of the resin via a linking group. Further, the linking group may have a monocyclic or polycyclic cyclic hydrocarbon structure.

The repeating unit having an alkali-soluble group is preferably a repeating unit with acrylic acid or methacrylic acid.

The content of the repeating unit having an alkali-soluble group is preferably 0% by mole or more, more preferably 3% by mole or more, and still more preferably 5% by mole or more with respect to all the repeating units in the resin (A). An upper limit value thereof is preferably 20% by mole or less, more preferably 15% by mole or less, and still more preferably 10% by mole or less.

Specific examples of the repeating unit having an alkali-soluble group are shown below, but the present invention is not limited thereto. In the specific examples, Rx represents H, $CH_3$, $CH_2OH$, or $CF_3$.

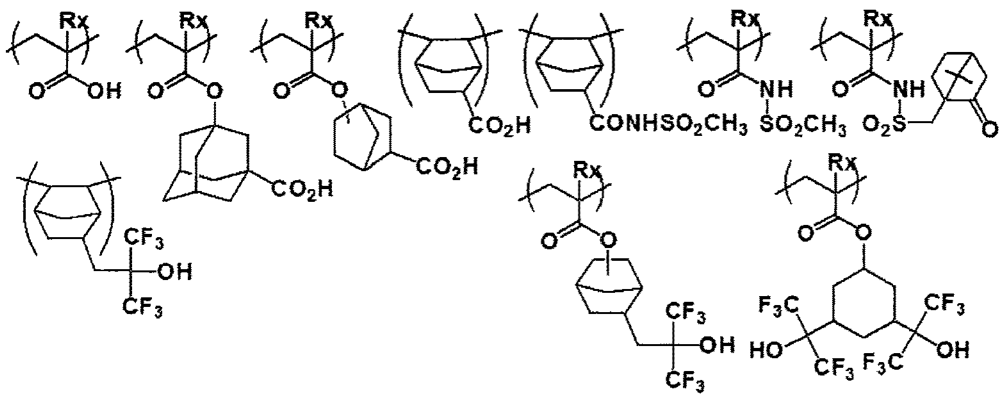

As the repeating unit having at least one group selected from a lactone group, a hydroxyl group, a cyano group, or an alkali-soluble group, a repeating unit having at least two selected from a lactone group, a hydroxyl group, a cyano group, or an alkali-soluble group is preferable, a repeating unit having a cyano group and a lactone group is more preferable, and a repeating unit having a structure in which a cyano group is substituted in the lactone structure represented by General Formula (LC1-4) is still more preferable.

<Repeating Unit Having Alicyclic Hydrocarbon Structure and Not Exhibiting Acid Decomposability>

The resin (A) may have a repeating unit having an alicyclic hydrocarbon structure and not exhibiting acid decomposability. This can reduce the elution of low-molecular-weight components from the resist film into an immersion liquid during liquid immersion exposure. Examples of such the repeating unit include repeating units derived from 1-adamantyl (meth)acrylate, diamantyl (meth)acrylate, tricyclodecanyl (meth)acrylate, and cyclohexyl (meth)acrylate.

<Repeating Unit Represented by General Formula (III) Having Neither Hydroxyl Group Nor Cyano Group>

The resin (A) may have a repeating unit represented by General Formula (III), which has neither a hydroxyl group nor a cyano group.

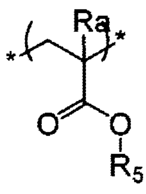
(III)

In General Formula (III), $R_5$ represents a hydrocarbon group having at least one cyclic structure and having neither a hydroxyl group nor a cyano group.

Ra represents a hydrogen atom, an alkyl group, or a $-CH_2-O-Ra_2$ group. In the formula, $Ra_2$ represents a hydrogen atom, an alkyl group, or an acyl group.

The cyclic structure contained in $R_5$ includes a monocyclic hydrocarbon group and a polycyclic hydrocarbon group. Examples of the monocyclic hydrocarbon group include a cycloalkyl group having 3 to 12 carbon atoms (more preferably 3 to 7 carbon atoms) or a cycloalkenyl group having 3 to 12 carbon atoms.

Examples of the polycyclic hydrocarbon group include a ring-assembled hydrocarbon group and a crosslinked cyclic hydrocarbon group. Examples of the crosslinked cyclic hydrocarbon ring include a bicyclic hydrocarbon ring, a tricyclic hydrocarbon ring, and a tetracyclic hydrocarbon ring. Further, examples of the crosslinked cyclic hydrocarbon ring also include a fused ring formed by fusing a plurality of 5- to 8-membered cycloalkane rings.

As the crosslinked cyclic hydrocarbon group, a norbornyl group, an adamantyl group, a bicyclooctanyl group, or a tricyclo$[5,2,1,0^{2,6}]$decanyl group is preferable, and the norbornyl group or the adamantyl group is more preferable.

The alicyclic hydrocarbon group may have a substituent, and examples of the substituent include a halogen atom, an alkyl group, a hydroxyl group protected with a protective group, and an amino group protected with a protective group.

The halogen atom is preferably a bromine atom, a chlorine atom, or a fluorine atom.

As the alkyl group, a methyl group, an ethyl group, a butyl group, or a t-butyl group is preferable. The alkyl group may further have a substituent, and examples of the substituent include a halogen atom, an alkyl group, a hydroxyl group protected with a protective group, and an amino group protected with a protective group.

Examples of the protective group include an alkyl group, a cycloalkyl group, an aralkyl group, a substituted methyl group, a substituted ethyl group, an alkoxycarbonyl group, and an aralkyloxycarbonyl group.

As the alkyl group, an alkyl group having 1 to 4 carbon atoms is preferable.

As the substituted methyl group, a methoxymethyl group, a methoxythiomethyl group, a benzyloxymethyl group, a t-butoxymethyl group, or a 2-methoxyethoxymethyl group is preferable.

The substituted ethyl group is preferably a 1-ethoxyethyl group or a 1-methyl-1-methoxyethyl group.

As the acyl group, an aliphatic acyl group having 1 to 6 carbon atoms, such as a formyl group, an acetyl group, a propionyl group, a butyryl group, an isobutyryl group, a valeryl group, and a pivaloyl group, is preferable.

As the alkoxycarbonyl group, an alkoxycarbonyl group having 1 to 4 carbon atoms is preferable.

The content of the repeating unit represented by General Formula (III), which has neither a hydroxyl group nor a cyano group, is preferably 0% to 40% by mole, and more preferably 0% to 20% by mole with respect to all the repeating units in the resin (A).

Specific examples of the repeating unit represented by General Formula (III) are shown below, but the present invention is not limited thereto. In the formulae, Ra represents H, $CH_3$, $CH_2OH$, or $CF_3$.

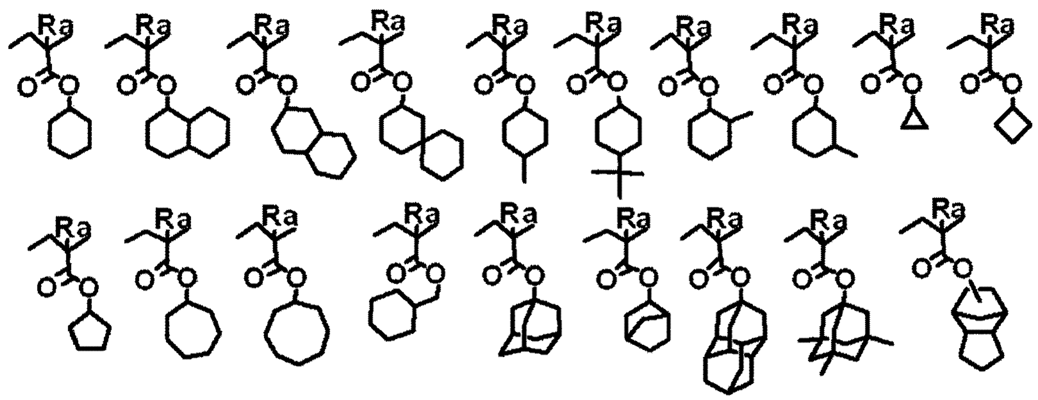

The resin (A) may have a variety of repeating structural units, in addition to the repeating structural units described above, for the purpose of adjusting dry etching resistance, suitability for a standard developer, adhesiveness to a substrate, a resist profile, resolving power, heat resistance, sensitivity, and the like.

In the resin (A), all the repeating units are preferably constituted with (meth)acrylate-based repeating units. In this case, any of a resin in which all of the repeating units are methacrylate-based repeating units, a resin in which all of the repeating units are acrylate-based repeating units, and a resin in which all of the repeating units are methacrylate-based repeating units and acrylate-based repeating units can be used, and it is preferable that the amount of the acrylate-based repeating units is 50% by mole or less with respect to all the repeating units.

<Specific Aspects of Resin (A)>

Specific examples of the resin (A) include resins selected from the group consisting of the following Resins X1 to X3.

Resin X1: A resin including a repeating unit A derived from one or more monomers selected from the following monomer group A and a repeating unit B derived from one or more monomers selected from the following monomer group B.

Resin X2: A resin including a repeating unit A derived from one or more monomers selected from the following monomer group A, a repeating unit B derived from one or more monomers selected from the following monomer group B, and a repeating unit C derived from one or more monomers selected from the following monomer group C.

Resin X3: A resin including a repeating unit including an aromatic ring, and at least one repeating unit of a repeating unit A derived from one or more monomers selected from the following monomer group A or a repeating unit B derived from one or more monomers selected from the following monomer group B.

Furthermore, the repeating unit B derived from one or more monomers selected from the following monomer group B corresponds to a repeating unit having a group having a polarity that increases through decomposition by the action of an acid.

In addition, in Resin X3, in a case where the repeating unit including an aromatic ring does not correspond to the repeating unit having an acid-decomposable group, it is preferable that Resin X3 preferably includes the repeating unit B as the repeating unit having an acid-decomposable group.

Monomer group A:

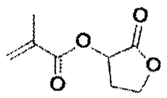
(a-1)

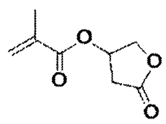
(a-2)

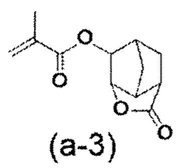
(a-3)

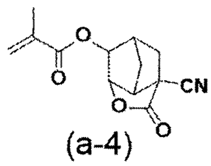
(a-4)

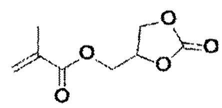
(a-5)

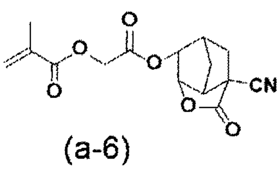
(a-6)

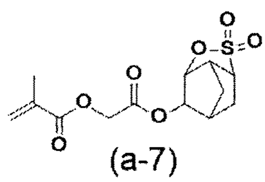
(a-7)

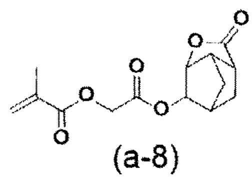
(a-8)

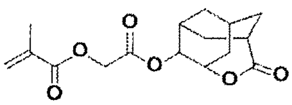
(a-9)

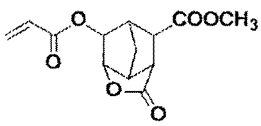
(a-10)

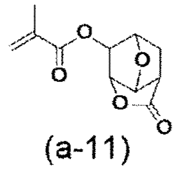
(a-11)

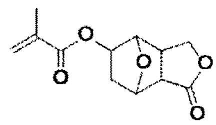
(a-12)

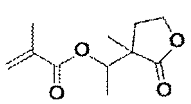
(a-13)

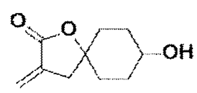
(a-14)

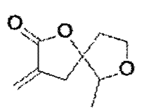
(a-15)

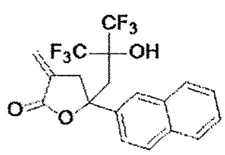
(a-16)

Monomer group B:

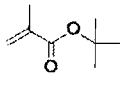 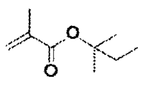 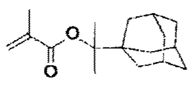 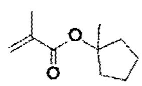 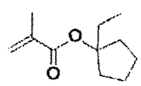

(b-1) (b-2) (b-3) (b-4) (b-5)

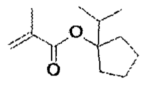 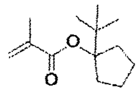 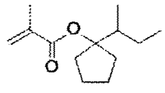 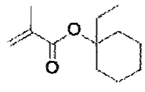 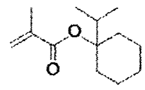

(b-6) (b-7) (b-8) (b-9) (b-10)

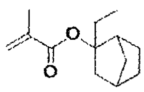 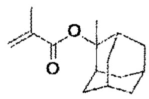 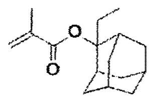 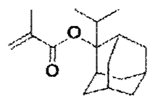 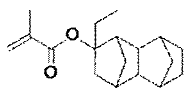

(b-11) (b-12) (b-13) (b-14) (b-15)

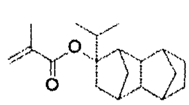 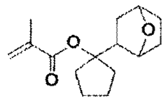 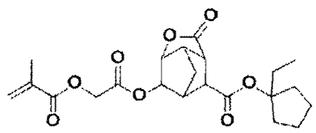

(b-16) (b-17) (b-18)

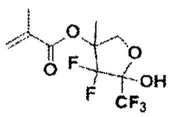 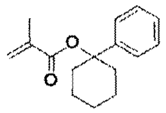 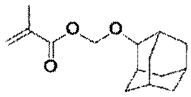 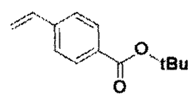

(b-19) (b-20) (b-21) (b-22)

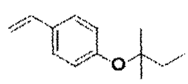 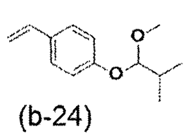

(b-23) (b-24)

Monomer group C:

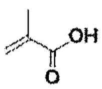 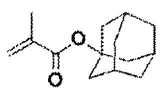 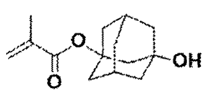 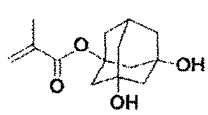 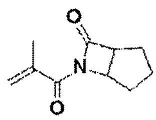

(c-1) (c-2) (c-3) (c-4) (c-5)

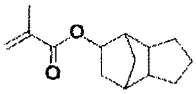
(c-6)
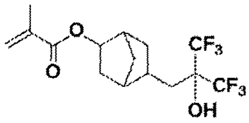
(c-7)
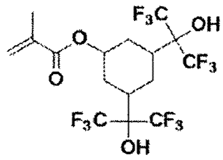
(c-8)
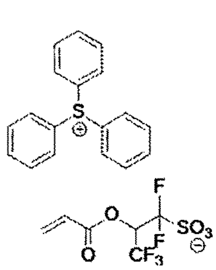
(c-9)

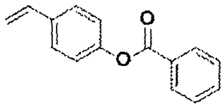
(c-10)
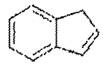
(c-11)
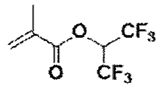
(c-12)
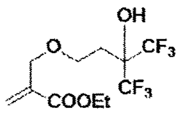
(c-13)

The repeating unit including an aromatic ring is not particularly limited, but is preferably, for example, a repeating unit derived from at least one of a monomer of Formula (d-1) or a monomer of Formula (d-2).

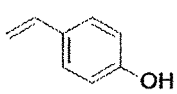
(d-1)
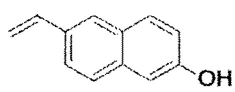
(d-2)

The monomer group A is preferably the following monomer group A1.

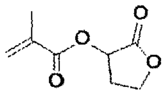
(a-1)
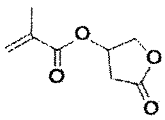
(a-2)
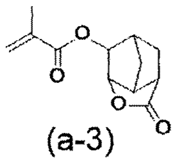
(a-3)
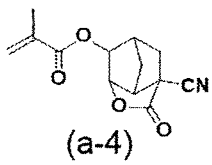
(a-4)
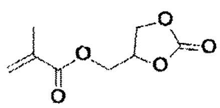
(a-5)

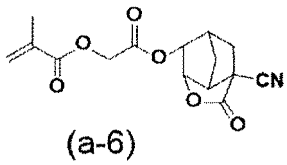
(a-6)
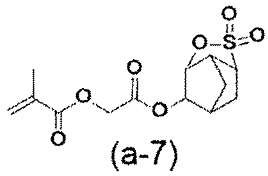
(a-7)
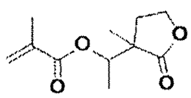
(a-13)

The monomer group B is preferably the following monomer group B1.

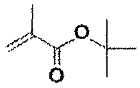
(b-1)
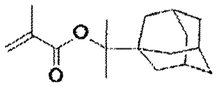
(b-3)
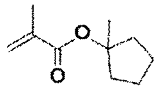
(b-4)
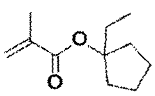
(b-5)
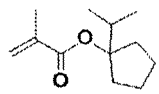
(b-6)

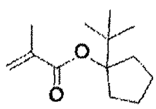
(b-7)
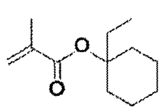
(b-9)
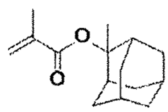
(b-12)
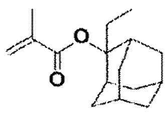
(b-13)
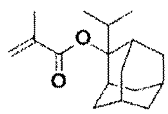
(b-14)

The monomer group C is preferably the following monomer group C1.

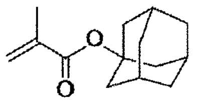

(c-2)

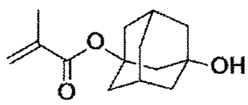

(c-3)

Each of the repeating unit A and the repeating unit B may be included singly or in combination of two or more kinds thereof in Resin X1.

The content of the repeating unit A included in Resin X1 (in a case where the repeating units A are present in a plural number, a total content thereof) is preferably 20% to 85% by mole, more preferably 20% to 70% by mole, and still more preferably 20% to 60% by mole with respect to all the repeating units of Resin X1.

The content of the repeating unit B included in Resin X1 (in a case where the repeating units B are present in a plural number, a total content thereof) is preferably 15% to 80% by mole, more preferably 25% to 80% by mole, and still more preferably 30% to 70% by mole with respect to all the repeating units of Resin X1.

In Resin X2, the repeating unit A, the repeating unit B, and the repeating unit C may be included singly or in combination of two or more kinds thereof.

The content of the repeating unit A included in Resin X2 (in a case where the repeating units A are present in a plural number, a total content thereof) is preferably 20% to 80% by mole, more preferably 20% to 70% by mole, and still more preferably 20% to 60% by mole with respect to all the repeating units of Resin X2.

The content of the repeating unit B included in Resin X2 (in a case where the repeating units B are present in a plural number, a total content thereof) is preferably 15% to 70% by mole, more preferably 25% to 70% by mole, and still more preferably 30% to 60% by mole with respect to all the repeating units of Resin X2.

The content of the repeating unit C included in Resin X2 (in a case where the repeating units C are present in a plural number, a total content thereof) is preferably 5% to 30% by mole, and more preferably 5% to 20% by mole with respect to all the repeating units of Resin X2.

In Resin X3, each of the repeating unit including an aromatic ring, the repeating unit A, and the repeating unit B may be included singly or in combination of two or more kinds thereof.

The content of the repeating unit including an aromatic ring included in Resin X3 (in a case where the repeating units including an aromatic ring are present in a plural number, a total content thereof) is preferably 30% to 90% by mole, more preferably 40% to 85% by mole, and still more preferably 50% to 85% by mole with respect to all the repeating units of Resin X3.

In a case where Resin X3 includes the repeating unit A, the content of the repeating unit A included in Resin X3 (in a case where the repeating units A are present in a plural number, a total content thereof) is preferably 10% to 70% by mole, more preferably 10% to 40% by mole, and still more preferably 10% to 20% by mole with respect to all the repeating units of Resin X3.

In a case where Resin X3 includes the repeating unit B, the content of the repeating unit B included in Resin X3 (in a case where the repeating units B are present in a plural number, a total content thereof) is preferably 15% to 70% by mole, and more preferably 15% to 40% by mole with respect to all the repeating units of Resin X3.

Resins X1 to X3 are each preferably, above all, a resin selected from the group consisting of Formula (A-1), Formula (A-3), Formula (A-4), Formula (A-6), and Formula (A-8), Formula (A-12), Formula (A-13), Formula (A-14), Formula (A-16), Formula (A-19), Formula (A-41), Formula (A-42), Formula (A-43), Formula (A-46), and Formula (A-48).

Furthermore, the resins represented by Formula (A-1), Formula (A-3), Formula (A-4), Formula (A-6), Formula (A-8), Formula (A-12), Formula (A-13), Formula (A-14), Formula (A-16), Formula (A-19), Formula (A-41), Formula (A-42), Formula (A-43), Formula (A-46), and Formula (A-48) mean resins including a repeating unit in each formula, and the content of each of the repeating units is particularly not limited. For example, the resin represented by Formula (A-1) only needs to include the four repeating units, and the content of each repeating unit is not limited. * in the formulae represents a bonding position.

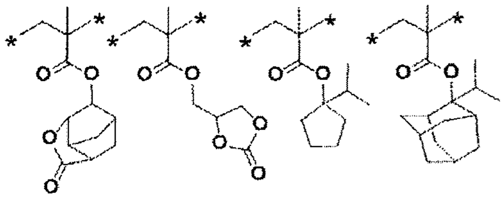

(A-1)

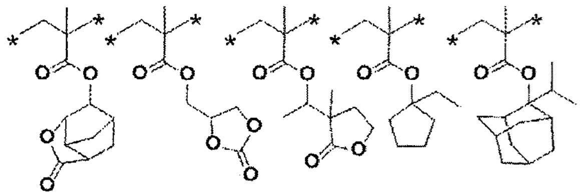

(A-3)

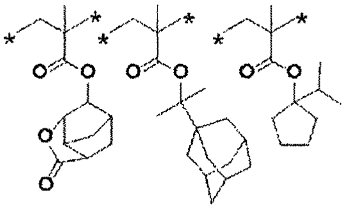

(A-4)

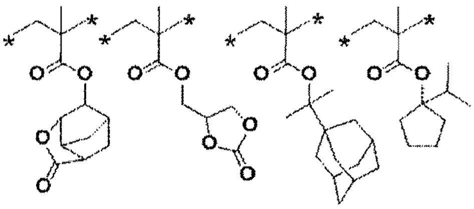

(A-6)

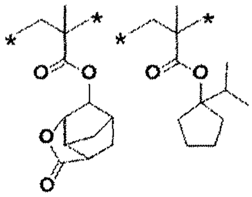

(A-8)

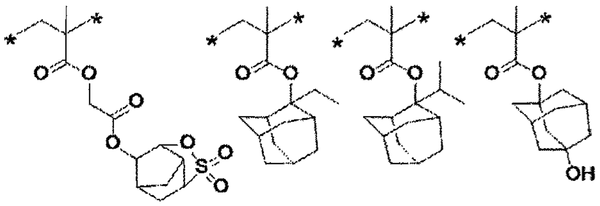

(A-12)

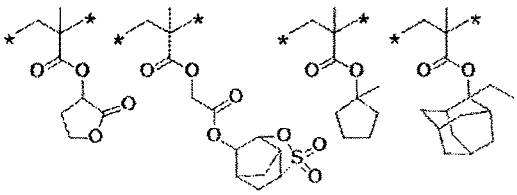

(A-13)

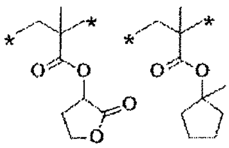

(A-14)

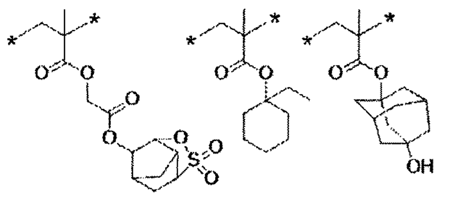
(A-16)

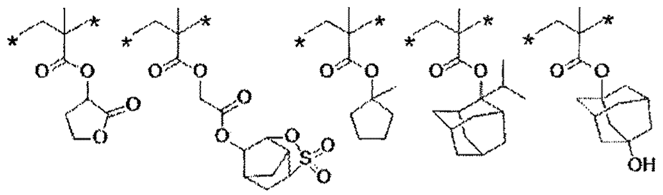
(A-19)

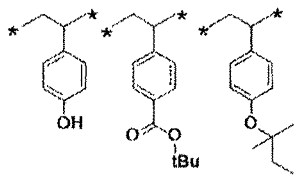
(A-41)

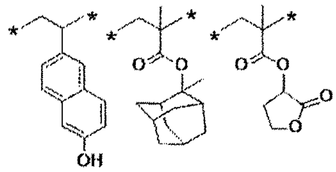
(A-42)

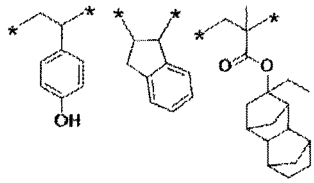
(A-43)

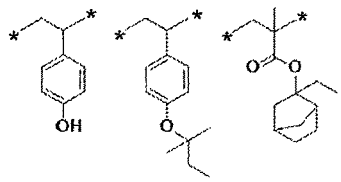
(A-46)

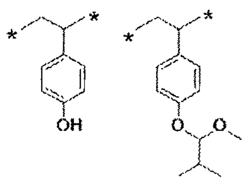
(A-48)

In addition, other examples of Resin X1 or Resin X2 that can be used in the present invention are shown below.

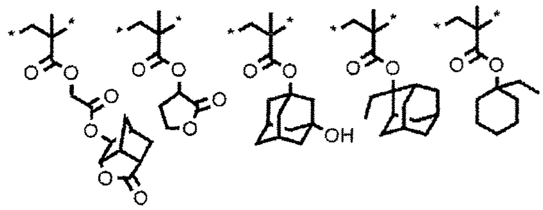

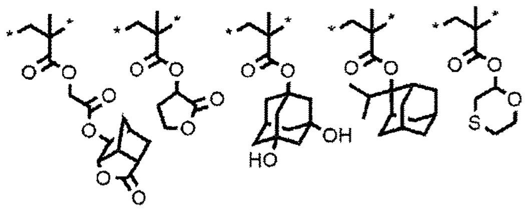

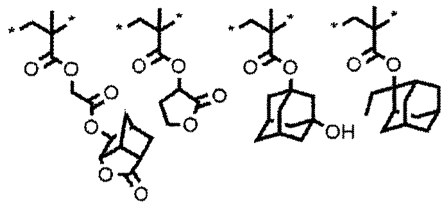

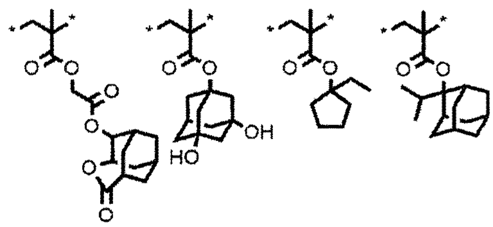

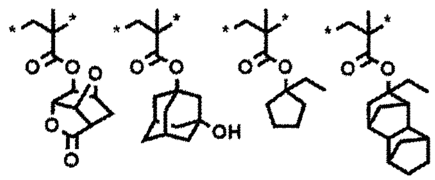

The resin (A) can be synthesized in accordance with an ordinary method (for example, radical polymerization).

The weight-average molecular weight of the resin (A) as a value expressed in terms of polystyrene by a GPC method is preferably 1,000 to 200,000, more preferably 3,000 to 20,000, and still more preferably 5,000 to 15,000. By setting the weight-average molecular weight of the resin (A) to 1,000 to 200,000, deterioration of heat resistance and dry etching resistance can be further suppressed. In addition, deterioration of developability and deterioration of film forming property due to high viscosity can also be further suppressed.

The dispersity (molecular weight distribution) of the resin (A) is usually 1 to 5, preferably 1 to 3, more preferably 1.2 to 3.0, and still more preferably 1.2 to 2.0. The smaller the dispersity, the more excellent the resolution and the resist shape, and the smoother the side wall of the resist pattern, the more excellent the roughness.

The content of the resin (A) in the resist composition is preferably 50% to 99.9% by mass, and more preferably 60% to 99.0% by mass with respect to the total solid content of the composition.

Furthermore, the solid content is intended to be components excluding the solvent in the composition, and any of components other than the solvent are regarded as a solid content even in a case where they are liquid components.

In addition, the resin (A) may be used singly or in combination of a plurality thereof.

[Photoacid Generator (B)]

The resist composition of the embodiment of the present invention includes a compound that generates an

acid upon irradiation with actinic rays or radiation (hereinafter also referred to as a "photoacid generator").

Furthermore, the photoacid generator as mentioned herein corresponds to an acid generator which is usually used to cause a deprotection reaction of a resin component (a deprotection reaction of an acid-decomposable resin) or to cause a crosslinking reaction of a resin component.

As the photoacid generator, a compound that generates an organic acid upon irradiation with actinic rays or radiation is preferable. Examples thereof include a sulfonium salt compound, an iodonium salt compound, a diazonium salt compound, a phosphonium salt compound, an imidosulfonate compound, an oxime sulfonate compound, a diazodisulfone compound, a disulfone compound, and an o-nitrobenzyl sulfonate compound.

As the photoacid generators, known compounds that generate an acid upon irradiation with actinic rays or radiation can be used singly or as a mixture thereof, appropriately selected and used. For example, the known compounds disclosed in paragraphs [0125] to [0319] of the specification of US2016/0070167A1, paragraphs [0086] to [0094] of the specification of US2015/0004544A1, and paragraphs [0323] to [0402] of the specification of US2016/0237190A1 can be suitably used as the photoacid generator.

As the photoacid generator, for example, a compound represented by Formula (ZI), Formula (ZII), or Formula (ZIII) is preferable.

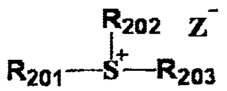 (ZI) 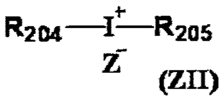 (ZII) 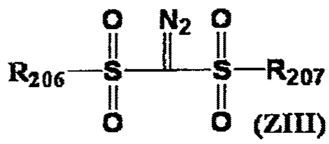 (ZIII)

In Formula (ZI),

$R_{201}$, $R_{202}$, and $R_{203}$ each independently represent an organic group.

The organic group as each of $R_{201}$, $R_{202}$, and $R_{203}$ generally has 1 to 30 carbon atoms, and preferably has 1 to 20 carbon atoms.

In addition, two of $R_{201}$ to $R_{203}$ may be bonded to each other to form a ring structure, and the ring may include an oxygen atom, a sulfur atom, an ester bond, an amide bond, or a carbonyl group. Examples of the group formed by the bonding of two of $R_{201}$ to $R_{203}$ include an alkylene group (for example, a butylene group and a pentylene group), and $-CH_2-CH_2-O-CH_2-CH_2-$.

$Z^-$ represents an anion.

Suitable aspects of the cation in Formula (ZI) include the corresponding groups in a compound (ZI-1), a compound (ZI-2), a compound (ZI-3), and a compound (ZI-4) which will be described later.

Furthermore, the photoacid generator may be a compound having a plurality of the structures represented by Formula (ZI). For example, the photoacid generator may be a compound having a structure in which at least one of $R_{201}$, $R_{202}$, or $R_{203}$ of the compound represented by Formula (ZI) and at least one of $R_{201}$, $R_{202}$, or $R_{203}$ of another compound represented by Formula (ZI) are bonded via a single bond or a linking group.

First, the compound (ZI-1) will be described.

The compound (ZI-1) is an arylsulfonium compound in which at least one of $R_{201}$, $R_{202}$, or $R_{203}$ in Formula (ZI) is an aryl group, that is, a compound having arylsulfonium as a cation.

In the arylsulfonium compound, all of $R^{201}$ to $R^{203}$ may be aryl groups, or some of $R^{201}$ to $R^{203}$ may be an aryl group, and the rest may be an alkyl group or a cycloalkyl group.

Examples of the arylsulfonium compound include a triarylsulfonium compound, a diarylalkylsulfonium compound, an aryldialkylsulfonium compound, a diarylcycloalkylsulfonium compound, and an aryldicycloalkylsulfonium compound.

As the aryl group included in the arylsulfonium compound, a phenyl group or a naphthyl group is preferable, and the phenyl group is more preferable. The aryl group may be an aryl group which has a heterocyclic structure having an oxygen atom, a nitrogen atom, a sulfur atom, or the like. Examples of the heterocyclic structure include a pyrrole residue, a furan residue, a thiophene residue, an indole residue, a benzofuran residue, and a benzothiophene residue. In a case where the arylsulfonium compound has two or more aryl groups, the two or more aryl groups may be the same as or different from each other.

The alkyl group or the cycloalkyl group contained in the arylsulfonium compound, as necessary, is preferably a linear alkyl group having 1 to 15 carbon atoms, a branched alkyl group having 3 to 15 carbon atoms, or a cycloalkyl group having 3 to 15 carbon atoms, and examples thereof include a methyl group, an ethyl group, a propyl group, an n-butyl group, a sec-butyl group, a t-butyl group, a cyclopropyl group, a cyclobutyl group, and a cyclohexyl group.

The aryl group, the alkyl group, and the cycloalkyl group represented by each of $R_{201}$ to $R_{203}$ may each independently have an alkyl group (for example, having 1 to 15 carbon atoms), a cycloalkyl group (for example, having 3 to 15 carbon atoms), an aryl group (for example, having 6 to 14 carbon atoms), an alkoxy group (for example, having

1 to 15 carbon atoms), a halogen atom, a hydroxyl group, or a phenylthio group as a substituent.

Next, the compound (ZI-2) will be described.

The compound (ZI-2) is a compound in which $R_{201}$ to $R_{203}$ in Formula (ZI) each independently represent an organic group having no aromatic ring. Here, the aromatic ring also includes an aromatic ring including a heteroatom.

The organic group having no aromatic ring as each of $R_{201}$ to $R_{203}$ generally has 1 to 30 carbon atoms, and preferably 1 to 20 carbon atoms.

$R_{201}$ to $R_{203}$ are each independently preferably an alkyl group, a cycloalkyl group, an allyl group, or a vinyl group, more preferably a linear or branched 2-oxoalkyl group, a 2-oxocycloalkyl group, or an alkoxycarbonylmethyl group, and still more preferably the linear or branched 2-oxoalkyl group.

As the alkyl group and the cycloalkyl group of each of $R_{201}$ to $R_{203}$, a linear alkyl group having 1 to 10 carbon atoms or branched alkyl group having 3 to 10 carbon atoms (for example, a methyl group, an ethyl group, a propyl group, a butyl group, and a pentyl group), or a cycloalkyl group having 3 to 10 carbon atoms (for example, a cyclopentyl group, a cyclohexyl group, and a norbornyl group) is preferable.

$R_{201}$ to $R_{203}$ may be further substituted with a halogen atom, an alkoxy group (for example, having 1 to 5 carbon atoms), a hydroxyl group, a cyano group, or a nitro group.

Next, the compound (ZI-3) will be described.

The compound (ZI-3) is a compound represented by Formula (ZI-3) and having a phenacylsulfonium salt structure.

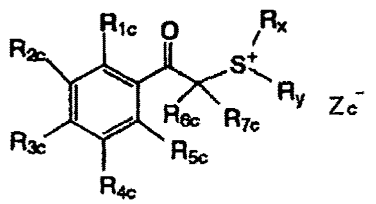

(ZI-3)

In Formula (ZI-3),

$R_{1c}$ to $R_{5c}$ each independently represent a hydrogen atom, an alkyl group, a cycloalkyl group, an aryl group, an alkoxy group, an aryloxy group, an alkoxycarbonyl group, an alkylcarbonyloxy group, a cycloalkylcarbonyloxy group, a halogen atom, a hydroxyl group, a nitro group, an alkylthio group, or an arylthio group.

$R_{6c}$ and $R_{7c}$ each independently represent a hydrogen atom, an alkyl group, a cycloalkyl group, a halogen atom, a cyano group, or an aryl group.

$R_x$ and $R_y$ each independently represent an alkyl group, a cycloalkyl group, a 2-oxoalkyl group, a 2-oxocycloalkyl group, an alkoxycarbonylalkyl group, an allyl group, or a vinyl group.

Any two or more of $R_{1c}$, ..., or $R_{5c}$, $R_{5c}$ and $R_{6c}$, $R_{6c}$ and $R_{7c}$, $R_{5c}$ and $R_x$, and $R_x$ and $R_y$ may be bonded to each other to form a ring structure, and the ring structure may each independently include an oxygen atom, a sulfur atom, a ketone group, an ester bond, or an amide bond.

Examples of the ring structure include an aromatic or non-aromatic hydrocarbon ring, an aromatic or non-aromatic heterocycle, and a polycyclic fused ring in which two or more of these rings are combined. Examples of the ring structure include a 3- to 10-membered ring and the ring structure is preferably a 4- to 8-membered ring, and more preferably a 5- or 6-membered ring.

Examples of the group formed by the bonding of any two or more of $R_{1c}$, ..., or $R_{5c}$, R6c and $R_{7c}$, and $R_x$ and $R_y$ include a butylene group and a pentylene group.

As the group formed by the bonding of $R_{5c}$ and $R_{6c}$, and Rsc and $R_x$, a single bond or an alkylene group is preferable. Examples of the alkylene group include a methylene group and an ethylene group.

$Zc^-$ represents an anion.

Next, the compound (ZI-4) will be described.

The compound (ZI-4) is represented by Formula (ZI-4).

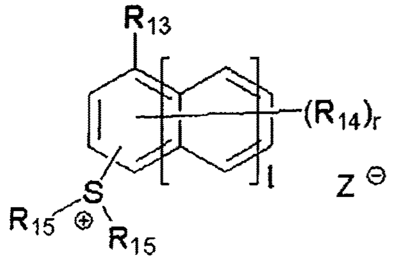

(ZI-4)

In Formula (ZI-4),
1 represents an integer of 0 to 2.

r represents an integer of 0 to 8.

$R_{13}$ represents a group having a hydrogen atom, a fluorine atom, a hydroxyl group, an alkyl group, a cycloalkyl group, an alkoxy group, an alkoxycarbonyl group, or a cycloalkyl group. These groups may have a substituent.

$R_{14}$ represents a hydroxyl group, an alkyl group, a cycloalkyl group, an alkoxy group, an alkoxycarbonyl group, an alkylcarbonyl group, an alkylsulfonyl group, a cycloalkylsulfonyl group, or a group having a cycloalkyl group. These groups may have a substituent. In a case where $R_{14}$'s are present in a plural number, they each independently represent the group such as a hydroxyl group.

$R_{15}$'s each independently represent an alkyl group, a cycloalkyl group, or a naphthyl group. These groups may have a substituent. Two $R_{15}$'s may be bonded to each other to form a ring. In a case where two $R_{15}$'s are bonded to each other to form a ring, the ring skeleton may include a heteroatom such as an oxygen atom and a nitrogen atom. In one aspect, it is preferable that two $R_{15}$'s are alkylene groups and are bonded to each other to form a ring structure.

$Z^-$ represents an anion.

In Formula (ZI-4), the alkyl groups represented by $R_{13}$, $R_{14}$, and $R_{15}$ are linear or branched. The alkyl group preferably has 1 to 10 carbon atoms. As the alkyl group, a methyl group, an ethyl group, an n-butyl group, or a t-butyl group is preferable.

Next, Formulae (ZII) and (ZIII) will be described.

In Formulae (ZII) and (ZIII), $R_{204}$ to $R_{207}$ each independently represent an aryl group, an alkyl group, or a cycloalkyl group.

The aryl group represented by each of $R_{204}$ to $R_{207}$ is preferably a phenyl group or a naphthyl group, and more preferably the phenyl group. The aryl group represented by each of $R_{204}$ to $R_{207}$ may be an aryl group having a heterocyclic structure having an oxygen atom, a nitrogen atom, a sulfur atom, or the like. Examples of the skeleton of the aryl group having a heterocyclic structure include pyrrole, furan, thiophene, indole, benzofuran, and benzothiophene.

As the alkyl group and the cycloalkyl group represented by each of $R_{204}$ to $R_{207}$, a linear alkyl group having 1 to 10 carbon atoms and branched alkyl group having 3 to 10 carbon atoms (for example, a methyl group, an ethyl group, a propyl group, a butyl group, and a pentyl group), or a cycloalkyl group having 3 to 10 carbon atoms (for example, a cyclopentyl group, a cyclohexyl group, and a norbornyl group) is preferable.

The aryl group, the alkyl group, and the cycloalkyl group represented by each of $R_{204}$ to $R_{207}$ may each independently have a substituent. Examples of the substituent which may be contained in the aryl group, the alkyl group, and the cycloalkyl group represented by each of $R_{204}$ to $R_{207}$ include an alkyl group (for example, having 1 to 15 carbon atoms), a cycloalkyl group (for example, having 3 to 15 carbon atoms), an aryl group (for example, having 6 to 15 carbon atoms), an alkoxy group (for example, having 1 to 15 carbon atoms), a halogen atom, a hydroxyl group, and a phenylthio group.

$Z^-$ represents an anion.

As $Z^-$ in Formula (ZI), $Z^-$ in Formula (ZII), $Zc^-$ in Formula (ZI-3), and $Z^-$ in Formula (ZI-4), an anion represented by Formula (3) is preferable.

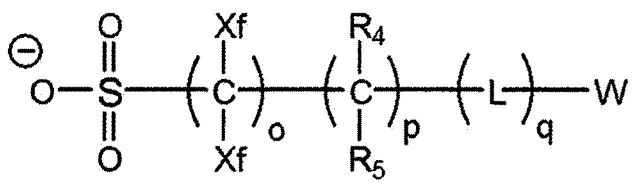

(3)

In Formula (3),
o represents an integer of 1 to 3. p represents an integer of 0 to 10. q represents an integer of 0 to 10.

Xf represents a fluorine atom or an alkyl group substituted with at least one fluorine atom. The alkyl group

preferably has 1 to 10 carbon atoms, and more preferably has 1 to 4 carbon atoms. In addition, a perfluoroalkyl group is preferable as the alkyl group substituted with at least one fluorine atom.

Xf is preferably a fluorine atom or a perfluoroalkyl group having 1 to 4 carbon atoms, and more preferably a fluorine atom or $CF_3$. In particular, it is preferable that both Xf's are fluorine atoms.

$R_4$ and $R_5$ each independently represent a hydrogen atom, a fluorine atom, an alkyl group, or an alkyl group substituted with at least one fluorine atom. In a case where $R_4$'s and Rs's are each present in a plural number, $R_4$'s and $R_5$'s may each be the same as or different from each other.

The alkyl group represented by each of $R_4$ and $R_5$ may have a substituent, and preferably has 1 to 4 carbon atoms. $R_4$ and $R_5$ are each preferably a hydrogen atom.

Specific examples and suitable aspects of the alkyl group substituted with at least one fluorine atom are the same ones as the specific examples and the suitable aspects of Xf in Formula (3), respectively.

L represents a divalent linking group. In a case where L's are present in a plural number, they may be the same as or different from each other.

Examples of the divalent linking group include -COO-(-C(=O)-O-), -OCO-, -CONH-, -NHCO-, -CO-, -O-, -S-, -SO-, $-SO_2-$, an alkylene group (preferably having 1 to 6 carbon atoms), a cycloalkylene group (preferably having 3 to 15 carbon atoms), an alkenylene group (preferably having 2 to 6 carbon atoms), and a divalent linking group formed by combination of a plurality of these groups. Among these, -COO-, -OCO-, -CONH-, -NHCO-, -CO-, -O-, $-SO_2-$, -COO-alkylene group-, -OCO-alkylene group-, -CONH-alkylene group-, or -NHCO-alkylene group- is preferable, and -COO-, -OCO-, -CONH-, $-SO_2-$, -COO-alkylene group -, or -OCO-alkylene group- is more preferable.

W represents an organic group including a cyclic structure. Among those, W is preferably a cyclic organic group.

Examples of the cyclic organic group include an alicyclic group, an aryl group, and a heterocyclic group.

The alicyclic group may be monocyclic or polycyclic. Examples of the monocyclic alicyclic group include monocyclic cycloalkyl groups such as a cyclopentyl group, a cyclohexyl group, and a cyclooctyl group. Examples of the polycyclic alicyclic group include polycyclic cycloalkyl groups such as a norbornyl group, a tricyclodecanyl group, a tetracyclodecanyl group, a tetracyclododecanyl group, and an adamantyl group. Among those, an alicyclic group having a bulky structure having 7 or more carbon atoms, such as a norbornyl group, a tricyclodecanyl group, a tetracyclodecanyl group, a tetracyclododecanyl group, and an adamantyl group, is preferable.

The aryl group may be monocyclic or polycyclic. Examples of the aryl group include a phenyl group, a naphthyl group, a phenanthryl group, and an anthryl group.

The heterocyclic group may be monocyclic or polycyclic. The polycyclic compound can further suppress acid diffusion. Further, the heterocyclic group may have aromaticity or may not have aromaticity. Examples of the heterocycle having aromaticity include a furan ring, a thiophene ring, a benzofuran ring, a benzothiophene ring, a dibenzofuran ring, a dibenzothiophene ring, and a pyridine ring. Examples of the heterocycle not having aromaticity include a tetrahydropyran ring, a lactone ring, a sultone ring, and a decahydroisoquinoline ring. As the heterocycle in the heterocyclic group, the furan ring, the thiophene ring, the pyridine ring, or the decahydroisoquinoline ring is particularly preferable.

The cyclic organic group may have a substituent. Examples of the substituent include an alkyl group (which may be either linear or branched, preferably having 1 to 12 carbon atoms), a cycloalkyl group (which may be any of a monocycle, a polycycle, and a spirocycle, and preferably has 3 to 20 carbon atoms), an aryl group (preferably having 6 to 14 carbon atoms), a hydroxyl group, an alkoxy group, an ester group, an amide group, a urethane group, a ureide group, a thioether group, a sulfonamide group, and a sulfonic ester group. Incidentally, the carbon constituting the cyclic organic group (carbon contributing to ring formation) may be carbonyl carbon.

As the anion represented by Formula (3), $SO_3^-$-$CF_2$-$CH_2$-OCO-(L)q'-W, $SO_3^-$-$CF_2$-CHF-$CH_2$-OCO-(L)q'-W, $SO_3^-$-$CF_2$-COO-(L)q'-W, $SO_3$--$CF_2$-$CF_2$-$CH_2$-$CH_2$-(L)q-W, or $SO_3^-$-$CF_2$-CH($CF_3$)-OCO-(L)q'-W is preferable. Here, L, q, and W are each the same as in Formula (3). q' represents an integer of 0 to 10.

In one aspect, as $Z^-$ in Formula (ZI), $Z^-$ in Formula (ZII), $Zc^-$ in Formula (ZI-3), and $Z^-$ in Formula (ZI-4), an anion represented by Formula (4) is also preferable.

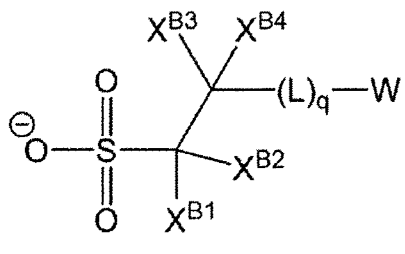

(4)

In Formula (4),

$X^{B1}$ and $X^{B2}$ each independently represent a hydrogen atom or a monovalent organic group having no fluorine atom. It

is preferable that $X^{B1}$ and $X^{B2}$ are each the hydrogen atom.

$X^{B3}$ and $X^{B4}$ each independently represent a hydrogen atom or a monovalent organic group. It is preferable that at least one of $X^{B3}$ or $X^{B4}$ is a fluorine atom or a monovalent organic group having a fluorine atom, and it is more preferable that both $X^{B3}$ and $X^{B4}$ are fluorine atoms or monovalent organic groups having a fluorine atom. It is still more preferable that both $X^{B3}$ and $X^{B4}$ are fluorine-substituted alkyl groups.

L, q, and W are the same as in Formula (3).

As $Z^-$ in Formula (ZI), $Z^-$ in Formula (ZII), $Zc^-$ in Formula (ZI-3), and $Z^-$ in Formula (ZI-4), an anion represented by Formula (5) is preferable.

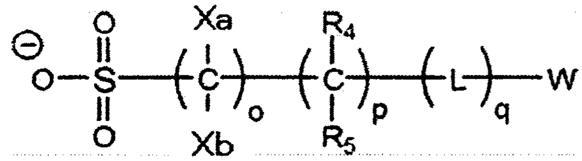

(5)

In Formula (5), Xa's each independently represent a fluorine atom or an alkyl group substituted with at least one fluorine atom. Xb's each independently represent a hydrogen atom or an organic group having no fluorine atom. The definitions and preferred aspects of o, p, q, $R_4$, $R_5$, L, and W are each the same as those in Formula (3).

$Z^-$ in Formula (ZI), $Z^-$ in Formula (ZII), $Zc^-$ in Formula (ZI-3), and $Z^-$ in Formula (ZI-4) may be a benzenesulfonate anion, and are each preferably a benzenesulfonate anion substituted with a branched alkyl group or a cycloalkyl group.

As $Z^-$ in Formula (ZI), $Z^-$ in Formula (ZII), $Zc^-$ in Formula (ZI-3), and $Z^-$ in Formula (ZI-4), an aromatic sulfonate anion represented by General Formula (SA1) is also preferable.

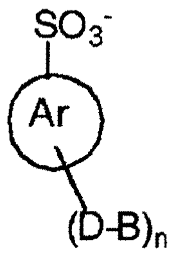

(SA1)

In Formula (SA1),

Ar represents an aryl group, and may further have a substituent other than a sulfonate anion and a -(D-B) group. Examples of the substituent which may be further contained include a fluorine atom and a hydroxyl group.

n represents an integer of 0 or more. n is preferably 1 to 4, more preferably 2 or 3, and still more preferably 3.

D represents a single bond or a divalent linking group. Examples of the divalent linking group include an ether group, a thioether group, a carbonyl group, a sulfoxide group, a sulfone group, a sulfonic ester group, an ester group, and a group consisting of a combination of two or more of these.

B represents a hydrocarbon group.

It is preferable that D is the single bond and B is an aliphatic hydrocarbon structure. It is more preferable that B is an isopropyl group or a cyclohexyl group.

Preferred examples of the sulfonium cation in Formula (ZI) and the iodonium cation in Formula (ZII) are shown below.

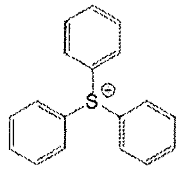
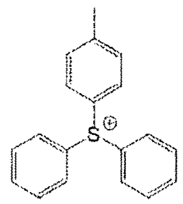
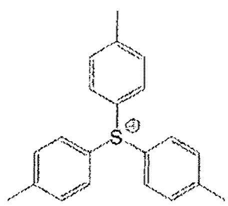
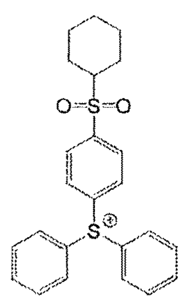

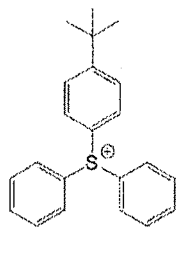 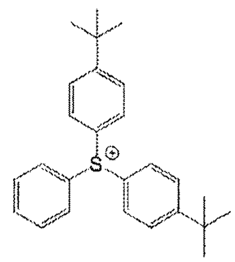 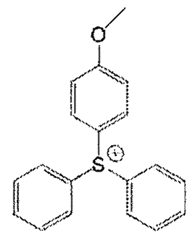 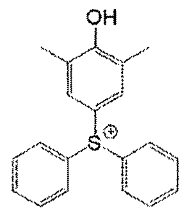

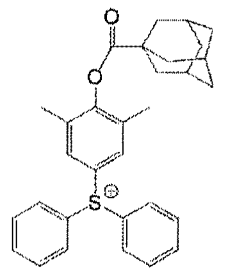 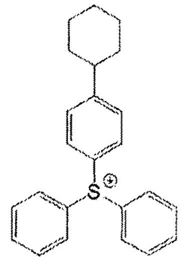 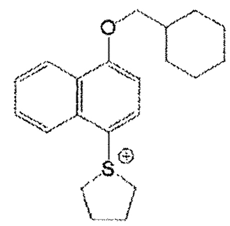 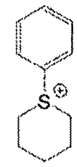

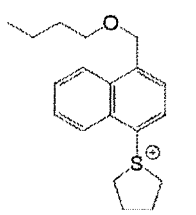 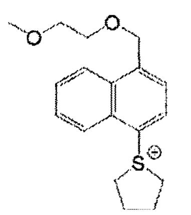 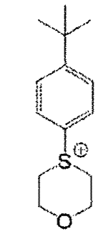 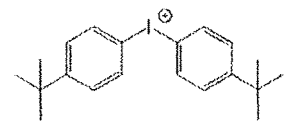

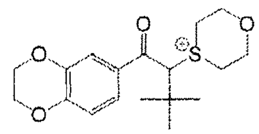 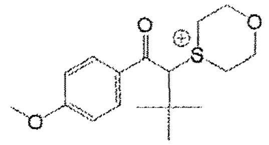 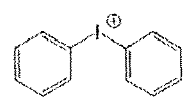

Preferred examples of the anion $Z^-$ in Formula (ZI), the anion $Z^-$ in Formula (ZII), $Zc^-$ in Formula (ZI-3), and $Z^-$ in Formula (ZI-4) are shown below.

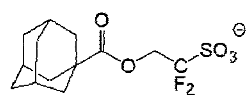 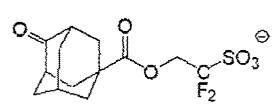 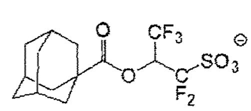

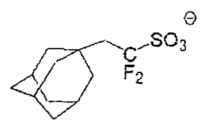 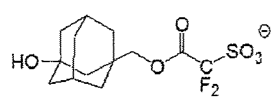 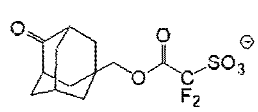

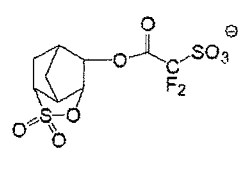 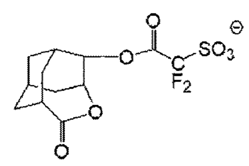 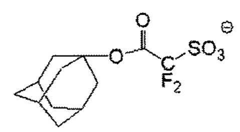

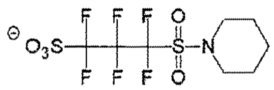

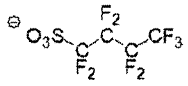

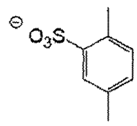

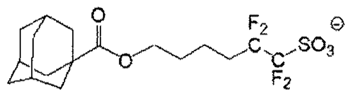

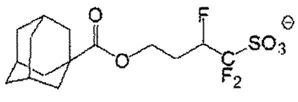

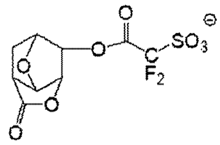

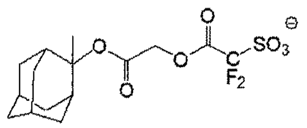

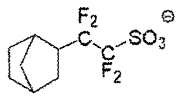

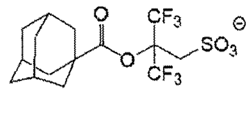

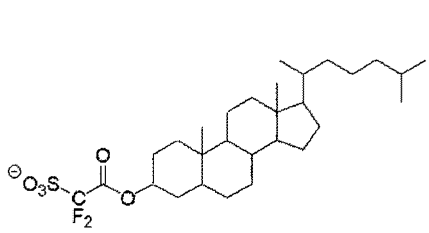

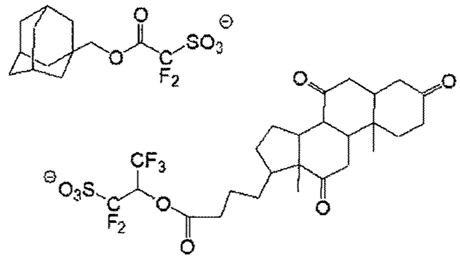

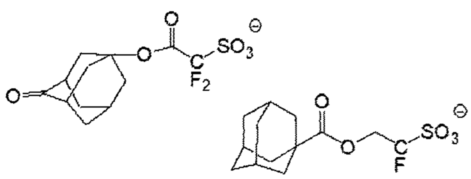

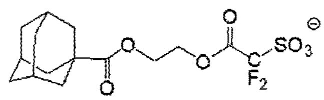

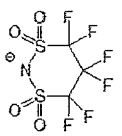

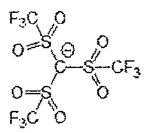

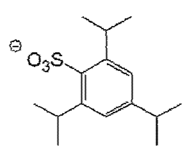

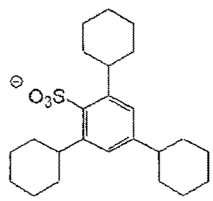

Any combination of the cations and the anions can be used as the photoacid generator.

Among those, the resist composition of the embodiment of the present invention preferably includes one or more photoacid generators selected from the group consisting of Formulae (P-1) to (P-14).

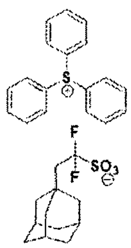

(P-1)

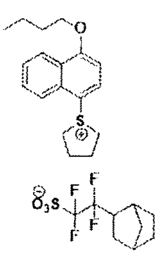

(P-2)

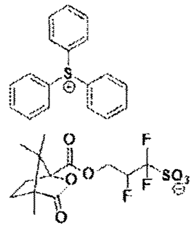

(P-3)

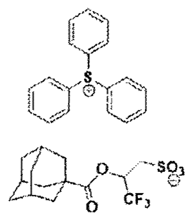

(P-4)

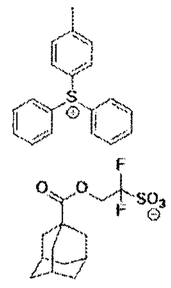
(P-5)

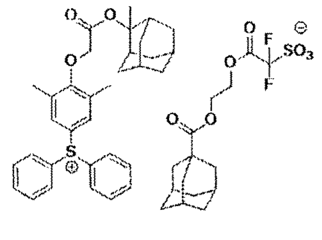
(P-6

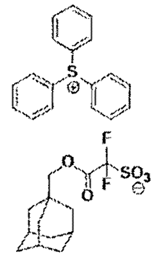
(P-7)

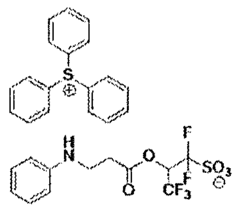
(P-8)

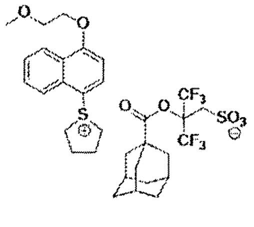
(P-9)

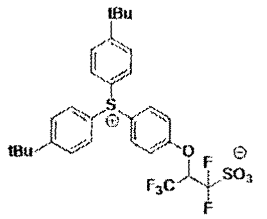
(P-10)

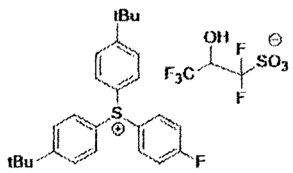
(P-11)

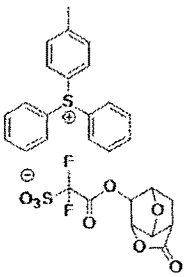
(P-12)

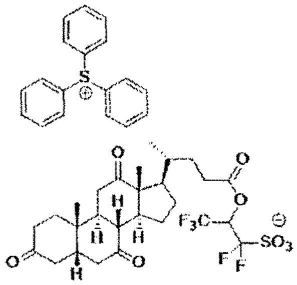
(P-13)

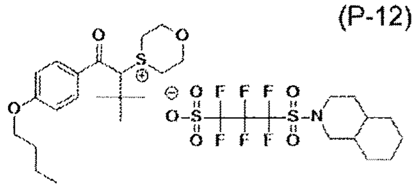
(P-14)

Other examples of the photoacid generator which can be included in the resist composition of the embodiment of the present invention are shown below. In addition, these may be used in combination.

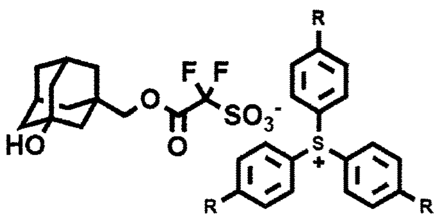
R=H or CH3

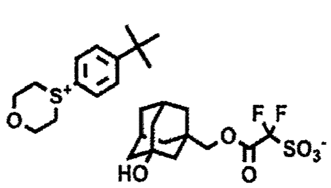

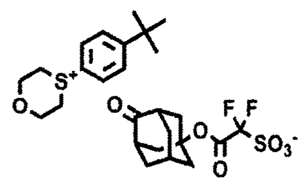

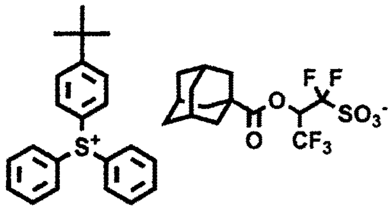 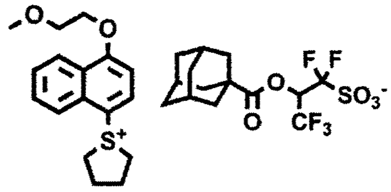

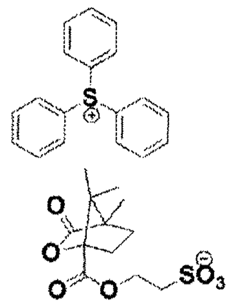

The photoacid generator may be in a form of a low-molecular-weight compound or a form incorporated into a part of a polymer.

As the photoacid generator, a photoacid generator in the form of a low-molecular-weight compound and a photoacid generator in the form incorporated into a part of a polymer may be used in combination.

The photoacid generator is preferably in the form of a low-molecular-weight compound.

In a case where the photoacid generator is in the form of a low-molecular-weight compound, the molecular weight is preferably 3,000 or less, more preferably 2,000 or less, and still more preferably 1,000 or less.

In a case where the photoacid generator is included in a part of a polymer, it may be included in a part of the above-mentioned Resin X or in a resin other than Resin X.

The photoacid generators may be used singly or in combination of two or more kinds thereof.

The content of the photoacid generator (in a case where the photoacid generators are present in a plurality of kinds, a total content thereof) in the composition is preferably 0.1% to 35.0% by mass, more preferably 0.5% to 25.0% by mass, and still more preferably 3.0% to 20.0% by mass with respect to a total solid content of the composition.

In a case where the compound represented by Formula (ZI-3) or (ZI-4) is included as the photoacid generator, the content of the photoacid generator included in the composition (in a case where the photoacid generators are present in a plurality of kinds, a total content thereof) is preferably 5.0% to 35.0% by mass, and more preferably 7.0% to 30.0% by mass with respect to the total solid content of the composition.

[Halogen-Based Solvent (C)]

The resist composition of the embodiment of the present invention includes a halogen-based solvent.

The halogen-based solvent may be any of a fluorine-based solvent, a chlorine-based solvent, a bromine-based solvent, and an iodine-based solvent, and among these, the chlorine-based solvent is preferable.

Examples of the chlorine-based solvent include methylene chloride, chloroform, dichloroethane, tetrachloromethane, and trichloroethane, and methylene chloride is preferable.

The halogen-based solvent may be added to a resist composition or may be unintentionally mixed in a resist composition in a process for producing the resist composition.

Examples of a case where a solvent is unintentionally mixed in a resist composition in a production process therefor include an aspect in which a raw material (for example, a photoacid generator) used for producing a resist composition includes a halogen-based solvent as an impurity. In particular, methylene chloride is used in a process for synthesizing a sulfonium salt-based photoacid generator in many cases, and therefore, methylene chloride may be included in a large amount as an impurity in a photoacid generator obtained. Therefore, it is preferable that the sulfonium salt-based photoacid generator is mixed with other raw materials constituting the resist composition after adjusting the content of the halogen-based solvent to a predetermined amount by purification.

The content of the halogen-based solvent is from 1 ppb by mass to 50 ppm by mass with respect to the total mass of the composition. In a case where the content of the halogen-based solvent in the resist composition is 50 ppm by mass or less with respect to the total mass of the composition, a dimensional variation of the line width of a pattern thus formed hardly occurs even with the lapse of time after the preparation of the resist composition. On the other hand, in a case where the content of the halogen-based solvent in the resist composition is 1 ppb by mass or more with respect

to the total mass of the composition, the cross-sectional shape of a pattern formed with the resist composition has excellent rectangularity. The content of the halogen-based solvent is preferably from 1 ppb by mass to 10 ppm by mass, and more preferably from 1 ppb by mass to 1 ppm by mass with respect to the total mass of the composition.

The halogen-based solvent may be used singly or in combination of two or more kinds thereof.

In a case where the resist composition of the embodiment of the present invention includes two or more kinds of halogen-based solvents, the content of the halogen-based solvents is intended to be a total content of the two or more kinds of the halogen-based solvents.

The content of the halogen-based solvent is measured by the following method.

First, the solvent is evaporated from a predetermined amount of the resist composition and dried to obtain a dry solid. At this time, with regard to the solvent to be evaporated (hereinafter also referred to as a "volatile solvent"), only the halogenated solvent is isolated by further fractional distillation based on a boiling point, and a mass thereof (hereinafter referred to as a "mass A") is measured.

Next, the obtained dry solid is dissolved in electronic grade N-methylpyrrolidone (NMP) to prepare a measurement sample. Thereafter, the mass of the halogen-based solvent (hereinafter referred to as a "mass B") in the measurement sample is measured using GC System 7890B manufactured by Agilent Technologies, Inc.

The content (% by mass) of the halogen-based solvent with respect to the total mass of the resist composition is determined through conversion from a total amount (the mass A + the mass B) of the halogen-based solvent obtained by the respective measurements.

[Metal Atom (D]

The resist composition of the embodiment of the present invention preferably includes metal atoms.

The "metal atom" is intended to be Li, Na, Mg, Al, K, Ca, Sc, Ti, V, Cr, Mn, Fe, Co, Ni, Cu, Zn, Ga, Ge, As, Rb, Sr, Y, Zr, Nb, Mo, Ru, Rh, Pd, Ag, Cd, In, Sn, Sb, Cs, Ba, Hf, Ta, W, Re, Os, Ir, Pt, Au, Hg, Tl, Pb, and Bi.

These metal atoms are metal atoms which can be included in the resist composition in an ordinary operation.

The form of the metal atom to be contained in the resist composition is not limited. That is, in the resist composition, the metal atom may be included in any of an ionic state, a simple substance state, and a compound (for example, a salt) state.

The metal atoms may be added to a resist composition or may be unintentionally mixed in the resist composition in a step of producing the resist composition.

Examples of a case where a solvent is unintentionally mixed in a resist composition in a production process therefor include an aspect in which a raw material (for example, a resin and an organic solvent) used for producing a resist composition includes a metal atom as an impurity and a form in which a metal atom is incorporated into the composition through a metal pipe or the like during a step of producing the composition.

The content of the metal atoms in the resist composition can be adjusted by, for example, a method of mixing various components constituting the resist composition and then purifying the mixed liquid.

The content of the metal atoms is preferably from 1 ppt by mass to 30 ppb by mass with respect to the total mass of the composition from the viewpoint that a pattern thus formed has excellent etching resistance and defects are hardly generated in a substrate etched using the pattern as a mask. In a case where the content of the metal atoms is 1 ppt by mass or more with respect to the total mass of the composition, the etching resistance of a pattern thus formed is high, and as a result, the cross-sectional shape of the substrate after etching is excellent. On the other hand, in a case where the content of the metal atoms is 30 ppb by mass or less with respect to the total mass of the composition, defects are hardly generated in the substrate after etching.

The content of the metal atoms is more preferably from 1 ppt by mass to 10 ppb by mass, more preferably from 1 ppt by mass to 1,000 ppt by mass, and particularly preferably from 1 ppt by mass to 500 ppt by mass with respect to the total mass of the composition.

The metal atoms may be used singly or in combination of two or more kinds thereof.

Furthermore, in a case where the resist composition of the embodiment of the present invention includes two or more kinds of metal atoms, the content of the metal atoms is intended to be a total content of the two or more kinds of metal atoms.

The content of the metal atoms can be measured using, for example, inductively coupled plasma mass spectrometry (ICP-MS).

[Solvent (E)]

The resist composition may include a solvent. Further, the solvent as mentioned herein is intended to be a solvent other than a halogen-based solvent.

In a case where the resist composition is an actinic ray-sensitive or radiation-sensitive resin composition for

EUV, it is preferable that the solvent includes at least one solvent of (M1) propylene glycol monoalkyl ether carboxylate or (M2) at least one selected from the group consisting of a propylene glycol monoalkyl ether, a lactic ester, an acetic ester, an alkoxypropionic ester, a chain ketone, a cyclic ketone, a lactone, and an alkylene carbonate as the solvent. Further, this solvent may further include components other than the components (M1) and (M2).

The present inventors have found that by using such a solvent and the above-mentioned resin (A) in combination, a pattern having a small number of development defects can be formed while improving the coating property of the composition. A reason therefor is not necessarily clear, but the present inventors have considered that since these solvents have a good balance among the solubility, the boiling point, and the viscosity of the resin (A), the unevenness of the film thickness of a composition film, the generation of precipitates during spin coating, and the like can be suppressed.

As the component (M1), at least one selected from the group consisting of propylene glycol monomethyl ether acetate (PGMEA), propylene glycol monomethyl ether propionate, and propylene glycol monoethyl ether acetate is preferable, and propylene glycol monomethyl ether acetate (PGMEA) is more preferable.

As the component (M2), the following ones are preferable.

As the propylene glycol monoalkyl ether, propylene glycol monomethyl ether (PGME) or propylene glycol monoethyl ether is preferable.

As the lactic ester, ethyl lactate, butyl lactate, or propyl lactate is preferable.

As the acetic ester, methyl acetate, ethyl acetate, butyl acetate, isobutyl acetate, propyl acetate, isoamyl acetate, methyl formate, ethyl formate, butyl formate, propyl formate, or 3-methoxybutyl acetate is preferable.

In addition, butyl butyrate is also preferable.

As the alkoxypropionic ester, methyl 3-methoxypropionate (MMP) or ethyl 3-ethoxypropionate (EEP) is preferable.

As the chain ketone, 1-octanone, 2-octanone, 1-nonanone, 2-nonanone, acetone, 2-heptanone, 4-heptanone, 1-hexanone, 2-hexanone, diisobutyl ketone, phenyl acetone, methyl ethyl ketone, methyl isobutyl ketone, acetyl acetone, acetonyl acetone, ionone, diacetonyl alcohol, acetyl carbinol, acetophenone, methyl naphthyl ketone, or methyl amyl ketone is preferable.

As the cyclic ketone, methyl cyclohexanone, isophorone, or cyclohexanone is preferable.

As the lactone, γ-butyrolactone is preferable.

As the alkylene carbonate, propylene carbonate is preferable.

As the component (M2), propylene glycol monomethyl ether (PGME), ethyl lactate, ethyl 3-ethoxypropionate, methyl amyl ketone, cyclohexanone, butyl acetate, pentyl acetate, γ-butyrolactone, or propylene carbonate is more preferable.

In addition to the components, it is preferable to use an ester-based solvent having 7 or more carbon atoms (preferably 7 to 14 carbon atoms, more preferably 7 to 12 carbon atoms, and still more preferably 7 to 10 carbon atoms) and 2 or less heteroatoms.

As the ester-based solvent having 7 or more carbon atoms and 2 or less heteroatoms, amyl acetate, 2-methylbutyl acetate, 1-methylbutyl acetate, hexyl acetate, pentyl propionate, hexyl propionate, butyl propionate, isobutyl isobutyrate, heptyl propionate, or butyl butanoate is preferable, and isoamyl acetate is more preferable.

As the component (M2), a component having a flash point (hereinafter also referred to as fp) of 37°C or higher is preferably used. As such a component (M2), propylene glycol monomethyl ether (fp: 47°C), ethyl lactate (fp: 53°C), ethyl 3-ethoxypropionate (fp: 49°C), methyl amyl ketone (fp: 42°C), cyclohexanone (fp: 44°C), pentyl acetate (fp: 45°C), methyl 2-hydroxyisobutyrate (fp: 45°C), γ-butyrolactone (fp: 101°C), or propylene carbonate (fp: 132°C) is preferable. Among those, propylene glycol monoethyl ether, ethyl lactate, pentyl acetate, or cyclohexanone is more preferable, and propylene glycol monoethyl ether or ethyl lactate is still more preferable.

In addition, the "flash point" herein means the value described in a reagent catalog of Tokyo Chemical Industry Co., Ltd. or Sigma-Aldrich Co. LLC.

It is preferable that the solvent includes the component (M1). It is more preferable that the solvent substantially consists of only the component (M1) or is a mixed solvent of the component (M1) and other components. In the latter case, it is still more preferable that the solvent includes both the component (M1) and the component (M2).

The mass ratio (M1/M2) of the content of the component (M1) to the component (M2) is preferably in the range of "100/0" to "15/85", more preferably in the range of "100/0" to "40/60", and still more preferably in the range of "100/0" to "60/40". That is, the solvent includes only the component (M1) or includes both of the component (M1) and the component (M2), and a mass ratio thereof is preferably as follows. That is, in the latter case, the mass ratio of the component (M1) to the component (M2) is preferably 15/85 or more, more preferably 40/60 or more, and still more preferably 60/40 or more. In a case where such a configuration is adopted and used, it is possible to further reduce the number of development defects.

Moreover, in a case where the solvent includes both the component (M1) and the component (M2), the mass ratio of the component (M1) to the component (M2) is, for example, 99/1 or less.

As described above, the solvent may further include components other than the components (M1) and (M2). In this case, the content of the components other than the components (M1) and (M2) is preferably in the range of 5% to 30% by mass with respect to the total mass of the solvent.

In a case where the resist composition is an actinic ray-sensitive or radiation-sensitive resin composition for ArF, examples of the solvent include organic solvents such as alkylene glycol monoalkyl ether carboxylate, alkylene glycol monoalkyl ether, alkyl lactate ester, alkyl alkoxypropionate, a cyclic lactone (preferably having 4 to 10 carbon atoms), a monoketone compound (preferably having 4 to 10 carbon atoms) which may contain a ring, alkylene carbonate, alkyl alkoxyacetate, and alkyl pyruvate.

As the alkylene glycol monoalkyl ether carboxylate, propylene glycol monomethyl ether acetate, propylene glycol monoethyl ether acetate, propylene glycol monopropyl ether acetate, propylene glycol monobutyl ether acetate, propylene glycol monomethyl ether propionate, propylene glycol monoethyl ether propionate, ethylene glycol monomethyl ether acetate, or ethylene glycol monoethyl ether acetate is preferable.

As the alkylene glycol monoalkyl ether, for example, propylene glycol monomethyl ether, propylene glycol monoethyl ether, propylene glycol monopropyl ether, propylene glycol monobutyl ether, ethylene glycol monomethyl ether or ethylene glycol monoethyl ether is preferable.

As the alkyl lactate ester, methyl lactate, ethyl lactate, propyl lactate, or butyl lactate is preferable.

As the alkyl alkoxypropionate, ethyl 3-ethoxypropionate, methyl 3-methoxypropionate, methyl 3-ethoxypropionate, or ethyl 3-methoxypropionate is preferable.

As the cyclic lactones, β-propiolactone, β-butyrolactone, γ-butyrolactone, α-methyl-γ-butyrolactone, β-methyl-γ-butyrolactone, γ-valerolactone, γ-caprolactone, γ-octanoic lactone, or α-hydroxy-γ-butyrolactone is preferable.

As the monoketone compound which may contain a ring, 2-butanone, 3-methylbutanone, pinacolone, 2-pentanone, 3-pentanone, 3-methyl-2-pentanone, 4-methyl-2-pentanone, 2-methyl-3-pentanone, 4,4-dimethyl-2-pentanone, 2,4-dimethyl-3-pentanone, 2,2,4,4-tetramethyl-3-pentanone, 2-hexanone, 3-hexanone, 5-methyl-3-hexanone, 2-heptanone, 3-heptanone, 4-heptanone, 2-methyl-3-heptanone, 5-methyl-3-heptanone, 2,6-dimethyl-4-heptanone, 2-octanone, 3-octanone, 2-nonanone, 3-nonanone, 5-nonanone, 2-decanone, 3-decanone, 4-decanone, 5-hexen-2-one, 3-penten-2-one, cyclopentanone, 2-methylcyclopentanone, 3-methylcyclopentanone, 2,2-dimethylcyclopentanone, 2,4,4-trimethylcyclopentanone, cyclohexanone, 3 -methylcyclohexanone, 4-methylcyclohexanone, 4-ethylcyclohexanone, 2,2-dimethylcyclohexanone, 2,6-dimethylcyclohexanone, 2,2,6-trimethylcyclohexanone, cycloheptanone, 2-methylcycloheptanone, or 3-methylcycloheptanone is preferable.

As the alkylene carbonate, propylene carbonate, vinylene carbonate, ethylene carbonate, or butylene carbonate is preferable.

As the alkyl alkoxyacetate, for example, 2-methoxyethyl acetate, 2-ethoxyethyl acetate, 2-(2-ethoxyethoxy)ethyl acetate, 3-methoxy-3-methylbutyl acetate, or 1-methoxy-2-propyl acetate is preferable.

As the alkyl pyruvate, methyl pyruvate, ethyl pyruvate, or propyl pyruvate is preferable.

As the solvent, a solvent having a boiling point of 130°C or higher at a normal temperature under a normal pressure is preferable. Specific examples of the solvent include cyclopentanone, γ-butyrolactone, cyclohexanone, ethyl lactate, ethylene glycol monoethyl ether acetate, propylene glycol monomethyl ether acetate, 3-ethyl ethoxypropionate, ethyl pyruvate, 2-ethoxyethyl acetate, 2-(2-ethoxyethoxy)ethyl acetate, and propylene carbonate.

In the present invention, the solvents may be used singly or in combination of two or more kinds thereof.

As the solvent, a mixed solvent obtained by mixing a solvent containing a hydroxyl group in the structure as an organic solvent and a solvent containing no hydroxyl group may be used.

As the solvent containing a hydroxyl group and the solvent containing no hydroxyl group, the above-mentioned exemplary compounds can be appropriately selected, but as the solvent containing a hydroxyl group, alkylene glycol monoalkyl ether or alkyl lactate is preferable, and propylene glycol monomethyl ether or ethyl lactate is more preferable.

In addition, as the solvent containing no hydroxyl group, alkylene glycol monoalkyl ether acetate, alkyl alkoxypropionate, a monoketone compound which may contain a ring, a cyclic lactone, or alkyl acetate is preferable, and propylene glycol monomethyl ether acetate, ethyl ethoxypropionate, 2-heptanone, γ-butyrolactone, cyclohexanone, or butyl acetate is more preferable, and propylene glycol monomethyl ether acetate, ethyl ethoxypropionate, or 2-heptanone are still more preferable.

A mixing ratio (mass) of the solvent containing a hydroxyl group to the solvent containing no hydroxyl group is preferably 1/99 to 99/1, more preferably 10/90 to 90/10, and still more preferably 20/80 to 60/40.

A mixed solvent containing 50% by mass or more of the solvent containing no hydroxyl group is particularly preferable from the viewpoint of coating evenness.

As the solvent, a mixed solvent of two or more kinds of solvents including propylene glycol monomethyl ether acetate is preferable.

The content of the solvent in the resist composition is preferably set so that the concentration of solid content is 0.5% to 30% by mass, and more preferably set so that the concentration of solid content is 1% to 20% by mass. This makes the coating property of the resist composition further improved.

[Acid Diffusion Control Agent (F)]

The resist composition may include an acid diffusion control agent.

The acid diffusion control agent acts as a quencher that suppresses a reaction of the acid-decomposable resin in the unexposed area by excessive generated acids by trapping the acids generated from a photoacid generator and the like upon exposure. For example, a basic compound (DA), a basic compound (DB) having basicity reduced or lost upon irradiation with actinic rays or radiation, an onium salt (DC) which is a weak acid relative to an acid generator, a low-molecular-weight compound (DD) having a nitrogen atom, and a group that leaves by the action of an acid, an onium salt compound (DE) having a nitrogen atom in the cationic moiety, can be used as the acid diffusion control agent. In the resist composition, a known acid diffusion control agent can be appropriately used. For example, the known compounds disclosed in paragraphs [0627] to [0664] of the specification of US2016/0070167A1, paragraphs [0095] to [0187] of the specification of US2015/0004544A1, paragraphs [0403] to [0423] of the specification of US2016/0237190A1, and paragraphs [0259] to [0328] of the specification of US2016/0274458A1 can be suitably used as the acid diffusion control agent.

As the basic compound (DA), compounds having structures represented by Formulae (A) to (E) are preferable.

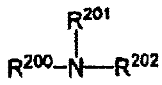
(A)

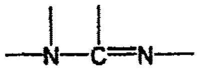
(B)

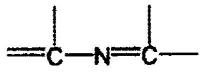
(C)

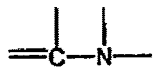
(D)

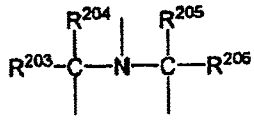
(E)

In General Formulae (A) and (E),
$R^{200}$, $R^{201}$, and $R^{202}$ may be the same as or different from each other, and each independently represent a hydrogen atom, an alkyl group (preferably having 1 to 20 carbon atoms), a cycloalkyl group (preferably having 3 to 20 carbon atoms), or an aryl group (having 6 to 20 carbon atoms). $R^{201}$ and $R^{202}$ may be bonded to each other to form a ring.

$R^{203}$, $R^{204}$, $R^{205}$, and $R^{206}$ may be the same as or different from each other and each independently represent an alkyl group having 1 to 20 carbon atoms.

The alkyl group in each of General Formulae (A) and (E) may have a substituent or may be unsubstituted.

With regard to the alkyl group, the alkyl group having a substituent is preferably an aminoalkyl group having 1 to 20 carbon atoms, a hydroxyalkyl group having 1 to 20 carbon atoms, or a cyanoalkyl group having 1 to 20 carbon atoms.

The alkyl group in each of General Formulae (A) and (E) are more preferably unsubstituted.

As the basic compound (DA), guanidine, aminopyrrolidine, pyrazole, pyrazoline, piperazine, aminomorpholine, aminoalkylmorpholine, or piperidine is preferable; and a compound having an imidazole structure, a diazabicyclo structure, an onium hydroxide structure, an onium carboxylate structure, a trialkylamine structure, an aniline structure, or a pyridine structure, an alkylamine derivative having a hydroxyl group and/or an ether bond, or an aniline derivative having a hydroxyl group and/or an ether bond is more preferable.

The basic compound (DB) having basicity reduced or lost upon irradiation with actinic rays or radiation (hereinafter also referred to as a "compound (DB)") is a compound which has a proton-accepting functional group, and decomposes under irradiation with actinic rays or radiation to exhibit deterioration in proton-accepting properties, no proton-accepting properties, or a change from the proton-accepting properties to acidic properties.

The proton-accepting functional group refers to a functional group having a group or an electron which is capable of electrostatically interacting with a proton, and for example, means a functional group with a macrocyclic structure, such as a cyclic polyether, or a functional group having a nitrogen atom having an unshared electron pair not contributing to $\pi$-conjugation. The nitrogen atom having an unshared electron pair not contributing to $\pi$-conjugation is, for example, a nitrogen atom having a partial structure represented by the following formula.

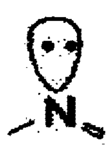

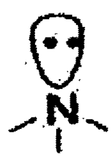

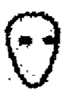 Unshared electron pair

Preferred examples of the partial structure of the proton-accepting functional group include a crown ether structure, an azacrown ether structure, primary to tertiary amine structures, a pyridine structure, an imidazole structure, and a pyrazine structure.

The compound (DB) decomposes upon irradiation with actinic rays or radiation to generate a compound exhibiting deterioration in proton-accepting properties, no proton-accepting properties, or a change from the proton-accepting properties to acidic properties. Here, exhibiting deterioration in proton-accepting properties, no proton-accepting properties, or a change from the proton-accepting properties to acidic properties means a change of proton-accepting properties due to the proton being added to the proton-accepting functional group, and specifically a decrease in the equilibrium constant at chemical equilibrium in a case where a proton adduct is generated from the compound (DB) having the proton-accepting functional group and the proton.

The proton-accepting properties can be confirmed by performing pH measurement.

The acid dissociation constant pKa of the compound generated by decomposition of the compound (DB) upon irradiation with actinic rays or radiation preferably satisfies pKa < -1, and more preferably satisfies -13 < pKa < -1, and still more preferably satisfies 13 < pKa < -3.

Furthermore, the acid dissociation constant pKa can be determined by the above-mentioned method.

In the composition of the embodiment of the present invention, the onium salt (DC) which is a weak acid relative to a photoacid generator can be used as the acid diffusion control agent.

In a case where the photoacid generator and the onium salt that generates an acid which is a weak acid relative to an acid generated from the photoacid generator are mixed and used, an acid generated from the photoacid generator upon irradiation with actinic rays or radiation produces an onium salt having a strong acid anion by discharging the weak acid through salt exchange in a case where the acid collides with an onium salt having an unreacted weak acid anion. In this process, the strong acid is exchanged with a weak acid having a lower catalytic ability, and thus, the acid is apparently deactivated and the acid diffusion can be controlled.

As the onium salt which is a weak acid relative to the photoacid generator, compounds represented by General Formulae (d1-1) to (d1-3) are preferable.

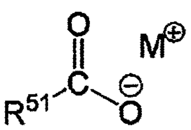
(d1-1)

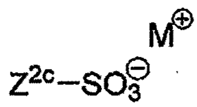
(d1-2)

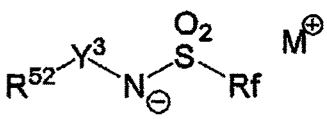
(d1-3)

In the formula, $R^{51}$ is a hydrocarbon group which may have a substituent, $Z^{2c}$ is a hydrocarbon group having 1 to 30 carbon atoms, which may have a substituent (provided that carbon adjacent to S is not substituted with a fluorine atom), $R^{52}$ is an organic group, $Y^3$ is a linear, branched or cyclic alkylene group or an arylene group, Rf is a hydrocarbon group including a fluorine atom, and $M^+$'s are each independently an ammonium cation, a sulfonium cation, or an iodonium cation.

Preferred examples of the sulfonium cation or iodonium cation represented by $M^+$ include the sulfonium cation exemplified for General Formula (ZI) and the iodonium cation exemplified for General Formula (ZII), each described above.

The onium salt (DC) which is a weak acid relative to a photoacid generator may be a compound having a cationic moiety and an anionic moiety in the same molecule, in which the cationic moiety and the anionic moiety are linked by a covalent bond (hereinafter also referred to as a "compound (DCA)").

As the compound (DCA), a compound represented by any of General Formulae (C-1) to (C-3) is preferable.

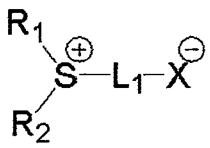
(C-1)

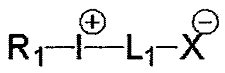
(C-2)

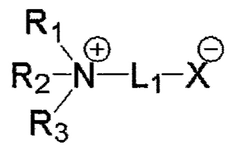
(C-3)

In General Formulae (C-1) to (C-3),

$R_1$, $R_2$, and $R_3$ each independently represent a substituent having 1 or more carbon atoms.

$L_1$ represents a divalent linking group that links a cationic moiety with an anionic moiety, or a single bond.

$-X^-$ represents an anionic moiety selected from $-COO^-$, $-SO_3^-$, $-SO_2^-$, and $-N^--R_4$. $R_4$ represents at least one of a monovalent substituent having a carbonyl group: -C(=O)-, a sulfonyl group: $-S(=O)_2-$, or a sulfinyl group: -S(=O)- at a site for linking to an adjacent N atom.

$R_1$, $R_2$, $R_3$, $R_4$, and $L_1$ may be bonded to each other to form a ring structure. In addition, in General Formula (C-3), two of Ri to $R_3$ together represent one divalent substituent, and may be bonded to an N atom by a double bond.

Examples of the substituent having 1 or more carbon atoms in each of $R_1$ to $R_3$ include an alkyl group, a cycloalkyl group, an aryl group, an alkyloxycarbonyl group, a cycloalkyloxycarbonyl group, an aryloxycarbonyl group, an alkylaminocarbonyl group, a cycloalkylaminocarbonyl group, and an arylaminocarbonyl group. Among those, the alkyl group, a cycloalkyl group, or the aryl group is preferable.

Examples of $L_1$ as the divalent linking group include a linear or branched alkylene group, a cycloalkylene group, an arylene group, a carbonyl group, an ether bond, an ester bond, an amide bond, an urethane bond, an urea bond, and a group formed by combination of two or more of these groups. $L_1$ is preferably the alkylene group, the arylene group, the ether bond, the ester bond, and the group formed by a combination of two or more of these groups.

The low-molecular-weight compound (DD) having a nitrogen atom and having a group that leaves by the action of an acid (hereinafter also referred to as a "compound (DD)") is preferably an amine derivative having a group that leaves by the action of an acid on the nitrogen atom.

As the group that leaves by the action of an acid, an acetal group, a carbonate group, a carbamate group, a tertiary ester group, a tertiary hydroxyl group, or a hemiaminal ether group is preferable, and the carbamate group or the hemiaminal ether group is more preferable.

The molecular weight of the compound (DD) is preferably 100 to 1,000, more preferably 100 to 700, and still more preferably 100 to 500.

The compound (DD) may have a carbamate group having a protective group on the nitrogen atom. The protective group constituting the carbamate group is represented by General Formula (d-1).

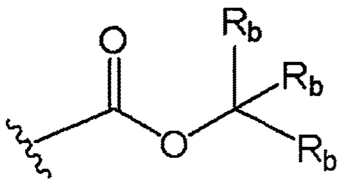

(d-1)

In General Formula (d-1),

$R_b$'s each independently represent a hydrogen atom, an alkyl group (preferably having 1 to 10 carbon atoms), a cycloalkyl group (preferably having 3 to 30 carbon atoms), an aryl group (preferably having 3 to 30 carbon atoms), an aralkyl group (preferably having 1 to 10 carbon atoms), or an alkoxyalkyl group (preferably having 1 to 10 carbon atoms). $R_b$'s may be linked to each other to form a ring.

The alkyl group, the cycloalkyl group, the aryl group, or the aralkyl group represented by $R_b$ may be each independently substituted with a functional group such as a hydroxyl group, a cyano group, an amino group, a pyrrolidino group, a piperidino group, a morpholino group, and an oxo group, an alkoxy group, or a halogen atom. The same applies to the alkoxyalkyl group represented by $R_b$.

As $R_b$, a linear or branched alkyl group, a cycloalkyl group, or an aryl group is preferable, and the linear or branched alkyl group, or the cycloalkyl group is more preferable.

Examples of the ring formed by the mutual linking of two $R_b$'s include an alicyclic hydrocarbon, an aromatic hydrocarbon, a heterocyclic hydrocarbon, and derivatives thereof.

Examples of the specific structure of the group represented by General Formula (d-1) include, but are not limited to, the structures disclosed in paragraph [0466] of the specification of US2012/0135348A1.

The compound (DD) is preferably a compound represented by General Formula (6).

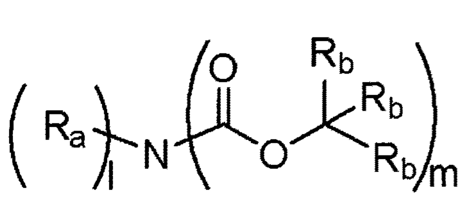

(6)

In General Formula (6),

1 represents an integer of 0 to 2, m represents an integer of 1 to 3, and these satisfy 1 + m = 3.

$R_a$ represents a hydrogen atom, an alkyl group, a cycloalkyl group, an aryl group, or an aralkyl group. In a case where 1 is 2, two $R_a$'s may be the same as or different from each other, and the two $R_a$'s may be linked to each other to form a heterocycle with the nitrogen atom in the formula. This heterocycle may include a heteroatom other than the nitrogen atom in the formula.

Rb has the same definition as Rb in General Formula (d-1), and preferred examples are also the same.

In General Formula (6), the alkyl group, the cycloalkyl group, the aryl group, and the aralkyl group as $R_a$ may

be each independently substituted with the same groups as the group mentioned above as a group which may be substituted in the alkyl group, the cycloalkyl group, the aryl group, and the aralkyl group as $R_b$.

Specific examples of the alkyl group, the cycloalkyl group, the aryl group, and the aralkyl group (these groups may be substituted with the groups as described above) of $R_a$ include the same groups as the specific examples as described above with respect to $R_b$.

Specific examples of the particularly preferred compound (DD) in the present invention include, but are not limited to, the compounds disclosed in paragraph [0475] of the specification of US2012/0135348A1.

The onium salt compound (DE) having a nitrogen atom in the cationic moiety (hereinafter also referred to as a "compound (DE)") is preferably a compound having a basic moiety including a nitrogen atom in the cationic moiety. The basic moiety is preferably an amino group, and more preferably an aliphatic amino group. All of the atoms adjacent to the nitrogen atom in the basic moiety are still more preferably hydrogen atoms or carbon atoms. In addition, from the viewpoint of improving basicity, it is preferable that an electron-withdrawing functional group (such as a carbonyl group, a sulfonyl group, a cyano group, and a halogen atom) is not directly linked to the nitrogen atom.

Preferred specific examples of the compound (DE) include, but are not limited to, the compounds disclosed in paragraph [0203] of US2015/0309408A1.

Preferred examples of the acid diffusion control agent are shown below.

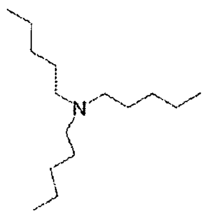
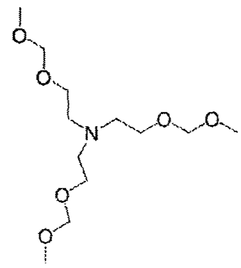

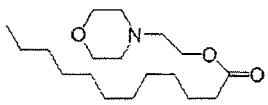
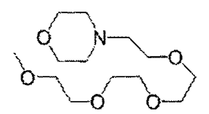

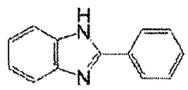
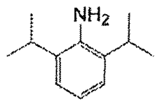
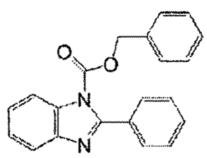

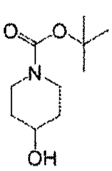
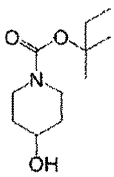
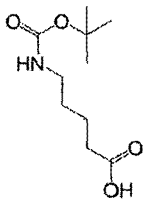
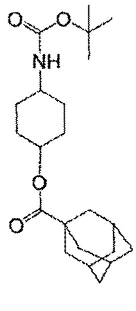

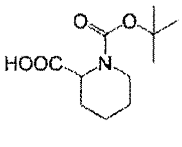
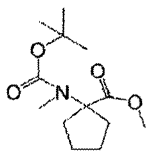

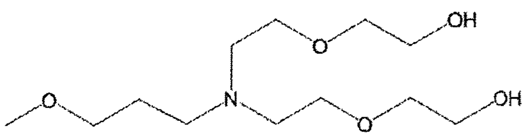

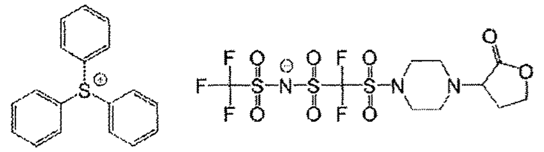

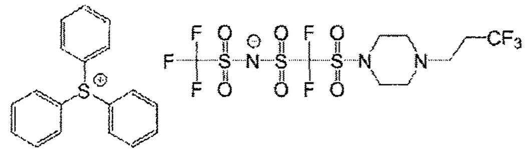

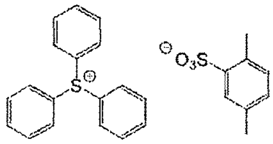
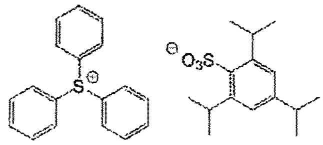
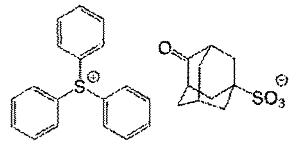

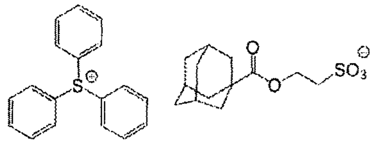
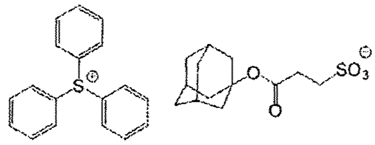
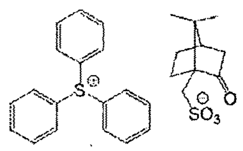

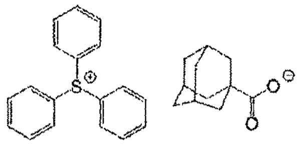
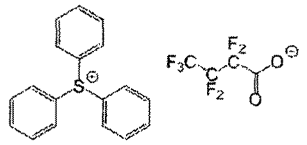
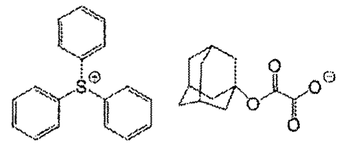

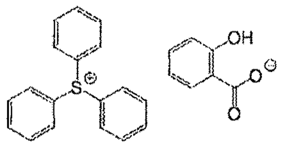
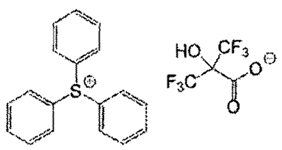
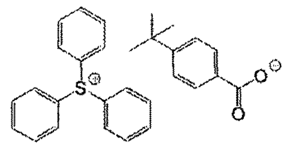

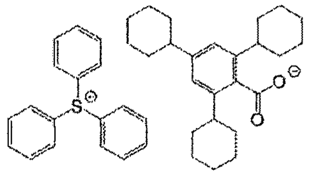
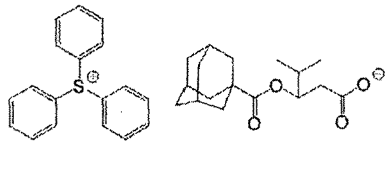

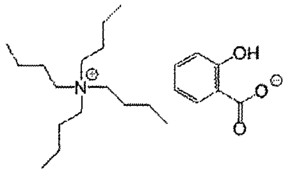
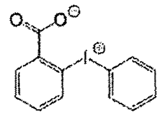

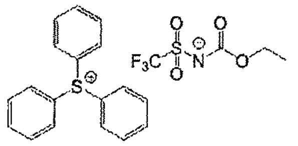

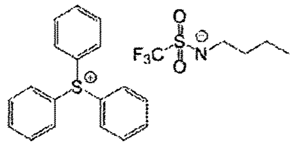

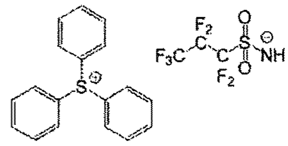

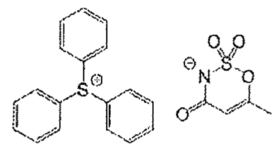

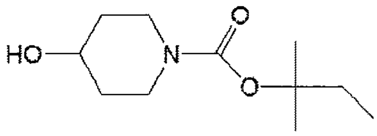

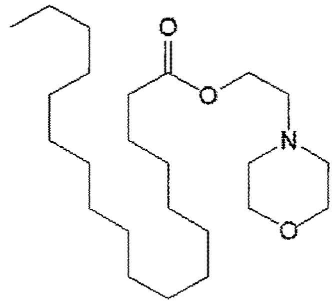

In a case where the resist composition includes an acid diffusion control agent, the content of the acid diffusion control agent (in a case where a plurality of kinds of the acid diffusion control agents are present, a total content thereof) is preferably 0.1% to 11.0% by mass, more preferably 0.1% to 10.0% by mass, still more preferably 0.1% to 8.0% by mass, and particularly preferably 0.1% to 5.0% by mass with respect to the total solid content of the composition.

In the resist composition, the acid diffusion control agents may be used singly or in combination of two or more kinds thereof.

[Hydrophobic Resin (G)]

The resist composition may include a hydrophobic resin different from the resin (A), in addition to the resin (A).

Although it is preferable that the hydrophobic resin is designed to be unevenly distributed on a surface of the resist film, it does not necessarily need to have a hydrophilic group in the molecule as different from the surfactant, and does not need to contribute to uniform mixing of polar materials and non-polar materials.

Examples of the effect of addition of the hydrophobic resin include a control of static and dynamic contact angles of a surface of the resist film with respect to water and suppression of out gas.

The hydrophobic resin preferably has any one or more of a "fluorine atom", a "silicon atom", and a "$CH_3$ partial structure which is contained in a side chain moiety of a resin" from the viewpoint of uneven distribution on the film surface layer, and more preferably has two or more kinds. Incidentally, the hydrophobic resin preferably has a hydrocarbon group having 5 or more carbon atoms. These groups may be contained in the main chain of the resin or may be substituted in a side chain.

In a case where hydrophobic resin includes a fluorine atom and/or a silicon atom, the fluorine atom and/or the silicon atom in the hydrophobic resin may be included in the main chain or a side chain of the resin.

In a case where the hydrophobic resin includes a fluorine atom, as a partial structure having a fluorine atom, an alkyl group having a fluorine atom, a cycloalkyl group having a fluorine atom, or an aryl group having a fluorine atom is preferable.

The alkyl group having a fluorine atom (preferably having 1 to 10 carbon atoms, and more preferably having 1 to 4 carbon atoms) is a linear or branched alkyl group in which at least one hydrogen atom is substituted with a fluorine atom, and the alkyl group may further have a substituent other than the fluorine atom.

The cycloalkyl group having a fluorine atom is a monocyclic or polycyclic cycloalkyl group in which at least one hydrogen atom is substituted with a fluorine atom, and may further have a substituent other than a fluorine atom.

Examples of the aryl group having a fluorine atom include an aryl group such as a phenyl group and a naphthyl group, in which at least one hydrogen atom is substituted with a fluorine atom, and the aryl group may further have a substituent other than the fluorine atom.

Examples of the repeating unit having a fluorine atom or a silicon atom include those exemplified in paragraph

[0519] of US2012/0251948A1.

Furthermore, as described above, it is also preferable that the hydrophobic resin includes a $CH_3$ partial structure in a side chain moiety.

Here, the $CH_3$ partial structure contained in the side chain moiety in the hydrophobic resin includes a $CH_3$ partial structure contained in an ethyl group, a propyl group, and the like.

On the other hand, a methyl group bonded directly to the main chain of the hydrophobic resin (for example, an $\alpha$-methyl group in the repeating unit having a methacrylic acid structure) makes only a small contribution of uneven distribution on the surface of the hydrophobic resin due to the effect of the main chain, and it is therefore not included in the $CH_3$ partial structure in the present invention.

With regard to the hydrophobic resin, reference can be made to the description in paragraphs [0348] to [0415] of JP2014-010245A, the contents of which are incorporated herein by reference.

Furthermore, the resins described in JP2011-248019A, JP2010-175859A, and JP2012-032544A, in addition to those above, can also be preferably used as the hydrophobic resin.

Preferred examples of a monomer corresponding to the repeating unit constituting the hydrophobic resin are shown below.

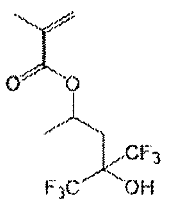
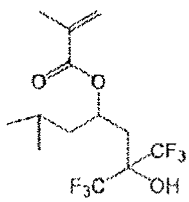
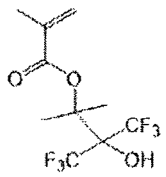

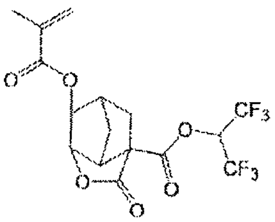
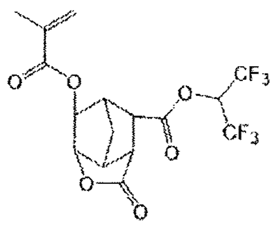
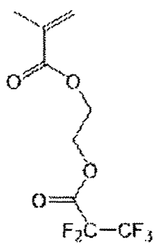

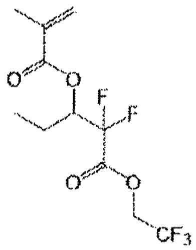
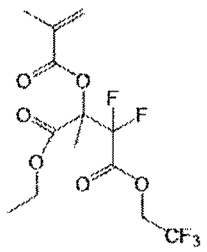
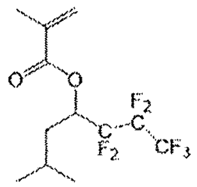
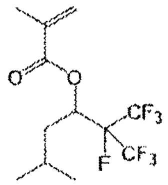

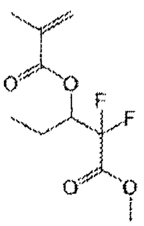
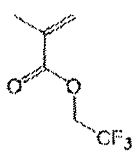
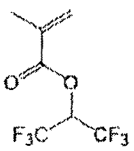
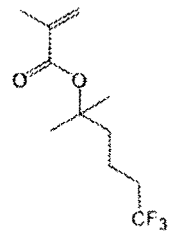

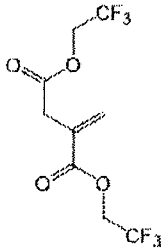
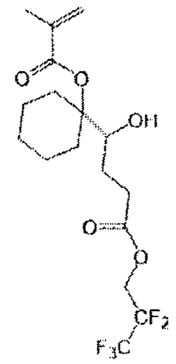
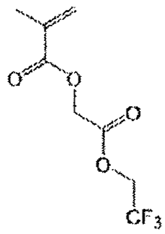
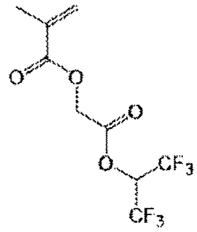

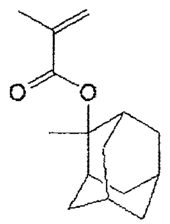
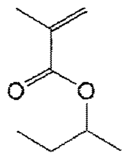
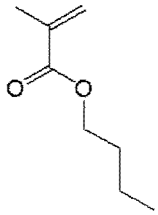
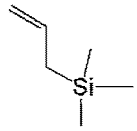

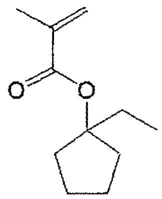
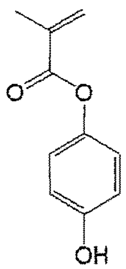
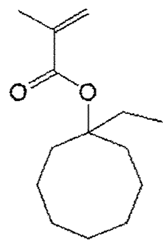
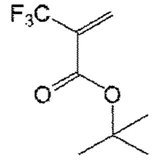

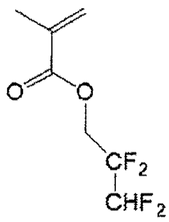
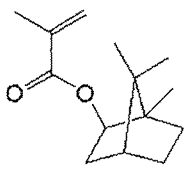
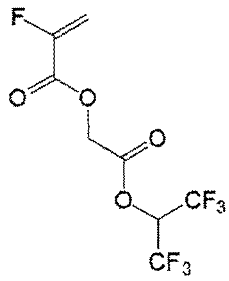

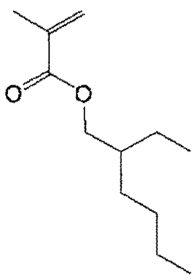
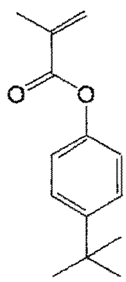
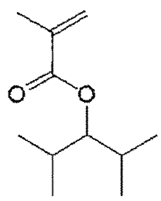

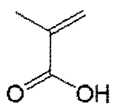
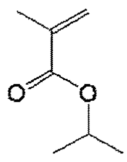
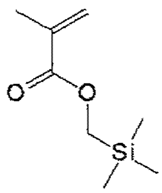

Specific examples of the hydrophobic resin that can be included in the composition of the embodiment of the present invention are shown below. In addition, in the following specific examples, the content of each repeating unit is not particularly limited as long as the content of the repeating unit is not described. * in the formulae represents a bonding position.

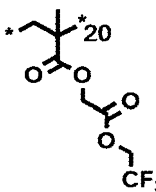
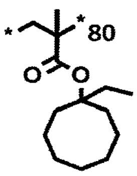
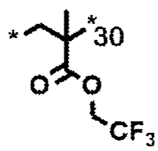
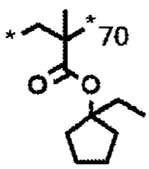

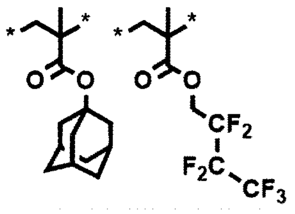
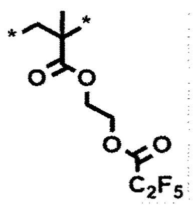
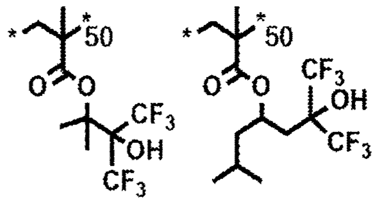

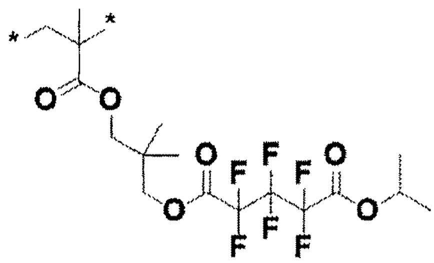

In a case where the resist composition includes a hydrophobic resin, the content of the hydrophobic resin is preferably 0.01% to 20% by mass, more preferably 0.1% to 15% by mass, still more preferably 0.1% to 10% by mass, and particularly preferably 0.1% to 6% by mass with respect to a total solid content of the composition.

[Surfactant (H)]

The resist composition may include a surfactant. By incorporation of the surfactant, it is possible to form a pattern having more excellent adhesiveness and fewer development defects.
As the surfactant, fluorine-based and/or silicon-based surfactants are preferable.
Examples of the fluorine-based and/or silicon-based surfactants include the surfactants described in paragraph [0276] of the specification of US2008/0248425A. In addition, EFTOP EF301 or EF303 (manufactured by Shin-Akita Chemical Co., Ltd.); FLUORAD FC430, 431, or 4430 (manufactured by Sumitomo 3M Inc.); MEGAFACE F171, F173, F176, F189, F113, F110, F177, F120, or R08 (manufactured by DIC Corporation); SURFLON S-382, SC101, 102, 103, 104, 105, or 106 (manufactured by Asahi Glass Co., Ltd.); TROYSOL S-366 (manufactured by Troy Chemical Corporation); GF-300 or GF-150 (manufactured by Toagosei Chemical Industry Co., Ltd.); SURFLON S-393 (manufactured by Seimi Chemical Co., Ltd.); EFTOP EF121, EF122A, EF122B, RF122C, EF125M, EF135M, EF351, EF352, EF801, EF802, or EF601 (manufactured by JEMCO Inc.); PF636, PF656, PF6320, or PF6520 (manufactured by OMNOVA Solutions Inc.); KH-20 (manufactured by Asahi Kasei Corporation); or FTX-204G, 208G, 218G, 230G, 204D, 208D, 212D, 218D, or 222D (manufactured by NEOS COMPANY LIMITED) may be used. In addition, a polysiloxane polymer,

KP-341 (manufactured by Shin-Etsu Chemical Co., Ltd.), can also be used as the silicon-based surfactant.

Moreover, in addition to the known surfactants as shown above, a surfactant may be synthesized using a fluoroaliphatic compound manufactured using a telomerization method (also referred to as a telomer method) or an oligomerization method (also referred to as an oligomer method). Specifically, a polymer including a fluoroaliphatic group derived from fluoroaliphatic compound may be used as the surfactant. This fluoroaliphatic compound can be synthesized, for example, by the method described in JP2002-090991A.

As the polymer having a fluoroaliphatic group, a copolymer of a monomer having a fluoroaliphatic group and (poly(oxyalkylene))acrylate and/or (poly(oxyalkylene))methacrylate is preferable, and the polymer may be unevenly distributed or block-copolymerized. Furthermore, examples of the poly(oxyalkylene) group include a poly(oxyethylene) group, a poly(oxypropylene) group, and a poly(oxybutylene) group, and the group may also be a unit such as those having alkylenes having different chain lengths within the same chain length such as poly(block-linked oxyethylene, oxypropylene, and oxyethylene) and poly(block-linked oxyethylene and oxypropylene). In addition, the copolymer of a monomer having a fluoroaliphatic group and (poly(oxyalkylene))acrylate (or methacrylate) is not limited only to a binary copolymer but may also be a ternary or higher copolymer obtained by simultaneously copolymerizing monomers having two or more different fluoroaliphatic groups or two or more different (poly(oxyalkylene)) acrylates (or methacrylates).

Examples of a commercially available surfactant thereof include MEGAFACE F-178, F-470, F-473, F-475, F-476, and F-472 (manufactured by DIC Corporation), a copolymer of acrylate (or methacrylate) having a $C_6F_{13}$ group and (poly(oxyalkylene))acrylate (or methacrylate), and a copolymer of acrylate (or methacrylate) having a $C_3F_7$ group, (poly(oxyethylene))acrylate (or methacrylate), and (poly(oxypropylene))acrylate (or methacrylate).

In addition, a surfactant other than the fluorine-based surfactant and/or the silicon-based surfactants described in paragraph [0280] of the specification of US2008/0248425A may be used.

These surfactants may be used singly or in combination of two or more kinds thereof.

The content of the surfactant is preferably 0.0001 to 2% by mass and more preferably 0.0005 to 1% by mass with respect to the total solid content of the resist composition.

[Carboxylic Acid Onium Salt (I)]

The resist composition may include a carboxylic acid onium salt.

The carboxylic acid onium salt is preferably an iodonium salt or a sulfonium salt. As the anionic moiety, a linear, branched, or cyclic (for example, monocyclic or polycyclic) alkyl carboxylate anion having 1 to 30 carbon atoms is preferable, and an alkyl carboxylate anion in which part or all of the alkyl groups are fluorine-substituted is more preferable.

An oxygen atom may be included in the alkyl group. This ensures the transparency to light at a wavelength of 220 nm or shorter, improves the sensitivity and resolving power, and enhances the density dependency and the exposure margin.

Examples of the anion of the fluorine-substituted carboxylic acid include anions of fluoroacetic acid, difluoroacetic acid, trifluoroacetic acid, pentafluoropropionic acid, heptafluorobutyric acid, nonafluoropentanoic acid, perfluorododecanoic acid, perfluorotridecanoic acid, perfluorocyclohexanecarboxylic acid, and 2,2-bistrifluoromethylpropionic acid.

The content of the carboxylic acid onium salt is preferably 0.1% to 20% by mass, more preferably 0.5% to 10% by mass, and still more preferably 1% to 7% by mass with respect to the total solid content of the composition.

[Dissolution Inhibiting Compound Having Molecular Weight of 3,000 or Less, Having Solubility in Alkaline Developer That Increases through Decomposition by Action of Acid>

The resist composition may include a dissolution inhibiting compound having a molecular weight of 3,000 or less, having a solubility in an alkaline developer that increases through decomposition by an action of an acid (hereinafter also referred to as a "dissolution inhibiting compound").

As the dissolution inhibiting compound, an alicyclic or aliphatic compound containing an acid-decomposable group, such as a cholic acid derivative including an acid-decomposable group described in Proceeding of SPIE, 2724, 355 (1996), is preferable since it does not reduce the transparency to light at 220 nm or less.

Moreover, in a case where the resist composition of the embodiment of the present invention is exposed to a KrF excimer laser or irradiated with electron beams, a dissolution inhibiting compound including a structure in which a phenolic hydroxyl group of a phenol compound is substituted with an acid-decomposable group is preferable. In a case where the dissolution inhibiting compound is a phenol compound, the phenol compound preferably includes 1 to 9 phenol skeletons, and more preferably includes 2 to 6 phenol skeletons.

The content of the dissolution inhibiting compound is preferably 3% to 50% by mass, and more preferably 5% to 40% by mass with respect to the total solid content of the composition.

Specific examples of the dissolution inhibiting compound are shown below, but the present invention is not limited thereto.

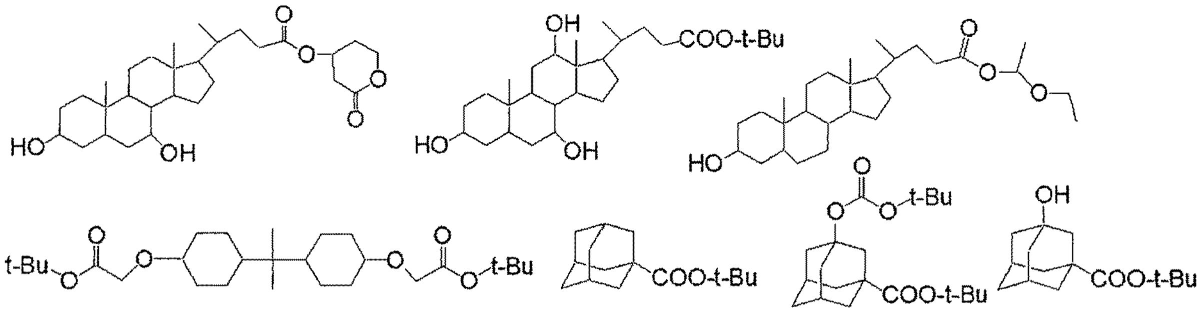

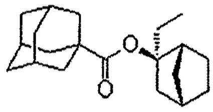

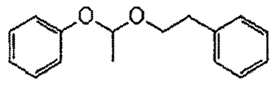

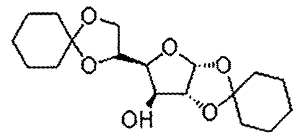

[Crosslinking Agent (K)]

The resist composition of the embodiment of the present invention may include a compound which crosslinks a resin by the action of an acid (hereinafter also referred to as a "crosslinking agent").

As the crosslinking agent, a known compound can be appropriately used. For example, the known compounds disclosed in paragraphs [0379] to [0431] of the specification of US2016/0147154A1 and paragraphs [0064] to [0141] of the specification of US2016/0282720A1 can be suitably used as the crosslinking agent.

The crosslinking agent is a compound (including a resin) having a crosslinkable group capable of crosslinking the resin.

Examples of the crosslinkable group include a hydroxymethyl group, an alkoxymethyl group, an acyloxymethyl group, an alkoxymethyl ether group, an oxirane ring, and an oxetane ring, and the hydroxymethyl group, the alkoxymethyl group, the oxirane ring, or the oxetane ring is preferable.

Further, the number of crosslinkable groups in the crosslinking agent is preferably 2 or more.

Among those, the crosslinking agent is more preferably a phenol derivative, a urea-based compound (compound having a urea structure), or a melamine-based compound (compound having a melamine structure), which includes a hydroxymethyl group or an alkoxymethyl group.

The crosslinking agents may be used singly or in combination of two or more kinds thereof.

The content of the crosslinking agent is preferably 3% to 40% by mass, more preferably 5% to 30% by mass, and still more preferably 5% to 20% by mass with respect to the total solid content of the resist composition.

[Other Additives]

The resist composition may further include a dye, a plasticizer, a photosensitizer, a light absorber, and/or a compound that accelerates a solubility in a developer (for example, a phenol compound having a molecular weight of 1,000 or less, and an alicyclic or aliphatic compound having a carboxyl group).

The phenol compound having a molecular weight of 1,000 or less can be synthesized by those skilled in the art with reference to the method described in, for example, JP1992-122938A (JP-H04-122938A), JP1990-028531A (JP-H02-028531A), US4916210A, EP219294B, and the like.

Specific examples of the alicyclic or aliphatic compound having a carboxyl group include a carboxylic acid derivative having a steroid structure, such as a cholic acid, deoxycholic acid, and lithocholic acid, an adamantane carboxylic acid derivative, adamantane dicarboxylic acid, cyclohexane carboxylic acid, and cyclohexane dicarboxylic acid.

[Pattern Forming Method]

The procedure of the pattern forming method using the resist composition is not particularly limited, but preferably has the following steps.

Step 1: A step of forming a resist film on a substrate using the resist composition
Step 2: A step of exposing the resist film
Step 3: A step of developing the exposed resist film using a developer to form a pattern

Hereinafter, the procedure of each of the steps will be described in detail.

[Step 1: Resist Film Forming Step]

Step 1 is a step of forming a resist film on a substrate using a resist composition.
The definition of the resist composition is as described above.
Hereinafter, a specific example of the method for preparing the resist composition will be shown.
In the resist composition used in the pattern forming method of the embodiment of the present invention, the content of the metal atoms is preferably adjusted to a predetermined amount as described above. The metal atoms may be added to a resist composition or may be unintentionally mixed in the resist composition in a step of producing the resist composition.
Hereinafter, first, a specific example of a method for reducing the content of the metal atoms in the resist composition will be described, and then a specific example of a method for preparing the resist composition will be described.
Examples of the method for reducing the content of the metal atoms in the resist composition include a method for adjusting the content by filtration using a filter. As for the filter pore diameter, the pore size is preferably less than 100 nm, more preferably 10 nm or less, and still more preferably 5 nm or less. As the filter, a polytetrafluoroethylene-made, polyethylene-made, or nylon-made filter is preferable. The filter may be constituted with a composite material in which the filter material is combined with an ion exchange medium. As the filter, a filter which has been washed with an organic solvent in advance may be used. In the step of filtration using a filter, plural kinds of filters connected in series or in parallel may be used. In a case of using the plural kinds of filters, a combination of filters having different pore diameters and/or materials may be used. In addition, various materials may be filtered plural times, and the step of filtering plural times may be a circulatory filtration step.
In addition, examples of a method for reducing the content of the metal atoms in the resist composition include a method of selecting raw materials having a low content of metals as raw materials constituting various materials in the resist composition, a method of subjecting raw materials constituting various materials in the resist composition to filtration using a filter, and a method of performing distillation under the condition for suppressing the contamination as much as possible by, for example, lining the inside of a device with TEFLON (registered trademark).
In addition, as the method for reducing the content of the metal atoms in the resist composition, removal with an adsorbing material may be performed, in addition to the above-mentioned filter filtration, and the filter filtration and the adsorbing material may be used in combination. As the adsorbing material, known adsorbing materials can be used, and for example, inorganic adsorbing materials such as silica gel and zeolite, and organic adsorbing materials such as activated carbon can be used.
In addition, in order to reduce the content of the metal atoms in the resist composition, it is necessary to prevent the incorporation of metal impurities in the production process. Sufficient removal of metal impurities from a production device can be confirmed by measuring the content of metal components included in a washing liquid used to wash the production device.
Next, a specific example of the method for preparing the resist composition will be described.
In the production of a resist composition, for example, it is preferable to dissolve various components such as the resin and the photoacid generator as described above in a solvent, and then perform circulatory filtration using a plurality of filters having different materials. For example, a method in which a polyethylene-made filter having a pore diameter of 50 nm, a nylon-made filter having a pore diameter of 10 nm, and a polyethylene-made filter having a pore diameter of 3 to 5 nm are connected in permuted connection to perform circulatory filtration twice or more is preferable. Further, the filtration step also has an effect of reducing the content of the metal atoms in the resist composition. A smaller pressure difference among the filters is more preferable, and the pressure difference is generally 0.1 MPa or less, preferably 0.05 MPa or less, and more preferably 0.01 MPa or less. A smaller pressure difference between the filter and the charging nozzle is also preferable, and the pressure difference is generally 0.5 MPa or less, preferably 0.2 MPa or less, and more preferably 0.1 MPa or less.
In addition, as a method for performing circulation filtration using a filter in the production of the resist composition, for example, a method of performing circulation filtration twice or more using a polytetrafluoroethylene-made filter having a pore diameter of 50 nm is also preferable.
Furthermore, the content of the halogen-based solvent in the resist composition is preferably adjusted to a predetermined amount as described above. The halogen-based solvent may be added to a resist composition or may be unintentionally mixed in the resist composition in a step of producing the resist composition.
As a method for reducing the content of the halogen-based solvent in the resist composition, for example, a method in which a material that can include a halogen-based solvent such as a photoacid generator is purified by a method such as crystallization, and then mixed with other raw materials constituting the resist composition, or other methods are preferable.

It is preferable to subject the inside of a device for producing the resist composition to gas replacement with an inert gas such as nitrogen. With this, it is possible to suppress dissolution of an active gas such as oxygen in the composition.

The resist composition is filtered by a filter and then charged into a clean container. It is preferable that the resist composition charged in the container is subjected to cold storage. This enables performance deterioration caused by the lapse of time to be suppressed. A shorter time from completion of the charge of the composition into the container to initiation of cold storage is more preferable, and the time is generally 24 hours or shorter, preferably 16 hours or shorter, more preferably 12 hours or shorter, and still preferably 10 hours or shorter. The storage temperature is preferably 0°C to 15°C, more preferably 0°C to 10°C, and still more preferably 0°C to 5°C.

Next, a method of forming a resist film on a substrate using a resist composition will be described.

Examples of the method of forming a resist film on a substrate using a resist composition include a method of applying a resist composition onto a substrate.

The resist composition can be applied onto a substrate (for example, silicon and silicon dioxide coating) as used in the manufacture of integrated circuit elements by a suitable application method such as ones using a spinner or a coater. As the application method, spin application using a spinner is preferable. The rotation speed upon spin application using a spinner is preferably 1,000 to 3,000 rpm.

After applying the resist composition, the substrate may be dried to form a resist film. In addition, various underlying films (an inorganic film, an organic film, or an antireflection film) may be formed on the underlayer of the resist film.

Examples of the drying method include a method of heating and drying. The heating may be performed using a unit included in an ordinary exposure machine and/or an ordinary development machine, and may also be performed using a hot plate or the like. The heating temperature is preferably 80°C to 150°C, more preferably 80°C to 140°C, and still more preferably 80°C to 130°C. The heating time is preferably 30 to 1,000 seconds, more preferably 60 to 800 seconds, and still more preferably 60 to 600 seconds.

The film thickness of the resist film is not particularly limited, but in a case where the exposure method involves an ArF excimer laser, EUV, X-rays, or electron beams, the film thickness is preferably 5 to 150 nm, and more preferably 10 to 100 nm from the viewpoint that a fine pattern having higher accuracy can be formed. In addition, in a case where the exposure method involves a KrF excimer laser, the film thickness is preferably 100 nm to 50 μm, and more preferably 100 nm to 15 μm from the viewpoint that a fine pattern having higher accuracy can be formed.

The content of the halogen-based solvent in the resist film is preferably 1 ppb by mass to 2,000 ppm by mass, more preferably 1 ppb by mass to 400 ppm by mass, and still more preferably 1 ppb by mass to 40 ppm by mass with respect to the total mass of the film.

Furthermore, the content of the halogen-based solvent included in the resist film can be measured by using gas chromatography (for example, GC system 7890B manufactured by Agilent Technologies, Inc.).

Moreover, a topcoat may be formed on the upper layer of the resist film, using the topcoat composition.

It is preferable that the topcoat composition is not mixed with the resist film and can be uniformly applied onto the upper layer of the resist film.

Furthermore, it is preferable to dry the resist film before forming the topcoat. Then, the topcoat composition can be applied onto the obtained resist film by the same unit as the method for forming a resist film, and further dried to form a topcoat.

The film thickness of the topcoat is preferably 10 to 200 nm, and more preferably 20 to 100 nm.

The topcoat is not particularly limited, a topcoat known in the related art can be formed by the methods known in the related art, and the topcoat can be formed, based on the description in paragraphs [0072] to [0082] of JP2014-059543A, for example.

It is preferable that a topcoat including a basic compound as described in JP2013-061648A, for example, is formed on a resist film. Specific examples of the basic compound which can be included in the topcoat include a basic compound which may be included in a resist composition which will be described later.

In addition, the topcoat preferably includes a compound which includes at least one group or bond selected from the group consisting of an ether bond, a thioether bond, a hydroxyl group, a thiol group, a carbonyl bond, and an ester bond.

[Step 2: Exposing Step]

Step 2 is a step of exposing the resist film.

Examples of the exposing method include a method of irradiating a resist film thus formed with actinic rays or radiation through a predetermined mask.

Examples of the actinic rays or radiation include infrared light, visible light, ultraviolet light, far ultraviolet light, extreme ultraviolet light, X-rays, and electron beams, preferably a far ultraviolet light having a wavelength of 250 nm or

less, more preferably a far ultraviolet light having a wavelength of 220 nm or less, and particularly preferably a far ultraviolet light having a wavelength of 1 to 200 nm, specifically, KrF excimer laser (248 nm), ArF excimer laser (193 nm), $F_2$ excimer laser (157 nm), EUV (13 nm), X-rays, and electron beams.

It is preferable to perform baking (heating) before performing development after the exposure. The baking accelerates a reaction in the exposed area, and the sensitivity and the pattern shape are improved.

The heating temperature is preferably 80°C to 150°C, more preferably 80°C to 140°C, and still more preferably 80°C to 130°C.

The heating time is preferably 10 to 1,000 seconds, more preferably 10 to 180 seconds, and still more preferably 30 to 120 seconds.

The heating may be performed using a unit included in an ordinary exposure machine and/or an ordinary development machine, and may also be performed using a hot plate or the like.

This step is also referred to as a post-exposure bake.

[Step 3: Developing Step]

Step 3 is a step of developing the exposed resist film using a developer to form a pattern.

Examples of the developing method include a method in which a substrate is immersed in a tank filled with a developer for a certain period of time (a dip method), a method in which development is performed by heaping a developer up onto the surface of a substrate by surface tension, and then leaving it to stand for a certain period of time (a puddle method), a method in which a developer is sprayed on the surface of a substrate (a spray method), and a method in which a developer is continuously jetted onto a substrate rotating at a constant speed while scanning a developer jetting nozzle at a constant rate (a dynamic dispense method).

Furthermore, after the step of performing development, a step of stopping the development may be carried out while substituting the solvent with another solvent.

The developing time is not particularly limited as long as it is a period of time where the unexposed area of a resin is sufficiently dissolved and is preferably 10 to 300 seconds, and more preferably 20 to 120 seconds.

The temperature of the developer is preferably 0°C to 50°C, and more preferably 15°C to 35°C.

Examples of the developer include an alkaline developer and an organic solvent developer.

As the alkaline developer, it is preferable to use an aqueous alkaline solution including an alkali. The type of the aqueous alkaline solution is not particularly limited, but examples thereof include an aqueous alkaline solution including a quaternary ammonium salt typified by tetramethylammonium hydroxide, an inorganic alkali, a primary amine, a secondary amine, a tertiary amine, an alcoholamine, a cyclic amine, or the like. Among those, the aqueous solutions of the quaternary ammonium salts typified by tetramethylammonium hydroxide (TMAH) are preferable as the alkaline developer. An appropriate amount of an alcohol, a surfactant, or the like may be added to the alkaline developer. The alkali concentration of the alkaline developer is usually 0.1% to 20% by mass. Further, the pH of the alkaline developer is usually 10.0 to 15.0.

The organic solvent developer is a developer including an organic solvent.

The vapor pressure of the organic solvent included in the organic solvent developer (in a case of a mixed solvent, a vapor pressure as a whole) is preferably 5 kPa or less, more preferably 3 kPa or less, and still more preferably 2 kPa or less at 20°C. By setting the vapor pressure of the organic solvent to 5 kPa or less, evaporation of the developer on a substrate or in a development cup is suppressed, the temperature uniformity in a wafer plane is improved, and as a result, the dimensional uniformity in the wafer plane is enhanced.

Examples of the organic solvent used in the organic solvent developer include known organic solvents, and include an ester-based solvent, a ketone-based solvent, an alcohol-based solvent, an amide-based solvent, an ether-based solvent, and a hydrocarbon-based solvent.

It is preferable to use an ester-based solvent having 7 or more carbon atoms (preferably 7 to 14 carbon atoms, more preferably 7 to 12 carbon atoms, and still more preferably 7 to 10 carbon atoms), and 2 or less heteroatoms as the organic solvent included in the organic solvent developer, from the viewpoint that swelling of the resist film can be suppressed in a case where EUV and electron beams are used in the exposing step.

The heteroatom of the ester-based solvent is an atom other than a carbon atom and a hydrogen atom, and examples thereof include an oxygen atom, a nitrogen atom, and a sulfur atom. The number of the heteroatoms is preferably 2 or less.

As the ester-based solvent having 7 or more carbon atoms and 2 or less heteroatoms, amyl acetate, isoamyl acetate, 2-methylbutyl acetate, 1-methylbutyl acetate, hexyl acetate, pentyl propionate, hexyl propionate, butyl propionate, isobutyl isobutyrate, heptyl propionate, butyl butanoate, or the like is preferable, and isoamyl acetate is more preferable.

In a case where EUV and electron beams are used in the exposing step, a mixed solvent of the ester-based solvent and the hydrocarbon-based solvent or a mixed solvent of the ketone-based solvent and the hydrocarbon solvent

may be used instead of the ester-based solvent having 7 or more carbon atoms and having 2 or less heteroatoms as the organic solvent included in the organic solvent developer. Also in this case, it is effective in suppressing the swelling of the resist film.

In a case where the ester-based solvent and the hydrocarbon-based solvent are used in combination, it is preferable to use isoamyl acetate as the ester-based solvent. In addition, from the viewpoint of adjusting the solubility of the resist film, a saturated hydrocarbon solvent (for example, octane, nonane, decane, dodecane, undecane, and hexadecane) is preferable as the hydrocarbon solvent.

In a case where the ketone-based solvent and the hydrocarbon-based solvent are used in combination, it is preferable to use 2-heptanone as the ketone-based solvent. In addition, from the viewpoint of adjusting the solubility of the resist film, a saturated hydrocarbon solvent (for example, octane, nonane, decane, dodecane, undecane, and hexadecane) is preferable as the hydrocarbon solvent.

Since the content of the hydrocarbon-based solvent depends on the solvent solubility of the resist film in a case of using the mixed solvent, it is not particularly limited, the content may be appropriately adjusted to determine a necessary amount of the hydrocarbon solvent.

A plurality of the organic solvents may be mixed or the organic solvent may be used in admixture with a solvent other than those described above or water. It should be noted that in order to fully exert the effects of the present invention, the moisture content of the developer as a whole is preferably less than 10% by mass, and the developer is more preferably substantially free of the moisture. The concentration of the organic solvent (in a case of mixing a plurality of the organic solvents, a total thereof) in the developer is preferably 50% by mass or more, more preferably 50% to 100% by mass, still more preferably 85% to 100% by mass, even still more preferably 90% to 100% by mass, and particularly preferably 95% to 100% by mass.

[Other Steps]

It is preferable that the pattern forming method includes a step of performing washing using a rinsing liquid after Step 3.

Examples of the rinsing liquid used in the rinsing step after the step of performing development using the developer include pure water. Further, an appropriate amount of a surfactant may be added to pure water.

An appropriate amount of a surfactant may be added to the rinsing liquid.

A method for the rinsing step is not particularly limited, but examples thereof include a method in which a rinsing liquid is continuously jetted on a substrate rotated at a constant rate (a rotation application method), a method in which a substrate is immersed in a tank filled with a rinsing liquid for a certain period of time (a dip method), and a method in which a rinsing liquid is sprayed on a substrate surface (a spray method).

Furthermore, the pattern forming method of the embodiment of the present invention may include a heating step (postbaking) after the rinsing step. By the present step, the developer and the rinsing liquid remaining between and inside the patterns are removed by the baking step. In addition, the present step also has an effect that a resist pattern is annealed and the surface roughness of the pattern is improved. The heating step after the rinsing step is usually performed at 40°C to 250°C (preferably 90°C to 200°C) for usually 10 seconds to 3 minutes (preferably 30 to 120 seconds).

In addition, an etching treatment on the substrate may be carried out using the formed pattern as a mask. That is, the substrate (or the underlayer film and the substrate) may be processed using the pattern thus formed in Step 3 as a mask to form a pattern on the substrate.

A method for processing the substrate (or the underlayer film and the substrate) is not particularly limited, but a method in which a pattern is formed on a substrate by subjecting the substrate (or the underlayer film and the substrate) to dry etching using the pattern thus formed in Step 3 as a mask is preferable.

The dry etching may be one-stage etching or multi-stage etching. In a case where the etching is etching including a plurality of stages, the etchings at the respective stages maybe the same treatment or different treatments.

For etching, any of known methods can be used, and various conditions and the like are appropriately determined according to the type of a substrate, usage, and the like. The etching can be carried out, for example, in accordance with a Journal of The International Society for Optical Engineering (Proc. of SPIE), Vol. 6924, 692420 (2008), JP2009-267112A, and the like. In addition, the etching can also be carried out in accordance with "Chapter 4 Etching" in "Semiconductor Process Text Book, 4th Ed., published in 2007, publisher: SEMI Japan".

Among those, oxygen plasma etching is preferable as the dry etching.

Various materials (for example, a developer, a rinsing liquid, a composition for forming an antireflection film, and a composition for forming a topcoat) other than the resist composition used in the pattern forming method of the embodiment of the present invention preferably have smaller amounts of impurities such as a metal (for example, Na, K, Ca, Fe, Cu, Mg, Al, Li, Cr, Ni, Sn, Ag, As, Au, Ba, Cd, Co, Pb, Ti, V, W, and Zn). The content of the impurities included in these materials is preferably, for example, 1 ppm by mass or less.

Examples of a method for reducing impurities such as a metal in various materials other than the resist composition include filtration using a filter. As for the filter pore diameter, the pore size is preferably less than 100 nm, more preferably 10 nm or less, and still more preferably 5 nm or less. As the filter, a polytetrafluoroethylene-made, polyethylene-made, or nylon-made filter is preferable. The filter may be constituted with a composite material in which the filter material is combined with an ion exchange medium. As the filter, a filter which has been washed with an organic solvent in advance may be used. In the step of filtration using a filter, plural kinds of filters connected in series or in parallel may be used. In a case of using the plural kinds of filters, a combination of filters having different pore diameters and/or materials may be used. In addition, various materials may be filtered plural times, and the step of filtering plural times may be a circulatory filtration step.

In addition, examples of a method for reducing impurities such as a metal in various materials other than the resist composition include a method of selecting raw materials having a low content of metals as raw materials constituting various materials, a method of subjecting raw materials constituting various materials to filtration using a filter, and a method of performing distillation under the condition for suppressing the contamination as much as possible by, for example, lining the inside of a device with TEFLON (registered trademark).

In addition, as the method for reducing impurities such as a metal in various materials other than the resist composition, removal of impurities with an adsorbing material may be performed, in addition to the above-mentioned filter filtration, and the filter filtration and the adsorbing material may be used in combination. As the adsorbing material, known adsorbing materials can be used, and for example, inorganic adsorbing materials such as silica gel and zeolite, and organic adsorbing materials such as activated carbon can be used. It is necessary to prevent the incorporation of metal impurities in the production process in order to reduce the impurities such as a metal included in the various materials other than the resist composition. Sufficient removal of metal impurities from a production device can be confirmed by measuring the content of metal components included in a washing liquid used to wash the production device.

A conductive compound may be added to an organic treatment liquid such as a rinsing liquid in order to prevent breakdown of chemical liquid pipes and various parts (a filter, an O-ring, a tube, or the like) due to electrostatic charging, and subsequently generated electrostatic discharging. The conductive compound is not particularly limited, but examples thereof include methanol. The addition amount is not particularly limited, but from the viewpoint that preferred development characteristics or rinsing characteristics are maintained, the addition amount is preferably 10% by mass or less, and more preferably 5% by mass or less.

For the chemical liquid pipe, it is possible to use various pipes coated with stainless steel (SUS), or a polyethylene resin, a polypropylene resin, or a fluorine resin (a polytetrafluoroethylene resin, a perfluoroalkoxy resin, or the like) which has been subjected to an antistatic treatment. Similarly, a polyethylene resin, a polypropylene resin, or a fluorine resin (a polytetrafluoroethylene resin, a perfluoroalkoxy resin, or the like) which has been subjected to an antistatic treatment can be used for a filter and an O-ring.

A method for improving the surface roughness of a pattern may be applied to a pattern thus formed by the method of the embodiment of the present invention. Examples of the method for improving the surface roughness of the pattern include the method of treating a pattern with a plasma of a hydrogen-containing gas disclosed in WO2014/002808A. Additional examples of the method include known methods as described in JP2004-235468A, US2010/0020297A, JP2008-083384A, and Proc. of SPIE Vol. 8328 83280N-1 "EUV Resist Curing Technique for LWR Reduction and Etch Selectivity Enhancement".

In a case where a pattern thus formed is in the form of a line, an aspect ratio determined by dividing the height of the pattern with the line width is preferably 2.5 or less, more preferably 2.1 or less, and still more preferably 1.7 or less.

In a case where a pattern thus formed is in the form of a trench (groove) pattern or a contact hole pattern, an aspect ratio determined by dividing the height of the pattern with the trench width or the hole diameter is preferably 4.0 or less, more preferably 3.5 or less, and still more preferably 3.0 or less.

The pattern forming method of the embodiment of the present invention can also be used for forming a guide pattern in a directed self-assembly (DSA) (see, for example, ACS Nano Vol. 4, No. 8, Pages 4815-4823).

In addition, a pattern thus formed by the method can be used as a core material (core) of the spacer process disclosed in, for example, JP1991-270227A (JP-H03-270227A) and JP2013-164509A.

[Method for Manufacturing Electronic Device]

Moreover, the present invention further relates to a method for manufacturing an electronic device, including the above-described pattern forming method, and an electronic device manufactured by the manufacturing method.

Furthermore, the electronic device of an embodiment of the present invention is suitably mounted on electric or electronic equipment (for example, home appliances, office automation (OA)-related equipment, media-related equipment, optical equipment, telecommunication equipment, and the like).

Examples

Hereinbelow, the present invention will be described in more detail with reference to Examples. The materials, the amounts of materials used, the proportions, the treatment details, the treatment procedure, and the like shown in Examples below may be appropriately modified as long as the modifications do not depart from the spirit of the present invention. Therefore, the scope of the present invention should not be construed as being limited to Examples shown below.

[Various Components]

[Acid-Decomposable Resin]

The structures of acid-decomposable resins (resins A-1 to A-51) shown in Table 2 are shown in Table 1.

Furthermore, the weight-average molecular weights (Mw) and the dispersities (Mw/Mn) of the acid-decomposable resins were measured by means of GPC (carrier: tetrahydrofuran (THF)) (an amount expressed in terms of polystyrene). In addition, the compositional ratios (ratios in % by mole) of the resins were measured by means of $^{13}C$-nuclear magnetic resonance (NMR).

Furthermore, as the acid-decomposable resins shown in Table 1, those synthesized according to a synthesis method for the resin A-8 described in the latter part were used.

[Table 1-1]

| | Repeating unit 1 | | Repeating unit 2 | | Repeating unit 3 | | Repeating unit 4 | | Repeating unit 5 | | Mw | Mw/Mn |
|---|---|---|---|---|---|---|---|---|---|---|---|---|
| | Type of monomer | Molar ratio | Type of monomer | Molar ratio | Type of monomer | Molar ratio | Type of monomer | Molar ratio | Type of monomer | Molar ratio | | |
| Resin A-1 | a-3 | 20 | a-5 | 30 | b-6 | 30 | b-14 | 20 | | | 8,500 | 1.6 |
| Resin A-2 | a-5 | 35 | a-8 | 20 | b-4 | 20 | b-13 | 25 | | | 12,000 | 1.5 |
| Resin A-3 | a-3 | 20 | a-5 | 10 | a-13 | 10 | b-5 | 30 | b-14 | 30 | 10,000 | 1.4 |
| Resin A-4 | a-3 | 50 | b-3 | 30 | b-6 | 20 | | | | | 13,500 | 1.6 |
| Resin A-5 | a-8 | 40 | b-3 | 15 | b-4 | 15 | b-5 | 15 | b-14 | 15 | 9,000 | 1.3 |
| Resin A-6 | a-3 | 15 | a-5 | 10 | b-3 | 50 | b-6 | 25 | | | 14,000 | 1.4 |
| Resin A-7 | a-3 | 30 | b-4 | 10 | b-10 | 40 | b-13 | 20 | | | 16,500 | 1.7 |
| Resin A-8 | a-3 | 55 | b-6 | 45 | | | | | | | 17,500 | 1.5 |
| Resin A-9 | a-3 | 30 | a-14 | 15 | b-6 | 55 | | | | | 8,500 | 1.7 |
| Resin A-10 | a-1 | 45 | a-15 | 10 | b-3 | 45 | | | | | 10,000 | 1.8 |
| Resin A-11 | a-3 | 40 | b-12 | 50 | c-7 | 10 | | | | | 9,000 | 1.4 |
| Resin A-12 | a-7 | 45 | b-13 | 20 | b-14 | 30 | c-3 | 5 | | | 9,000 | 1.4 |
| Resin A-13 | a-1 | 30 | a-7 | 30 | b-4 | 25 | b-13 | 15 | | | 6,500 | 1.5 |
| Resin A-14 | a-1 | 70 | b-4 | 30 | | | | | | | 12,000 | 1.4 |

(continued)

| | Repeating unit 1 | | Repeating unit 2 | | Repeating unit 3 | | Repeating unit 4 | | Repeating unit 5 | | Mw | Mw/Mn |
|---|---|---|---|---|---|---|---|---|---|---|---|---|
| | Type of monomer | Molar ratio | Type of monomer | Molar ratio | Type of monomer | Molar ratio | Type of monomer | Molar ratio | Type of monomer | Molar ratio | | |
| Resin A-15 | a-7 | 40 | b-13 | 20 | b-14 | 25 | c-3 | 15 | | | 7,000 | 1.6 |
| Resin A-16 | a-7 | 35 | b-9 | 35 | c-3 | 30 | | | | | 18,000 | 1.6 |
| Resin A-17 | a-9 | 50 | b-5 | 20 | b-14 | 25 | c-3 | 5 | | | 7,500 | 1.5 |
| Resin A-18 | a-2 | 40 | a-8 | 20 | b-9 | 20 | b-14 | 15 | c-4 | 5 | 8,500 | 1.5 |
| Resin A-19 | a-1 | 10 | a-7 | 25 | b-4 | 35 | b-14 | 20 | c-3 | 10 | 16,500 | 1.7 |
| Resin A-20 | a-11 | 45 | b-5 | 25 | b-15 | 20 | c-3 | 10 | | | 14,500 | 1.3 |
| Resin A-21 | a-11 | 35 | b-17 | 45 | b-21 | 5 | c-3 | 10 | c-8 | 5 | 10,500 | 1.6 |
| Resin A-22 | a-3 | 45 | b-4 | 45 | c-6 | 10 | | | | | 14,500 | 1.4 |
| Resin A-23 | a-3 | 25 | b-1 | 10 | b-4 | 50 | c-7 | 15 | | | 9,000 | 1.3 |
| Resin A-24 | a-12 | 20 | b-5 | 35 | b-19 | 25 | c-3 | 20 | | | 14,000 | 1.6 |
| Resin A-25 | a-3 | 20 | b-4 | 40 | b-7 | 40 | | | | | 17,500 | 1.8 |
| Resin A-26 | a-8 | 50 | b-9 | 15 | b-14 | 25 | c-4 | 10 | | | 13,500 | 1.3 |
| Resin A-27 | a-11 | 30 | b-5 | 30 | b-8 | 30 | c-1 | 5 | c-2 | 5 | 7,000 | 1.5 |
| Resin A-28 | a-11 | 50 | b-17 | 30 | b-20 | 5 | c-3 | 10 | c-8 | 5 | 9,500 | 1.5 |

(continued)

| | Repeating unit 1 | | Repeating unit 2 | | Repeating unit 3 | | Repeating unit 4 | | Repeating unit 5 | | Mw | Mw/Mn |
|---|---|---|---|---|---|---|---|---|---|---|---|---|
| | Type of monomer | Molar ratio | Type of monomer | Molar ratio | Type of monomer | Molar ratio | Type of monomer | Molar ratio | Type of monomer | Molar ratio | | |
| Resin A-29 | a-11 | 45 | b-5 | 40 | b-19 | 5 | c-3 | 10 | | | 7,500 | 1.3 |
| Resin A-30 | a-10 | 45 | b-15 | 50 | c-3 | 5 | | | | | 9,000 | 1.6 |
| Resin A-31 | a-11 | 30 | b-5 | 30 | b-15 | 30 | c-3 | 10 | | | 12,500 | 1.5 |
| Resin A-32 | a-11 | 40 | b-15 | 40 | c-1 | 15 | c-3 | 5 | | | 8,500 | 1.3 |
| Resin A-33 | a-3 | 35 | b-4 | 45 | b-18 | 10 | c-7 | 10 | | | 10,500 | 1.4 |
| Resin A-34 | a-11 | 55 | b-12 | 30 | c-3 | 15 | | | | | 9,500 | 1.7 |
| Resin A-35 | a-10 | 65 | b-15 | 25 | c-3 | 10 | | | | | 13,000 | 1.5 |
| Resin A-36 | a-11 | 65 | b-12 | 10 | b-15 | 10 | c-3 | 5 | c-9 | 10 | 13,500 | 1.4 |
| Resin A-37 | a-11 | 45 | b-15 | 40 | c-3 | 15 | | | | | 11,000 | 1.6 |
| Resin A-38 | a-1 | 55 | b-9 | 25 | b-13 | 15 | c-5 | 5 | | | 8,500 | 1.6 |
| Resin A-39 | a-3 | 40 | b-3 | 10 | b-6 | 50 | | | | | 10,000 | 1.2 |
| Resin A-40 | a-4 | 20 | a-6 | 30 | b-4 | 50 | | | | | 8,000 | 1.3 |

[Table 1-2]

| | Repeating unit 1 | | Repeating unit 2 | | Repeating unit 3 | | Repeating unit 4 | | Repeating unit 5 | | Mw | Mw/Mn |
|---|---|---|---|---|---|---|---|---|---|---|---|---|
| | Type of monomer | Molar ratio | Type of monomer | Molar ratio | Type of monomer | Molar ratio | Type of monomer | Molar ratio | Type of monomer | Molar ratio | | |
| Resin A-41 | b-22 | 20 | b-23 | 20 | d-1 | 60 | | | | | 1,5,000 | 1.5 |
| Resin A-42 | a-1 | 10 | b-12 | 30 | d-2 | 60 | | | | | 9,000 | 1.4 |
| Resin A-43 | b-15 | 20 | c-11 | 10 | d-1 | 70 | | | | | 8,500 | 1.2 |
| Resin A-44 | b-13 | 30 | b-16 | 5 | c-10 | 5 | c-11 | 10 | d-1 | 50 | 12,000 | 1.6 |
| Resin A-45 | b-22 | 10 | b-23 | 5 | d-1 | 85 | | | | | 3,500 | 1.1 |
| Resin A-46 | b-11 | 10 | b-23 | 30 | d-1 | 60 | | | | | 7,300 | 1.2 |
| Resin A-47 | b-2 | 30 | d-1 | 70 | | | | | | | 6,500 | 1.1 |
| Resin A-48 | b-24 | 50 | d-1 | 50 | | | | | | | 6,000 | 1.3 |
| Resin A-49 | b-5 | 20 | b-23 | 10 | d-1 | 70 | | | | | 8,000 | 1.2 |
| Resin A-50 | b-23 | 60 | d-1 | 40 | | | | | | | 13,000 | 1.4 |
| Resin A-51 | a-X | 50 | b-X | 50 | | | | | | | 10,000 | 1.6 |

The various monomers shown in Table 1 are shown below.

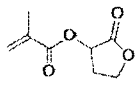
(a-1)
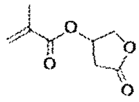
(a-2)
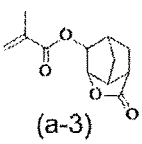
(a-3)
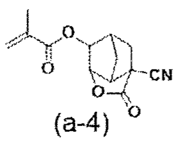
(a-4)
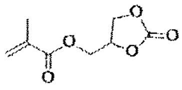
(a-5)

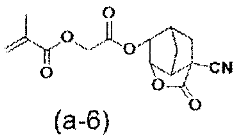
(a-6)
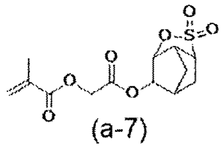
(a-7)
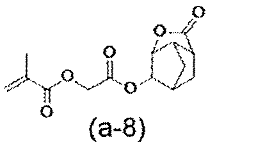
(a-8)

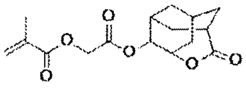
(a-9)
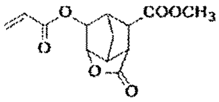
(a-10)
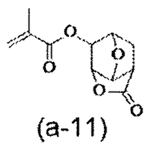
(a-11)
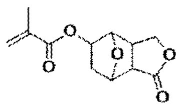
(a-12)

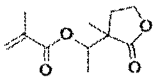
(a-13)
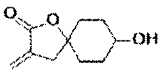
(a-14)
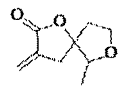
(a-15)

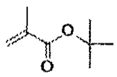
(b-1)
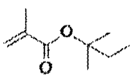
(b-2)
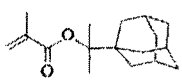
(b-3)
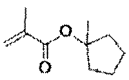
(b-4)
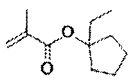
(b-5)

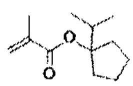
(b-6)
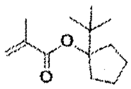
(b-7)
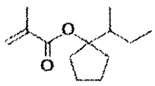
(b-8)
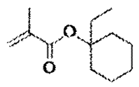
(b-9)
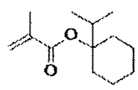
(b-10)

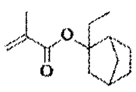
(b-11)
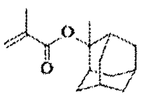
(b-12)
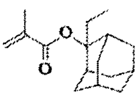
(b-13)
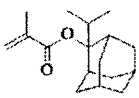
(b-14)
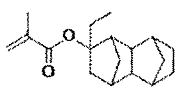
(b-15)

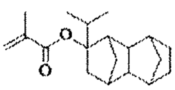
(b-16)
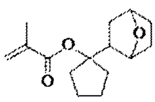
(b-17)
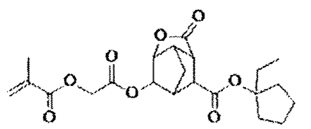
(b-18)

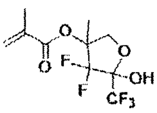
(b-19)
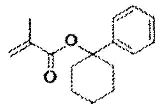
(b-20)
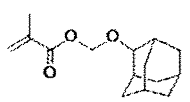
(b-21)
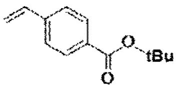
(b-22)

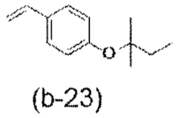
(b-23)

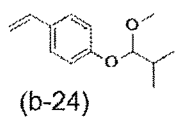
(b-24)

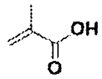
(c-1)

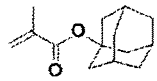
(c-2)

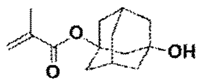
(c-3)

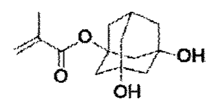
(c-4)

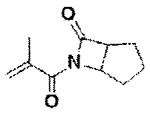
(c-5)

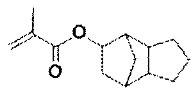
(c-6)

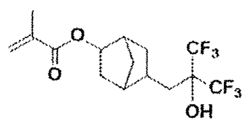
(c-7)

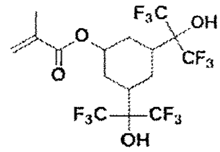
(c-8)

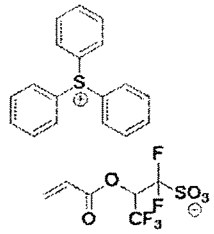
(c-9)

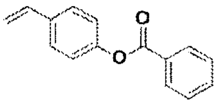
(c-10)

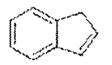
(c-11)

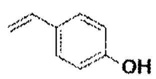
(d-1)

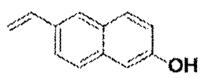
(d-2)

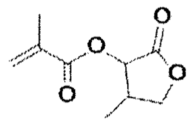
(a-X)

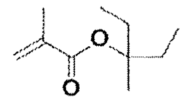
(b-X)

The synthesis method for the resin A-8 is shown below as an example of the above-mentioned method for synthesizing an acid-decomposable resin.

<Synthesis of Resin (A-8)>

Under a nitrogen stream, 8.6 g of cyclohexanone was put into a three-neck flask and heated at 80°C. Next, 17.0 g of a monomer (b-6), 19.2 g of a monomer (a-3), and a polymerization initiator V-601 (manufactured by FUJIFILM Wako Pure Chemical Corporation) in an amount of 8% by mole with respect to a total amount of these monomers were dissolved in 100 g of cyclohexanone to obtain a solution. Next, this solution was added dropwise to the three-neck flask over 6 hours. After completion of the dropwise addition, the mixture was further reacted at 80°C for 2 hours.
The obtained reaction solution was cooled and then added dropwise to a mixed liquid of 800 mL of hexane/200 mL of ethyl acetate over 20 minutes, and the precipitated powder was collected by filtration and dried to obtain 23 g of a resin (A-8). The obtained resin had a weight-average molecular weight of 17,500 and a dispersity (Mw/Mn) of 1.5 expressed in terms of polystyrene as a standard.

[Photoacid Generator]

The structures of the photoacid generators (P-1 to P-14, P-X, and P-Y) shown in Tables 2, 4, 6, and 8 are

shown below. Further, as the photoacid generators shown in Tables 2, 4, 6, and 8, all of them were synthesized according to a synthesis method for a photoacid generator P-1 described in the latter part.

Furthermore, the content of the halogen-based solvent in the composition which will be described later was adjusted by changing the number of times of crystallization of the photoacid generator.

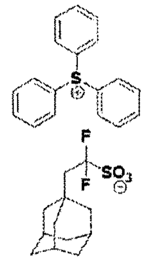
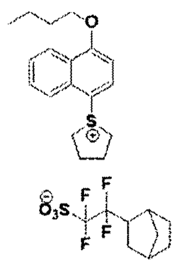
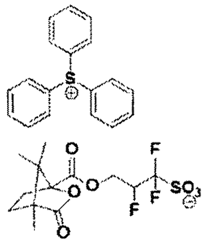
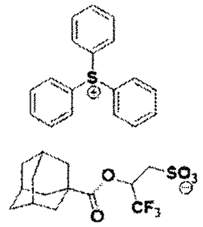

(P-1) (P-2) (P-3) (P-4)

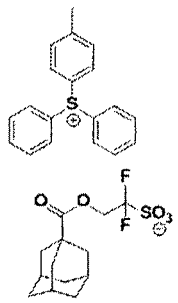
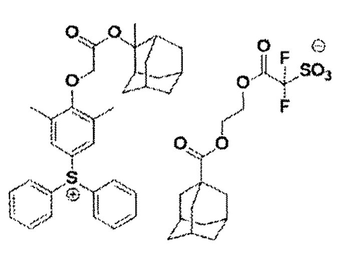
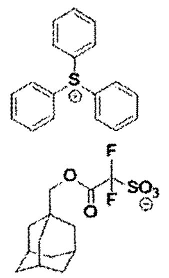

(P-5) (P-6 (P-7)

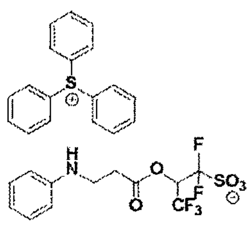
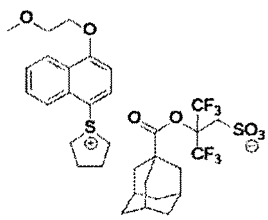
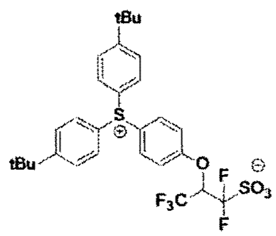

(P-8) (P-9) (P-10)

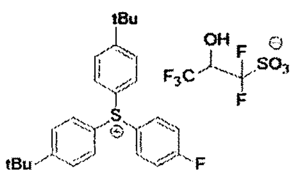
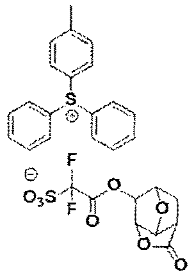
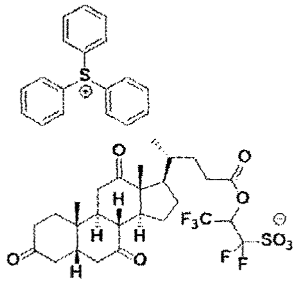

(P-11) (P-12) (P-13)

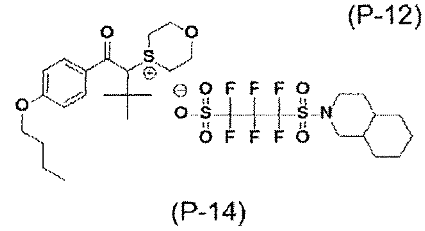

(P-14)

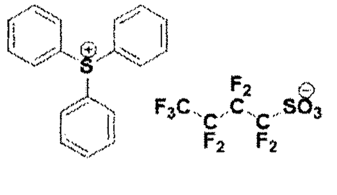

(P-X)

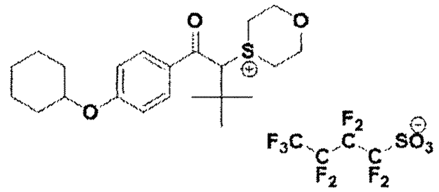

(P-Y)

<Synthesis of Photoacid Generator (P-1)>

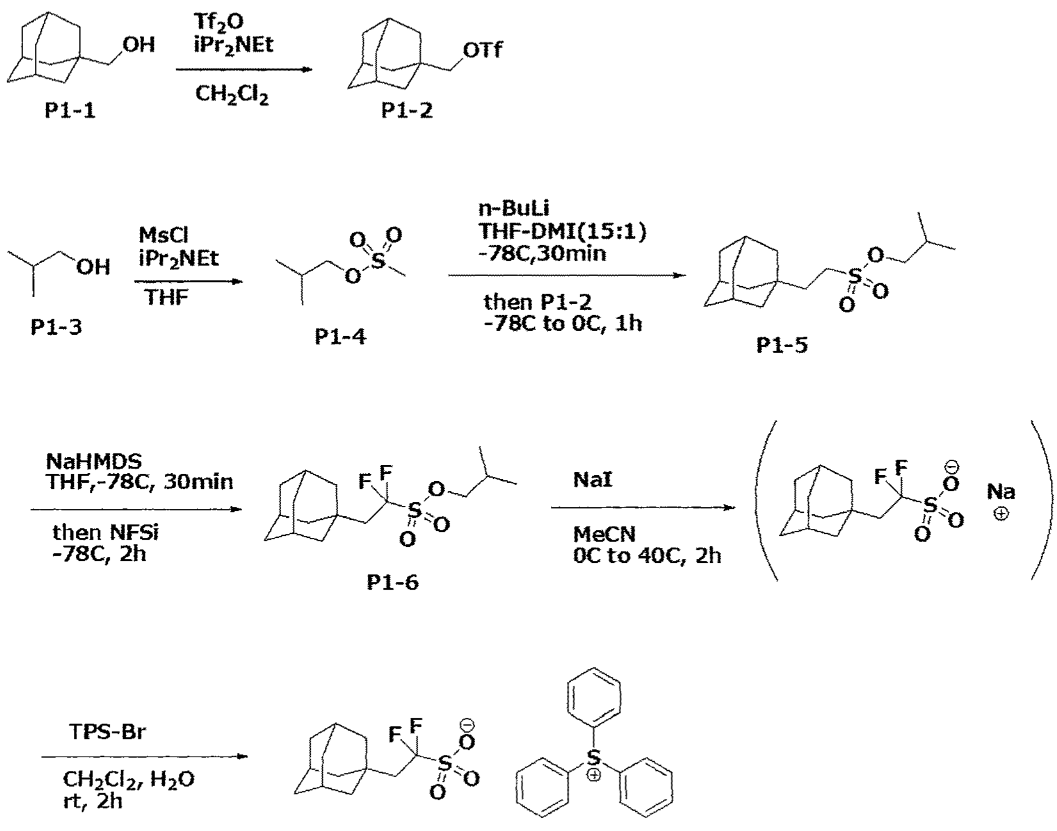


P-1

(Synthesis of P1-2)

16.6 g (100 mmol) of P1-1 (adamantane methanol) was dissolved in 160 g of methylene chloride in a three-neck flask. Next, 14.9 g (115 mmol) of diisopropylethylamine ($iPr_2NEt$) was further added to the three-neck flask and cooled to -20°C to obtain a reaction solution. Subsequently, 30.8 g (110 mmol) of trifluoromethanesulfonic anhydride ($Tf_2O$) was added dropwise to the reaction solution using a dropping funnel, and the reaction solution after completion of the dropwise addition was further stirred at -20°C for one hour. Next, the reaction solution after stirring was added to the three-neck flask into which 400 g of a saturated aqueous sodium hydrogen carbonate solution and 300 g of hexane had been charged, and the mixture was stirred at room temperature (25°C) for 10 minutes. Subsequently, the organic phase was separated, washed with a saturated aqueous ammonium chloride solution, water, and saturated saline, and concentrated to obtain 29.6 g of a target compound P1-2.

(Synthesis of P1-4)

In a three-neck flask, 20 g (270 mmol) of P1-3 (2-methyl-1-propanol) was dissolved in 200 g of tetrahydrofuran (THF). Next, 38.4 g (297 mmol) of diisopropylethylamine was added to the three-neck flask and cooled to 0°C to obtain

a reaction solution. Subsequently, 32.5 g (284 mmol) of methanesulfonic acid chloride (MsCl) was added dropwise to the reaction solution using a dropping funnel, and the reaction solution after completion of the dropwise addition was further stirred at 0°C for one hour. Next, the reaction solution after stirring was added to the three-neck flask into which 300 g of a saturated aqueous sodium hydrogen carbonate solution had been charged, and the mixture was stirred at room temperature (25°C) for 10 minutes. Subsequently, 300 g of ethyl acetate was added thereto, and then the organic phase was separated, washed with saturated saline, and concentrated. A crude product thus obtained was distilled and purified (5 mmHG, external temperature 100°C) to obtain 26 g of a target compound P1-4.

(Synthesis of P1-5)

In a three-neck flask, 20 g (134 mmol) of P1-4 was dissolved in 300 g of THF and 20 g of 1,3-dimethyl-2-imidazolidinone (DMI), and cooled to -78°C. Subsequently, 50.6 ml (134 mmol) of n-BuLi (2.65 M/hexane solution) was added dropwise to the obtained reaction solution with a syringe, and after completion of the dropwise addition, the mixture was further stirred at -78°C for 30 minutes. Next, a solution obtained by dissolving 26.6 g (89.3 mmol) of P1-2 in 50 g of THF was added dropwise to the reaction solution after stirring, using a dropping funnel. After completion of the dropwise addition, the obtained reaction solution was heated to 0°C and stirred for one hour. Next, the reaction solution after stirring was added to the three-neck flask to which 1 L of hexane and 500 g of a saturated aqueous ammonium chloride solution had been charged, and the mixture was stirred at room temperature (25°C) for 30 minutes. Subsequently, the organic phase was separated, washed with saturated saline, and concentrated. A crude product thus obtained was purified by silica gel column chromatography (developing solvent: hexane/ethyl acetate = 20/1) to obtain 19.5 g of a target compound P1-5.

(Synthesis of P1-6)

11.1 g (37 mmol) of P1-5 was dissolved in 60 g of THF in a three-neck flask and cooled to -78°C. Next, 58 ml (111 mmol) of sodium bis(trimethylsilyl)amide (NaHMDS) (1.9 M/hexane solution) was added dropwise to the obtained reaction solution with a syringe, and after completion of the dropwise addition, the mixture was further stirred at -78°C for 30 minutes. Next, 35 g (111 mmol) of N-fluorobenzenesulfonimide (NFSi) was dividedly added to the reaction solution after stirring, and the mixture was further stirred at -78°C for 2 hours. Next, the reaction solution after stirring was added to the three-neck flask to which 500 g of hexane and 300 g of a saturated aqueous ammonium chloride solution had been charged, and the mixture was stirred at room temperature (25°C) for 30 minutes. Subsequently, the organic phase was separated, washed with saturated saline, and concentrated. A crude product thus obtained was purified by silica gel column chromatography (developing solvent: hexane/ethyl acetate = 60/1) to obtain 4.8 g of a target compound P1-6.

(Synthesis of P-1)

1.9 g (5.7 mmol) of P1-6 was added to a three-neck flask, dissolved in 20 g of acetonitrile, and cooled to 0°C. Next, 0.85 g (5.7 mmol) of NaI was added to the three-neck flask, and the mixture was heated to an internal temperature of 40°C and stirred for one hour. Subsequently, after adjusting the internal temperature to room temperature (25°C), 50 g of methylene chloride and 50 g of water were added to the reaction solution in the three-neck flask, 1.96 g (5.7 mmol) of triphenisulfonium bromide (TPS-Br) was added thereto, and the mixture was further stirred for 2 hours. Then, the organic layer was extracted and washed with 200 g of ion exchange water, and the solvent was evaporated. A crude oily product thus obtained was crystallized from diisopropyl ether to obtain 2.7 g of a target compound (P-1).

The compounds (P-2) to (P-14), the compound (P-X), and the compound (P-Y) which will be described later were synthesized by the same synthesis method as that for the compound (P-1).

Furthermore, the content of the halogen-based solvent in the composition which will be described later was adjusted by changing the number of times of crystallization of the compound (photoacid generator).

[Acid Diffusion Control Agent]

The structures of acid diffusion control agents (Q-1 to Q-7) shown in Tables 2, 4, 6, and 8 are shown below.

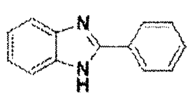

(Q-1)

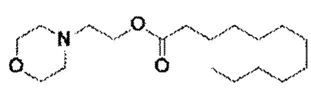

(Q-2)

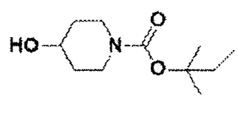

(Q-3)

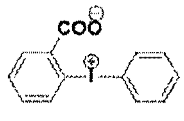

(Q-4)

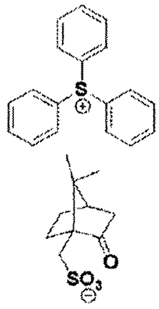

(Q-5)

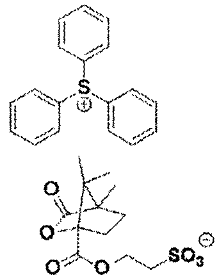

(Q-6)

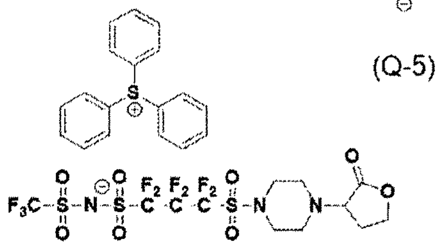

(Q-7)

[Hydrophobic Resin]

The structures of hydrophobic resins (resins E-1 to E-4) shown in Table 2 are shown.

Furthermore, the weight-average molecular weight (Mw) and the dispersity (Mw/Mn) of the hydrophobic resin were measured by GPC (carrier: tetrahydrofuran (THF)) (amount expressed in terms of polystyrene). In addition, the compositional ratio (ratio in % by mole) of the resin was measured by $^{13}$C-NMR.

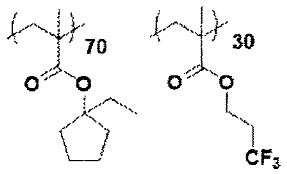

(E-1)

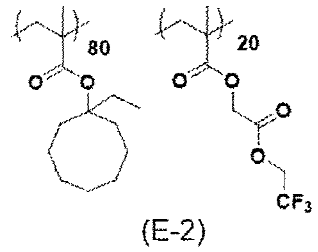

(E-2)

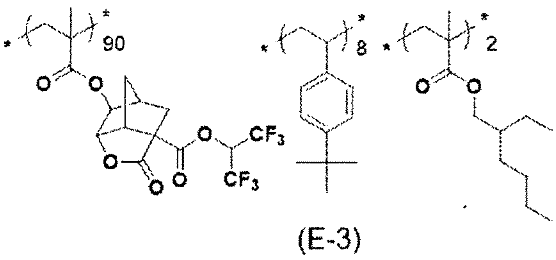

(E-3)

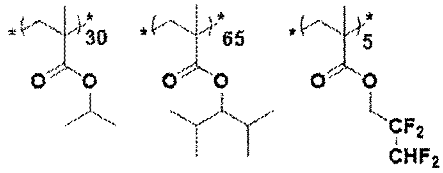

(E-4)

[Solvent]

The solvents shown in Tables 2, 4, 6, and 8 are shown below.

F-1: Propylene glycol monomethyl ether acetate (PGMEA)
F-2: Cyclohexanone
F-3: γ-Butyrolactone
F-4: Propylene glycol monomethyl ether (PGME)
F-5: 2-Heptanone

[Surfactant]

The surfactants shown in Tables 4, 6, and 8 are shown below.

H-1: MEGAFACE F176 (manufactured by DIC Corporation, fluorine-based surfactant)
H-2: MEGAFACE R08 (manufactured by DIC Corporation, fluorine- and silicone-based surfactants)

[Crosslinking Agent]

Crosslinkable groups shown in Table 8 are shown below.

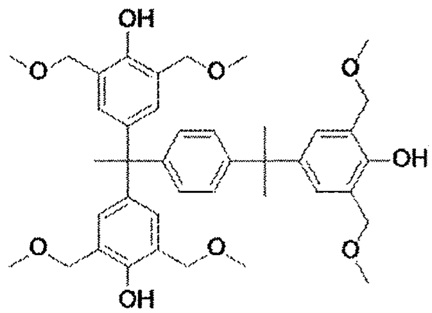

(G-1)

[Preparation of Resist Composition for ArF Exposure and Pattern Formation]

[Preparation of Resist Composition for ArF Exposure]

Various components shown in Table 2 were mixed, and a mixed liquid thus obtained was first filtered through a polyethylene-made filter having a pore diameter of 50 nm, then a nylon-made filter having a pore diameter of 10 nm, and finally a polyethylene-made filter having a pore diameter of 5 nm in this order. Further, an actinic ray-sensitive or radiation-sensitive resin composition (hereinafter also referred to as a resist composition) was prepared by appropriately adjusting the content of the metal atoms by changing the number of cycles as shown in Table 3 while taking the above-mentioned filtration as one cycle. The obtained resist composition was used in Examples and Comparative Examples.

[Table 2-1]

| | Resist composition | | | | | | | | | |
|---|---|---|---|---|---|---|---|---|---|---|
| | Acid-decomposable resin | | Photoacid generator | | Acid diffusion control agent | | Hydrophobic resin | | Solvent | |
| | Type | Content [parts by mass] | Type | Content [parts by mass] | Type | Content [parts by mass] | Type | Content [parts by mass] | Type | Content [parts by mass] |
| Re-1 | A-1 | 100 | P-1 | 6 | Q-1 | 5 | E-1 | 5.5 | F-1/F-2/F-3 | 1,980/850/100 |
| Re-2 | A-2 | 100 | P-2 | 7 | Q-2 | 4 | E-2 | 4 | F-1/F-4/F-5/F-3 | 2,517/190/190/33 |
| Re-3 | A-3 | 100 | P-3 | 12 | Q-3 | 5 | E-3 | 3.5 | F-1 | 2,930 |
| Re-4 | A-4 | 100 | P-4 | 11 | Q-4 | 2 | E-4 | 4 | F-1/F-4/F-5/F-3 | 2,517/190/190/33 |
| Re-5 | A-5 | 100 | P-5 | 5 | Q-1 | 3 | E-1 | 4.5 | F-1/F-5 | 2,730/200 |
| Re-6 | A-6 | 100 | P-6 | 16 | Q-4 | 4 | E-1 | 3 | F-1/F-4/F-5/F-3 | 2,517/190/190/33 |
| Re-7 | A-7 | 100 | P-1 | 6 | Q-5 | 2 | E-1 | 3.5 | F-1/F-2/F-3 | 1,980/850/100 |
| Re-8 | A-8 | 100 | P-6 | 8 | Q-3/Q-6 | 6/4 | E-1 | 6 | F-1/F-4/F-5/F-3 | 2,517/190/190/33 |
| Re-9 | A-9 | 100 | P-7 | 6 | Q-1 | 5 | E-1 | 4 | F-1/F-4/F-5/F-3 | 2,517/190/190/33 |
| Re-10 | A-10 | 100 | P-2 | 8 | Q-4 | 2 | E-1 | 4.5 | F-1/F-5 | 2,730/200 |
| Re-11 | A-11 | 100 | P-3 | 9 | Q-7 | 3 | E-1 | 3.5 | F-1/F-2/F-3 | 1,980/850/100 |

(continued)

| | Resist composition | | | | | | | | | |
|---|---|---|---|---|---|---|---|---|---|---|
| | Acid-decomposable resin | | Photoacid generator | | Acid diffusion control agent | | Hydrophobic resin | | Solvent | |
| | Type | Content [parts by mass] | Type | Content [parts by mass] | Type | Content [parts by mass] | Type | Content [parts by mass] | Type | Content [parts by mass] |
| Re-12 | A-12 | 100 | P-4 | 10 | Q-4 | 4 | E-2 | 3 | F-1/F-4/F-5/F-3 | 2,517/190/190/33 |
| Re-13 | A-13 | 100 | P-5 | 8 | Q-4/Q-5 | 3/3 | E-2 | 4 | F-1/F-2/F-3 | 1,980/850/100 |
| Re-14 | A-14 | 100 | P-1 | 7 | Q-2 | 2 | E-1 | 4.5 | F-1/F-3 | 2,530/400 |
| Re-15 | A-15 | 100 | P-5 | 15 | Q-4 | 6 | E-3 | 3.5 | F-1/F-2/F-3 | 1,980/850/100 |
| Re-16 | A-16 | 100 | P-1 | 12 | Q-1 | 5 | E-4 | 4 | F-1/F-4/F-5/F-3 | 2,517/190/190/33 |
| Re-17 | A-17 | 100 | P-5 | 13 | Q-1 | 4 | E-2 | 4 | F-1/F-4/F-5/F-3 | 2,517/190/190/33 |
| Re-18 | A-18 | 100 | P-1 | 5 | Q-1/Q-5 | 2/1 | E-1/E-2 | 2/2 | F-1/F-4/F-3 | 1,980/850/100 |
| Re-19 | A-19 | 100 | P-3 | 7 | Q-4 | 5 | E-2 | 3 | F-1/F-2 | 2,000/930 |
| Re-20 | A-20 | 100 | P-1/P-8 | 4/1 | Q-4 | 3 | E-1 | 4 | F-1/F-3 | 2,530/400 |
| Re-21 | A-21 | 100 | P-9 | 6 | Q-6 | 2 | E-2 | 4.5 | F-1/F-2/F-3 | 1,980/850/100 |
| Re-22 | A-22 | 100 | P-10 | 14 | Q-2 | 6 | E-1/E-3 | 3/2 | F-1 | 2.930 |
| Re-23 | A-23 | 100 | P-11 | 8 | Q-1/Q-4 | 5/2 | E-4 | 3.5 | F-1/F-4/F-3 | 1,980/850/100 |

[Table 2-2]

| | Resist composition | | | | | | | | | |
|---|---|---|---|---|---|---|---|---|---|---|
| | Acid-decomposable resin | | Photoacid generator | | Acid diffusion control agent | | Hydrophobic resin | | Solvent | |
| | Type | Content [parts by mass] | Type | Content [parts by mass] | Type | Content [parts by mass] | Type | Content [parts by mass] | Type | Content [parts by mass] |
| Re-24 | A-24 | 100 | P-2 | 10 | Q-4 | 4 | E-1 | 4 | F-1/F-2/F-3 | 1,980/850/100 |
| Re-25 | A-25 | 100 | P-6 | 7 | Q-6 | 3 | E-1 | 2.5 | F-1/F-4 | 2,530/400 |
| Re-26 | A-26 | 100 | P-6 | 12 | Q-4 | 5 | E-1 | 2 | F-1/F-4/F-5/F-3 | 2,517/190/190/33 |
| Re-27 | A-27 | 100 | P-12 | 9 | Q-1 | 5 | E-1 | 2.5 | F-1/F-5 | 2,830/100 |
| Re-28 | A-28 | 100 | P-4 | 8 | Q-1/Q-3 | 2/4 | E-1 | 4 | F-1/F-4 | 2,030/900 |
| Re-29 | A-29 | 100 | P-1 | 7 | Q-1 | 3 | E-1 | 2 | F-1/F-3 | 2,530/400 |
| Re-30 | A-30 | 100 | P-1 | 9 | Q-1 | 4 | E-1 | 3.5 | F-1/F-2/F-3 | 1,980/850/100 |
| Re-31 | A-31 | 100 | P-5 | 10 | Q-2 | 5 | E-1 | 4.5 | F-1/F-2/F-4 | 1,980/850/100 |
| Re-32 | A-32 | 100 | P-13 | 13 | Q-1/Q-7 | 1/5 | E-1 | 5.5 | F-1/F-4/F-5/F-3 | 2,517/190/190/33 |
| Re-33 | A-33 | 100 | P-1 | 5 | Q-4 | 3 | E-1 | 2 | F-1/F-3 | 2,830/100 |
| Re-34 | A-34 | 100 | P-3 | 9 | Q-1 | 2 | E-1 | 5 | F-1/F-2 | 1,430/1500 |
| Re-35 | A-35 | 100 | P-6 | 15 | Q-4 | - | E-1 | 3.5 | F-1/F-4/F-3 | 1,980/850/100 |

(continued)

| | Resist composition | | | | | | | | | |
|---|---|---|---|---|---|---|---|---|---|---|
| | Acid-decomposable resin | | Photoacid generator | | Acid diffusion control agent | | Hydrophobic resin | | Solvent | |
| | Type | Content [parts by mass] | Type | Content [parts by mass] | Type | Content [parts by mass] | Type | Content [parts by mass] | Type | Content [parts by mass] |
| Re-36 | A-36 | 100 | P-4 | 20 | Q-3 | 9 | E-1 | 4 | F-1/F-4/F-5/F-3 | 2,517/190/190/33 |
| Re-37 | A-37 | 100 | P-3 | 15 | Q-1 | 7 | E-1 | 3.5 | F-1/F-4 | 2630/300 |
| Re-38 | A-38 | 100 | P-5 | 5 | Q-4 | 2 | E-1 | 4.5 | F-1/F-2/F-3 | 1,980/850/100 |
| Re-39 | A-39 | 100 | P-7 | 12 | Q-1 | 3 | E-4 | 3 | F-1/F-2 | 1,130/1800 |
| Re-40 | A-40 | 100 | P-1 | 8 | Q-3 | 2 | E-3 | 1 | F-1/F4 | 2,030/900 |
| Re-41 | A-1/A-15 | 50/50 | P-4 | 6 | Q-1 | 3 | E-1 | 5.5 | F-1/F-2/F-3 | 1,980/850/100 |
| Re-42 | A-12/A-25 | 50/50 | P-2 | 7 | Q-3 | 2 | E-2 | 3.5 | F-1/F-2 | 1,130/1800 |
| Re-43 | A-30/A-38 | 50/50 | P-4 | 8 | Q-3 | 4 | E-3/E-4 | 3/3 | F-1/F-4 | 2,030/900 |
| Re-44 | A-51 | 100 | P-1 | 6 | Q-1 | 5 | E-1 | 5.5 | F-1/F-2/F-3 | 1,980/850/100 |
| Re-45 | A-1 | 100 | P-X | 6 | Q-1 | 5 | E-1 | 5.5 | F-1/F-2/F-3 | 1,980/850/100 |
| Re-46 | A-51 | 100 | P-X | 6 | Q-1 | 5 | E-1 | 5.5 | F-1/F-2/F-3 | 1,980/850/100 |

[Identification of Content of Halogen-Based Solvent]

The content of the halogen-based solvent in each of the resist compositions of Examples and Comparative Examples was identified by the following method.

First, the solvent was evaporated from a predetermined amount of each of the resist compositions of Examples and Comparative Examples, and dried to obtain a dry solid. At this time, with regard to the solvent to be evaporated (volatile solvent), only the halogenated solvent was isolated by further fractional distillation based on a boiling point, and a mass thereof (mass A) was measured.

Next, the obtained dry solid was dissolved in an electronic grade NMP to prepare a measurement sample, and a mass (mass B) of the halogen-based solvent in the measurement sample was measured using GC System 7890B manufactured by Agilent Technologies, Inc.

The content (% by mass) of the halogen-based solvent with respect to the total mass of the resist composition was determined through conversion from a total amount (the mass A + the mass B) of the halogen-based solvent obtained by each of the measurements.

The detailed conditions for the GC system 7890B manufactured by Agilent Technologies, Inc. are shown below.

Sample: A sample obtained by dissolving 5 g of the dry solid in 20 g of NMP
Column: HP-5 (manufactured by Agilent Technologies, Inc.)
Oven temperature: 40°C (hold 3 min) → (10°C/min) → 240°C (hold 16 min)
Injection port temperature: 150°C
Detector: FID, 250°C
Carrier gas: He, 20 kPa (40°C)
Injection amount: 1 μL

[Identification of Content of Metal Atoms]

The content of the metal atoms in each of the resist compositions of Examples and Comparative Examples was identified by the following method.

Device: Triple quadrupole inductively coupled plasma mass spectrometer (Agilent 8800)
Solvent: Electronic grade N-methylpyrrolidone (NMP)
Carrier gas: Argon gas
Makeup gas: Argon/oxygen mixed gas
Reaction gas: Helium/ammonia mixed gas

The other conditions were set with reference to the description in JP2006-184109A.

[ArF Exposure Pattern Formation and Evaluation]

<Pattern Formation (1): Positive Pattern Formation>

A composition for forming an organic antireflection film, SOC9110D, and a composition for forming an Si-containing antireflection film, HM9825, were applied onto a silicon wafer to form an antireflection film. A resist composition was applied onto the obtained antireflection film and baked (PB: prebaking) at 100°C for 60 seconds to form a resist film having a film thickness of 100 nm.

The obtained wafer was exposed through a 6% halftone mask having a 1:1 line-and-space pattern with a line width of 100 nm by using an ArF excimer laser liquid immersion scanner (manufactured by ASML; XT1700i, NA0.85, Annular, outer sigma 0.9, inner sigma 0.6). Ultrapure water was used as the immersion liquid. Thereafter, the wafer was baked (PEB: post-exposure baking) at 90°C for 60 seconds. Thereafter, the wafer was puddle-developed with an aqueous tetramethylammonium hydroxide solution (2.38% by mass) as a developer for 30 seconds and rinsed with pure water to obtain a 1:1 line-and-space (LS) pattern having a line width of 100 nm.

<Pattern Formation (2): Negative Pattern Formation>

Pattern formation (2) was carried out by the same method as in Pattern Formation (1), except that a negative-tone developer (butyl acetate) was used and then rinsing was performed with methyl isobutyl carbinol (MIBC) to form a pattern.

<Evaluation>

(Measurement of Pattern Line Width)

The obtained line-and-space pattern was observed from the upper part of the pattern with a length-measuring scanning electron microscope (SEM, CG-4100 manufactured by Hitachi, Ltd.), the line width was measured at 50 points, and an average value thereof was defined as a line width of the pattern. Further, the measured value obtained herein is referred to as a "pattern line width after the non-lapse of time".

(Evaluation of Shape after Pattern Formation)

The shape of an LS pattern of the obtained pattern wafer was observed with a cross-sectional SEM (S4800 manufactured by Hitachi, Ltd.), and an angle X (°) formed between the substrate and the pattern was measured (see Fig. 1) and evaluated in accordance with the following evaluation standard.

«Evaluation Standard»

"3": An angle X formed between a substrate 10 and a pattern 12 in the cross-sectional shape is 87° to 93°.
"2": The angle X formed between the substrate 10 and the pattern 12 in the cross-sectional shape is 94° to 100°.
"1": The angle X formed between the substrate 10 and the pattern 12 in the cross-sectional shape is 101° or more.

Furthermore, for practical purposes, the evaluation of "2" or higher is preferable. In a case where the evaluation is "3", the cross-sectional shape of a pattern thus formed is rectangular, which is more preferable.
The results are shown in Table 3 ([B] column in Table 3: "Shape").

(Evaluation of Defects after Pattern Formation)

The obtained pattern wafer was examined with a defect evaluation device UVision 5 manufactured by Applied Materials, Inc., and a defect MAP was created. Thereafter, an image of a defect was acquired using SEMVision G4 (manufactured by Applied Materials, Inc.), and the actual number (pieces) of defects was calculated. Further, the defect generated in the pattern wafer is observed as an image as shown in Figs. 2 and 3, for example.
The results are shown in Table 3 ([C] column in Table 3: "Number (pieces) of defects after pattern formation").

(Evaluation of Shape after Etching)

The resist underlayer film in the obtained pattern wafer was etched under the following etching conditions, using an etching device M8000 manufactured by Hitachi, Ltd. First, an interlayer (a film formed of the composition of an Si-containing antireflection film, HM9825, the film being hereinafter also referred to as an "interlayer HM9825") was processed using the resist upper layer film as a mask under the following etching condition 1, and then a resist underlayer film (a film formed of the composition for forming an organic antireflection film, SOC9110D, the film being hereinafter also referred to as a "resist underlayer film SOC9110D") using the interlayer HM9825 as a mask under an etching condition 2. The shape of the resist underlayer film SOC9110D after processing was observed by a cross-sectional SEM (S4800 manufactured by Hitachi, Ltd.), and evaluation was carried out in accordance with the following evaluation standard.
(Etching Condition 1)
Etching gas: $CF_4$, pressure: 20 mTorr, applied power: 100 mW/$cm^2$
(Etching Condition 2)
Etching gas: $O_2$, pressure: 20 mTorr, applied power: 100 mW/$cm^2$

«Evaluation Standard»

"2": In the cross-sectional shape, a difference between a pattern line width after lithography and a pattern line width

after etching is 10 nm or less
"1": In the cross-sectional shape, a difference between a pattern line width after lithography and a pattern line width after etching is more than 10 nm (the line width is greatly reduced by etching).

The results are shown in Table 3 ([D] column in Table 3: "Shape after etching").

(Defect Performance after Etching)

The pattern wafer after etching obtained by the above-mentioned procedure was examined with a defect evaluation device UVision 5 manufactured by Applied Materials, Inc., and a defect MAP was created. Thereafter, an image of a defect was acquired using SEMVision G4 (manufactured by Applied Materials, Inc.), and the actual number (pieces) of defects was calculated. Further, the defect generated in the pattern wafer is observed as an image as shown in Figs. 2 and 3, for example.
The results are shown in Table 3 ([E] column in Table 3: "Number (pieces) of defects after etching").

(Evaluation of Temporal Stability of Resist composition)

<<Change in Pattern Line Width after Storage of Resist Composition over Time>>

After storing each of the resist compositions of Examples and Comparative Examples at 40°C for one month, a 1:1 line-and-space pattern having a line width of 100 nm was used according to the above-mentioned Pattern Formation (1) or Pattern Forming Method (2) (see Table 3). Next, the obtained line-and-space pattern was observed from the upper part of the pattern with a length-measuring scanning electron microscope (SEM, CG-4100 manufactured by Hitachi, Ltd.), the line width was measured at 50 points, and an average value thereof was defined as a line width of the pattern. Further, the measured value obtained herein is referred to as a "pattern line width after the elapse of time".
The temporal stability of the resist composition was evaluated based on the value of a change in the pattern line width obtained by Equation (1).

Equation (1):

$$\text{Value (nm) of change in pattern line width} = |(\text{Pattern line width (nm) after lapse of time}) - (\text{Pattern line width (nm)}) \text{ after non-lapse of time}|$$

The results are shown in Table 3 ([G] column in Table 3: "Change (nm) in line width after lapse of one month").

<<Evaluation of Defects after Pattern Formation after Storage of Resist Composition over Time>>

A pattern wafer formed by each of the resist compositions of Examples and Comparative Examples after being stored at 40°C for one month was inspected with a defect evaluation device UVision 5 manufactured by Applied Materials, Inc., and thus, a defect MAP was created. Thereafter, an image of a defect was acquired using SEMVision G4 (manufactured by Applied Materials, Inc.), and the actual number of defects was calculated. Further, the defect generated in the pattern wafer is observed as an image as shown in Figs. 2 and 3, for example.
The results are shown in Table 3 ([H] column in Table 3: "Number (pieces) of defects after lapse of one month").
Table 3 is shown below.
In the "Content of halogen-based solvent" column in Table 3, "Number of times of crystallization of compound" is intended to be the number of purification steps by crystallization during the synthesis of the compound (photoacid generator). In addition, "Content" is intended to be the content of the halogen-based solvent with respect to the total mass of the resist composition.
Furthermore, it is confirmed that halogen-based solvents other than methylene chloride are present at a detection limit value or less.
In Table 3, in the "Content of metal atoms" column, "Number of times of filtration" is intended to be the "number of cycles" in a case where filtration through a polyethylene-made filter having a pore diameter of 50 nm at first, then through a nylon-made filter having a pore diameter of 10 nm, and finally through a polyethylene-made filter having a pore diameter of 5 nm in this order is taken as one cycle. In addition, "Content" is intended to be the content of the metal atoms with respect to the total mass of the resist composition.
[A] column in Table 3: This column indicates which of the pattern forming method (1) or (2) was carried out to form a pattern, with regard to a pattern forming method.

The [B] to [E], [G], and [H] columns in Table 3 show the results of the above-mentioned evaluation method.

The [F] column in Table 3 corresponds to a value obtained by subtracting the number (pieces) of defects after pattern formation shown in the [C] column from the number (pieces) of defects after etching shown in the [E] column.

The [I] column in Table 3 corresponds to a value obtained by subtracting the number (pieces) of defects after pattern formation shown in the [C] column from the number (pieces) of defects after the lapse of one month in the [H] column.

In Table 3, in the "Content of halogen-based solvent" column and the "Content of metal atoms" column, ppt, ppb, and ppm are all based on mass.

Furthermore, the content (% by mass) of the halogen-based solvent with respect to the total mass of each of resist compositions shown in Table 3 and the content (% by mass) of the halogen-based solvent with respect to the total mass of the film in the pre-baked (PB) resist film formed by each of the resist compositions were compared, and the content of the halogen-based solvent with respect to the total mass of the film in the resist film was an amount of 20% to 100% of the content of the halogen-based solvent with respect to the total mass of the composition in the resist composition.

[Table 3-1]

| | Resist composition | Content of halogen-based solven | | Content of metal a oms | | Pattern forming method [A] | Shape [B] | Number [pieces] of defects after pattern formation [C] | Shape after etching [D] | Number [pieces] of defects after etching [E] | Difference [pieces] in number of defects between before and after etching [F] ([E] - [C]) | Change [nm] in line width after lapse of one month [G] | Number [pieces] of defects after lapse of one month [H] | Deterioration number [pieces] of defects over time [I] ([H] - [C]) |
|---|---|---|---|---|---|---|---|---|---|---|---|---|---|---|
| | | Number of times of crystallization of compound (photoacid generator) | Content | Number of times of filtration | Content | | | | | | | | | |
| Example 1 | Re-1 | 1 | 32 ppm | 3 | 128 ppt | (1) | 3 | 121 | 2 | 263 | 142 | 3.2 nm | 2,709 | 2,588 |
| Example 2 | Re-1 | 2 | 8 ppm | 3 | 128 ppt | (1) | 3 | 130 | 2 | 286 | 156 | 1.3 nm | 789 | 659 |
| Example 3 | Re-1 | 3 | 360 ppb | 3 | 128 ppt | (1) | 3 | 137 | 2 | 237 | 100 | < 1 nm | 282 | 145 |
| Example 4 | Re-1 | 3 | 346 ppb | 5 | 0.5 ppt | (1) | 3 | 186 | 1 | 2857 | 2,671 | < 1 nm | 378 | 192 |
| Example 5 | Re-1 | 3 | 245 ppb | 2 | 2 ppb | (1) | 3 | 230 | 2 | 580 | 350 | < 1 nm | 350 | 120 |
| Example 6 | Re-1 | 3 | 456 ppb | 1 | 28 ppb | (1) | 3 | 775 | 2 | 2,625 | 1,850 | < 1 nm | 911 | 136 |
| Example 7 | Re-2 | 3 | 421 ppb | 3 | 580 ppt | (1) | 3 | 175 | 2 | 377 | 202 | < 1 nm | 275 | 100 |
| Example 8 | Re-3 | 3 | 184 ppb | 3 | 220 ppt | (1) | 3 | 154 | 2 | 327 | 173 | < 1 nm | 183 | 29 |
| Example 9 | Re-4 | 3 | 248 ppb | 3 | 350 ppt | (1) | 3 | 160 | 2 | 340 | 180 | < 1 nm | 208 | 48 |
| Example 10 | Re-5 | 3 | 356 ppb | 3 | 12 ppb | (1) | 3 | 538 | 2 | 1,744 | 1,206 | < 1 nm | 715 | 177 |
| Example 11 | Re-6 | 2 | 5 ppm | 3 | 50 ppt | (2) | 3 | 50 | 2 | 88 | 38 | 2.5 nm | 572 | 522 |

(continued)

| | Resist composition | Content of halogen-based solven | | Content of metal a oms | | Pattern forming method [A] | Shape [B] | Number [pieces] of defects after pattern formation [C] | Shape after etching [D] | Number [pieces] of defects after etching [E] | Difference [pieces] in number of defects between before and after etching [F] ([E] - [C]) | Change [nm] in line width after lapse of one month [G] | Number [pieces] of defects after lapse of one month [H] | Deterioration number [pieces] of defects over time [I] ([H] - [C]) |
|---|---|---|---|---|---|---|---|---|---|---|---|---|---|---|
| | | Number of times of crystallization of compound (photoacid generator) | Content | Number of times of filtration | Content | | | | | | | | | |
| Example 12 | Re-6 | 2 | 5 ppm | 1 | 15 ppb | (2) | 3 | 620 | 2 | 2,070 | 1,450 | 2.4 nm | 1,221 | 601 |
| Example 13 | Re-6 | 3 | 213 ppb | 3 | 50 ppt | (2) | 3 | 54 | 2 | 108 | 54 | < 1 nm | 183 | 129 |
| Example 14 | Re-7 | 3 | 278 ppb | 3 | 608 ppt | (2) | 3 | 187 | 2 | 433 | 246 | < 1 nm | 473 | 286 |
| Example 15 | Re-8 | 3 | 358 ppb | 3 | 98 ppt | (2) | 3 | 64 | 2 | 184 | 120 | < 1 nm | 263 | 199 |
| Example 16 | Re-9 | 3 | 120 ppb | 3 | 580 ppt | (2) | 3 | 189 | 2 | 432 | 243 | < 1 nm | 374 | 185 |
| Example 17 | Re-10 | 3 | 240 ppb | 3 | 792 ppt | (2) | 3 | 198 | 2 | 483 | 285 | <1 nm | 431 | 233 |
| Example 18 | Re-11 | 3 | 678 ppb | 3 | 5 ppb | (2) | 3 | 320 | 2 | 1,025 | 705 | < 1 nm | 615 | 295 |
| Example 19 | Re-12 | 1 | 22 ppm | 3 | 201 ppt | (1) | 3 | 157 | 2 | 300 | 143 | 3.4 nm | 2,555 | 2,398 |
| Example 20 | Re-12 | 1 | 31 ppm | 1 | 18 ppb | (1) | 3 | 655 | 2 | 2,379 | 1.724 | 4.0 nm | 2,932 | 2.277 |

[Table 3-2]

| | Resist composition | Content of halogen-based solvent | | Content of metal atoms | | Pattern forming method [A] | Shape [B] | Number [pieces] of defects after pattern formation [C] | Shape after etching [D] | Number [pieces] of defects after etching [E] | Difference [pieces] in number of defects between before and after etching [F] ([E] - [C]) | Change [nm] in line width after lapse of one month [G] | Number [pieces] of defects after lapse of one month [H] | Deterioration number [pieces] of defects over time [I] ([H] - [C]) |
|---|---|---|---|---|---|---|---|---|---|---|---|---|---|---|
| | | Number of times of crystallization of compound (photoacid generator) | Content | Number of times of filtration | Content | | | | | | | | | |
| Example 21 | Re-12 | 3 | 546 ppb | 3 | 201 ppt | (1) | 3 | 153 | 2 | 307 | 154 | < 1 nm | 352 | 199 |
| Example 22 | Re-13 | 3 | 214 ppb | 3 | 346 ppt | (1) | 3 | 157 | 2 | 340 | 183 | < 1 nm | 277 | 120 |
| Example 23 | Re-14 | 3 | 123 ppb | 3 | 32 ppt | (1) | 3 | 32 | 2 | 87 | 55 | < 1 nm | 67 | 35 |
| Example 24 | Re-15 | 3 | 451 ppb | 3 | 505 ppt | (1) | 3 | 188 | 2 | 445 | 257 | < 1 nm | 381 | 193 |
| Example 25 | Re-16 | 1 | 48 ppm | 3 | 78 ppt | (2) | 3 | 58 | 2 | 147 | 89 | 4.6 nm | 4,059 | 4,001 |
| Example 26 | Re-16 | 2 | 3 ppm | 3 | 78 ppt | (2) | 3 | 43 | 2 | 115 | 72 | 2.7 nm | 927 | 884 |
| Example 27 | Re-16 | 3 | 46 ppb | 3 | 78 ppt | (2) | 3 | 40 | 2 | 110 | 70 | < 1 nm | 64 | 24 |
| Example 28 | Re-16 | 3 | 61 ppb | 2 | 4 ppb | (2) | 3 | 279 | 2 | 899 | 620 | < 1 nm | 338 | 59 |
| Example 29 | Re-16 | 3 | 169 ppb | 1 | 13 ppb | (2) | 3 | 557 | 2 | 1,862 | 1,305 | < 1 nm | 685 | 128 |
| Example 30 | Re-17 | 3 | 456 ppb | 3 | 18 ppb | (2) | 3 | 720 | 2 | 2,500 | 1,780 | < 1 nm | 1,004 | 284 |
| Example 31 | Re-18 | 3 | 432 ppb | 3 | 9 ppb | (2) | 3 | 478 | 2 | 1,320 | 842 | < 1 nm | 763 | 285 |

(continued)

| | Resist composition | Content of halogen-based solvent | | Content of metal atoms | | Pattern forming method [A] | Shape [B] | Number [pieces] of defects after pattern formation [C] | Shape after etching [D] | Number [pieces] of defects after etching [E] | Difference [pieces] in number of defects between before and after etching [F] ([E] - [C]) | Change [nm] in line width after lapse of one month [G] | Number [pieces] of defects after lapse of one month [H] | Deterioration number [pieces] of defects over time [I] ([H] - [C]) |
|---|---|---|---|---|---|---|---|---|---|---|---|---|---|---|
| | | Number of times of crystallization of compound (photoacid generator) | Content | Number of times of filtration | Content | | | | | | | | | |
| Example 32 | Re-19 | 3 | 512 ppb | 3 | 189 ppt | (2) | 3 | 136 | 2 | 268 | 132 | <1 nm | 239 | 103 |
| Example 33 | Re-20 | 3 | 247 ppb | 3 | 14 ppb | (1) | 3 | 504 | 2 | 1,971 | 1,467 | < 1 nm | 687 | 183 |
| Example 34 | Re-21 | 3 | 340 ppb | 3 | 26 ppb | (1) | 3 | 864 | 2 | 2,797 | 1,933 | < 1 nm | 1,102 | 238 |
| Example 35 | Re-22 | 3 | 451 ppb | 3 | 2 ppb | (1) | 3 | 264 | 2 | 620 | 356 | < 1 nm | 529 | 265 |
| Example 36 | Re-23 | 3 | 412 ppb | 3 | 6 ppb | (1) | 3 | 389 | 2 | 1,033 | 644 | <1 nm | 673 | 284 |
| Example 37 | Re-24 | 3 | 258 ppb | 3 | 11 ppb | (1) | 3 | 548 | 2 | 1,598 | 1,050 | < 1 nm | 785 | 237 |
| Example 38 | Re-25 | 3 | 421 ppb | 3 | 863 ppt | (1) | 3 | 194 | 2 | 483 | 289 | < 1 nm | 449 | 255 |
| Example 39 | Re-26 | 3 | 356 ppb | 3 | 21 ppb | (1) | 3 | 845 | 2 | 2,528 | 1,683 | < 1 nm | 1,139 | 294 |
| Example 40 | Re-27 | 3 | 512 ppb | 3 | 18 ppb | (1) | 3 | 694 | 2 | 2,193 | 1,499 | < 1 nm | 947 | 253 |

[Table 3-3]

| | Resist composition | Content of halogen-based solvent | | Content of metal atoms | | Pattern forming method [A] | Shape [B] | Number [pieces] of defects after pattern formation [C] | Shape after etching [D] | Number [pieces] of defects after etching [E] | Difference [pieces] in number of defects between before and after etching [F] ([E] - [C]) | Change [nm] in line width after lapse of one month [G] | Number [pieces] of defects after lapse of one month [H] | Deterioration number [pieces] of defects over time [I] ([H] - [C]) |
|---|---|---|---|---|---|---|---|---|---|---|---|---|---|---|
| | | Number of times of crystallization of compound (photoacid generator) | Content | Number of times of filtration | Content | | | | | | | | | |
| Example 41 | Re-28 | 3 | 426 ppb | 3 | 28 ppb | (1) | 3 | 903 | 2 | 2.770 | 1,867 | < 1 nm | 1,188 | 285 |
| Example 42 | Re-29 | 3 | 417 ppb | 3 | 13 ppb | (1) | 3 | 536 | 2 | 1,736 | 1,200 | < 1 nm | 779 | 243 |
| Example 43 | Re-30 | 3 | 235 ppb | 3 | 24 ppb | (1) | 3 | 754 | 2 | 2,502 | 1,748 | < 1 nm | 976 | 222 |
| Example 44 | Re-31 | 3 | 258 ppb | 3 | 16 ppb | (1) | 3 | 600 | 2 | 2,105 | 1,505 | < 1 nm | 857 | 257 |
| Example 45 | Re-32 | 3 | 222 ppb | 3 | 15 ppb | (1) | 3 | 536 | 2 | 2,036 | 1,500 | < 1 nm | 773 | 237 |
| Example 46 | Re-33 | 3 | 169 ppb | 3 | 5 ppb | (1) | 3 | 388 | 2 | 1,080 | 692 | < 1 nm | 622 | 234 |
| Example 47 | Re-34 | 3 | 487 ppb | 3 | 11 ppb | (1) | 3 | 502 | 2 | 1,504 | 1,002 | < 1 nm | 773 | 271 |
| Example 48 | Re-35 | 3 | 287 ppb | 3 | 21 ppb | (1) | 3 | 812 | 2 | 2,502 | 1,690 | < 1 nm | 1,104 | 292 |
| Example 49 | Re-36 | 3 | 265 ppb | 3 | 17 ppb | (1) | 3 | 603 | 2 | 2,012 | 1.409 | < 1 nm | 876 | 273 |
| Example 50 | Re-37 | 3 | 354 ppb | 3 | 29 ppb | (1) | 3 | 966 | 2 | 2,52 | 1,986 | < 1 nm | 1,229 | 263 |
| Example 51 | Re-38 | 3 | 154 ppb | 3 | 8 ppb | (1) | 3 | 483 | 2 | 1.284 | 801 | < 1 nm | 716 | 233 |
| Example 52 | Re-39 | 3 | 46 ppb | 3 | 560 ppt | (1) | 3 | 163 | 2 | 449 | 286 | < 1 nm | 321 | 158 |
| Example 53 | Re-40 | 3 | 58 ppb | 3 | 782 ppt | (1) | 3 | 178 | 2 | 455 | 277 | < 1 nm | 325 | 147 |
| Example 54 | Re-41 | 3 | 146 ppb | 3 | 985 ppt | (1) | 3 | 199 | 2 | 484 | 285 | < 1 nm | 493 | 294 |
| Example 55 | Re-42 | 3 | 356 opb | 3 | 712 ppt | (1) | 3 | 175 | 2 | 428 | 253 | < 1 nm | 410 | 235 |
| Example 56 | Re-43 | 3 | 288 ppb | 3 | 2 ppb | (1) | 3 | 234 | 2 | 555 | 321 | < 1 nm | 511 | 277 |
| Example 57 | Re-44 | 1 | 38 ppm | 3 | 58 ppb | (1) | 3 | 1,480 | 2 | 4,285 | 2,805 | 4.2 nm | 4,028 | 2,548 |
| Example 58 | Re-44 | 3 | 458 ppb | 3 | 58 ppb | (1) | 3 | 1,277 | 2 | 5,127 | 3,850 | < 1 nm | 1,565 | 288 |
| Comparative Example 1 | Re-1 | 0 | 98 ppm | 3 | 128 ppt | (1) | 3 | 143 | 2 | 285 | 142 | 11 nm | 15,366 | 15,223 |

(continued)

| | Resist composition | Content of halogen-based solvent | | Content of metal atoms | | Pattern forming method [A] | Shape [B] | Number [pieces] of defects after pattern formation [C] | Shape after etching [D] | Number [pieces] of defects after etching [E] | Difference [pieces] in number of defects between before and after etching [F] ([E] - [C]) | Change [nm] in line width after lapse of one month [G] | Number [pieces] of defects after lapse of one month [H] | Deterioration number [pieces] of defects over time [I] ([H] - [C]) |
|---|---|---|---|---|---|---|---|---|---|---|---|---|---|---|
| | | Number of times of crystallization of compound (photoacid generator) | Content | Number of times of filtration | Content | | | | | | | | | |
| Comparative Example 2 | Re-1 | 5 | 320 ppt | 3 | 128 ppt | (1) | 1 | 807 | 1 | 8,249 | 7,442 | 2.8 nm | 1,307 | 500 |
| Comparative Example 3 | Re-45 | 3 | 132 ppm | 3 | 146 ppt | (1) | 3 | 155 | 2 | 414 | 259 | 12 nm | 17,545 | 17,390 |
| Comparative Example 4 | Re-46 | 3 | 124 ppm | 3 | 60 ppb | (1) | 3 | 1,544 | 1 | 10,101 | 8,557 | 12 nm | 20,882 | 19,338 |

From the results of Table 3, it is clear that the resist compositions of Examples have excellent rectangularity in the cross-sectional shape of a pattern thus formed ("Shape": see [B column]), and a dimensional variation of the line width of a pattern thus formed hardly occurs even in a case where the resist composition is used after the lapse of time from the preparation thereof ("Change in line width after lapse of one month": see [G column]). Further, according to the resist compositions of Examples, it is clear that the number of defects deteriorated over time (see [I column]) can be reduced.

In addition, from the results in Table 3, in a case where the content of the halogen-based solvent in the resist composition is from 1 ppb by mass to 10 ppm by mass (preferably a case where the content is from 1 ppb by mass to 1 ppm by mass) with respect to the total mass of the composition, it is clear that the change in line width after the lapse of one month (see [G column]) and the number of defect deteriorations with time (see [I column]) can be further reduced.

In addition, from the results in Table 3, it is clear that in a case where the resist composition includes metal atoms and the content of the metal atoms is from 1 ppt by mass to 30 ppb by mass (preferably from 1 ppt by mass to 10 ppt by mass, more preferably from 1 ppt by mass to 1,000 ppt by mass, and particularly preferably from 1 ppt by mass to 500 ppt by mass) with respect to the total mass of the composition, a pattern thus formed has excellent etching resistance (see [D column]) and defects are hardly generated in a silicon wafer etched using the pattern as a mask (see [F column]).

From the results of Table 3, it is clear that the resist compositions of Comparative Examples do not satisfy desired requirements.

[Preparation of Resist Composition for KrF Exposure and Pattern Formation]

[Preparation of Resist Composition for KrF Exposure]

<Preparation of Resist Composition Re-101>

Various components shown in Table 4 were mixed, and a mixed liquid thus obtained was first filtered through a polyethylene-made filter having a pore diameter of 50 nm, then a nylon-made filter having a pore diameter of 10 nm, and finally a polyethylene-made filter having a pore diameter of 5 nm in this order. Further, a resist composition Re-101 was prepared by appropriately adjusting the content of the metal atoms by performing the number of cycles shown in Table 5 while taking the above-mentioned filtration as one cycle.

<Preparation of Resist Composition Re-102>

Various components shown in Table 4 were mixed and a mixed liquid thus obtained was then filtered through a polyethylene-made filter having a pore diameter of 0.1 μm. Further, a resist composition Re-102 was prepared by performing the above-mentioned filtration as many times as shown in Table 3 to appropriately adjust the content of the metal atoms.

<Preparation of Resist Compositions Re-103 to Re-107>

Various components shown in Table 4 were mixed and a mixed liquid thus obtained was then filtered through a polyethylene-made filter having a pore diameter of 0.1 μm. Further, resist compositions Re-103 to Re-107 were prepared by performing the above-mentioned filtration as many times as shown in Table 3 to appropriately adjust the content of the metal atoms.

[Table 4]

| | Resist composition | | | | | | | | | |
|---|---|---|---|---|---|---|---|---|---|---|
| | Acid-decomposable resin | | Photoacid generator | | Acid diffusion control agent | | Surfactant | | Solvent | |
| | Type | Content [parts by mass] | Type | Content [parts by mass] | Type | Content [parts by mass] | Type | Content [parts by mass] | Type | Content [parts by mass] |
| Re-101 | A-41 | 100 | P-8 | 6 | Q-1 | 5 | H-1 | 0.2 | F-1/F-2/F-3 | 1,980/850/100 |
| Re-102 | A-42 | 100 | P-14 | 4 | Q-2 | 4 | H-1 | 0.2 | F-1/F-4 | 2,530/400 |
| Re-103 | A-43 | 100 | P-9 | 5 | Q-3 | 5 | H-2 | 0.2 | F-1 | 2,930 |
| Re-104 | A-44 | 100 | P-14 | 7 | Q-4 | 2 | H-2 | 0.2 | F-1/F-3 | 2,530/400 |
| Re-105 | A-47 | 100 | P-2 | 8 | Q-3 | 4 | H-1 | 0.2 | F-1/F-4/F-5/F-3 | 2,517/190/190/33 |
| Re-106 | A-49 | 100 | P-8/P-9 | 1/5 | Q-3 | 6 | H-1 | 0.2 | F-1/F-2 | 2,000/930 |
| Re-107 | A-41 | 100 | P-Y | 5 | Q-1 | 5 | H-1 | 0.2 | F-1/F-2/F-3 | 1,980/850/100 |

[Identification of Content of Halogen-Based Solvent]

The content of the halogen-based solvent in Examples and Comparative Examples was identified by the same method as in Example 1 described above. The results are shown in Table 5.

[Identification of Content of Metal Atoms]

The content of the metal atoms in Examples and Comparative Examples was identified by the same method as in Example 1 described above. The results are shown in Table 5.

[KrF Exposure Pattern Formation and Evaluation]

<Pattern Formation (3): Positive Pattern Formation>

The prepared resist composition was applied onto an Si substrate (manufactured by Advanced Materials Technology), which had been subjected to a hexamethyldisilazane treatment, using a spin coater "ACT-8" manufactured by Tokyo Electron Limited, while not being provided with an antireflection layer, and pre-baked (PB) at 130°C for 60 seconds to form a positive-tone resist film having a film thickness of 3 $\mu$m.

This resist film was subjected to pattern exposure under an exposure condition of numerical aperture (NA) = 0.68 and $\sigma$ = 0.60 through a mask having a line-and-space pattern such that a space pattern was 250 nm and a line pattern was 1 $\mu$m after the reduction projection exposure, using a KrF excimer laser scanner (manufactured by ASML, PAS5500/850C wavelength 248 nm). After the irradiation, the film was post-exposure baked (PEB) at 130°C for 60 seconds, immersed using a 2.38%-by-mass aqueous tetramethylammonium hydroxide (TMAH) solution for 60 seconds, then rinsed with water for 30 seconds, and dried.

(Evaluation)

The shape after pattern formation ([B] column), the number (pieces) of defects after pattern formation ([C] column), and the change (nm) in the line width after the lapse of one month ([G] column) were evaluated by the same method as for the ArF exposure.

<Pattern Formation (4): Positive Pattern Formation>

A positive-tone resist film with a film thickness of 400 nm was formed by uniform application onto a substrate coated with a 60-nm antireflection film (DUV42 manufactured by Brewer Science, Inc.) using a spin coater Mark8 manufactured by Tokyo Electron Limited, and pre-baked (PB) at 130°C for 60 seconds.

A line-and-space pattern was formed on this resist film using a 150-nm LS mask under an exposure condition of NA = 0.68 and $\sigma$ = 0.60, using a KrF excimer laser scanner (manufactured by ASML, PAS5500/850C wavelength 248 nm). After the irradiation, the film was post-exposure baked (PEB) at 130°C for 60 seconds, immersed using a 2.38%-by-mass aqueous tetramethylammonium hydroxide (TMAH) solution for 60 seconds, then rinsed with water for 30 seconds, and dried to obtain an LS pattern of a 150-nm LS.

(Evaluation)

The shape after pattern formation ([B] column), the number (pieces) of defects after pattern formation ([C] column), "Shape after etching" ([D] column), "Number (pieces) of defects after etching" ([E] column), "Change (nm) in line width after lapse of one month" ([G] column), and "Number (pieces) of defects after lapse of one month" ([H] column) were evaluated by the same method as for the ArF exposure. It should be noted that Complus manufactured by SOKUDO Ltd. was used as a defect evaluation device, and SEMVision G3 (manufactured by Applied Materials, Inc.) was used as a review device. In addition, a parallel plate type reactive ion etching device DES-245R manufactured by Plasma System Co. was used as an etching device, and a pattern after etching was obtained under the above-mentioned etching condition 2.

<Pattern Formation (5): Positive Pattern Formation>

The prepared resist composition was applied onto an Si substrate (manufactured by Advanced Materials Technology), which had been subjected to a hexamethyldisilazane treatment, using a spin coater "ACT-8" manufactured by Tokyo Electron Limited, while not being provided with an antireflection layer, and pre-baked (PB) at 130°C for 60 seconds

to form a positive-tone resist film having a film thickness of 10 μm.

This resist film was subjected to pattern exposure under an exposure condition of NA (numerical aperture) = 0.68 and σ = 0.60 through a mask having a line-and-space pattern such that a space pattern was 3 μm and a pitch was 33 μm after the reduction projection exposure, using a KrF excimer laser scanner (manufactured by ASML, PAS5500/850C wavelength 248 nm). After the irradiation, the film was post-exposure baked (PEB) at 130°C for 60 seconds, immersed using a 2.38%-by-mass aqueous tetramethylammonium hydroxide (TMAH) solution for 60 seconds, then rinsed with water for 30 seconds, and dried.

(Evaluation)

The shape after pattern formation ([B] column), the number (pieces) of defects after pattern formation ([C] column), and the change (nm) in the line width after the lapse of one month ([G] column) were evaluated by the same method as for the ArF exposure.

Table 5 is shown below.

In the "Content of halogen-based solvent" column in Table 5, "Number of times of crystallization of compound" is intended to be the number of purification steps by crystallization during the synthesis of the compound (photoacid generator). In addition, "Content" is intended to be the content of the halogen-based solvent with respect to the total mass of the resist composition.

Furthermore, it is confirmed that halogen-based solvents other than methylene chloride are present at a detection limit value or less.

In Table 5, in the "Content of metal atoms" column, "Number of times of filtration" is intended to be Number of cycles in a case where filtration through a polyethylene-made filter having a pore diameter of 50 nm at first, then through a nylon-made filter having a pore diameter of 10 nm, and finally through a polyethylene-made filter having a pore diameter of 5 nm in this order is taken as one cycle, for the resist composition Re-101; and "Number of times of filtration" is intended to be number of times of filtration, the filtration being performed through a polyethylene-made filter having a pore diameter of 0.1 μm, for the resist compositions Re-102 to Re-107. In addition, "Content" is intended to be the content of the metal atoms with respect to the total mass of the resist composition.

[A] column in Table 5: Indicates which of the pattern forming methods (3) to (5) was carried out to form a pattern, with regard to a pattern forming method.

The [B] to [I] columns in Table 5 have the same definitions as for the evaluation performed at the time of ArF exposure, and specific evaluation methods thereof are as described above.

"-" in Table 5 is intended to be not measured.

In Table 5, in the "Content of halogen-based solvent" column and the "Content of metal atoms" column, ppt, ppb, and ppm are all based on mass.

Furthermore, the content (% by mass) of the halogen-based solvent with respect to the total mass of each of resist compositions shown in Table 5 and the content (% by mass) of the halogen-based solvent with respect to the total mass of the film in the pre-baked (PB) resist film formed by each of the resist compositions were compared, and the content of the halogen-based solvent with respect to the total mass of the film in the resist film was an amount of 60% to 100% of the content of the halogen-based solvent with respect to the total mass of the composition in the resist composition.

[Table 5]

| | Resist composition | Content of halogen-based solvent | | Content of metal atoms | | Pattern forming method [A] | Shape [B] | Number [pieces] of defects after pattern formation [C] | Shape after etching [D] | Number [pieces] of defects after etching [E] | Difference [pieces] in number of defects between before and after etching [F] ([E] - [C]) | Change [nm] in line width after lapse of one month [G] | Number [pieces] of defects after lapse of one month [H] | Deterioration number [pieces] of defects over time [I] ([H] - [C]) |
|---|---|---|---|---|---|---|---|---|---|---|---|---|---|---|
| | | Number of times of crystallization of compound (photoacid generator) | Content | Number of times of filtration | Content | | | | | | | | | |
| Example 101 | Re-101 | 3 | 46 ppb | 3 | 860 ppt | (4) | 2 | 198 | 2 | 456 | 258 | < 1 nm | 286 | 88 |
| Example 102 | Re-102 | 3 | 215 ppb | 3 | 21 ppb | (5) | 2 | 789 | - | - | - | < 1 nm | - | - |
| Example 103 | Re-103 | 3 | 351 ppb | 3 | 9 ppb | (3) | 2 | 480 | - | - | - | < 1 nm | - | - |
| Example 104 | Re-104 | 3 | 178 ppb | 3 | 16 ppb | (3) | 2 | 654 | - | - | - | < 1 nm | - | - |
| Example 105 | Re-105 | 3 | 442 ppb | 3 | 19 ppb | (3) | 2 | 668 | - | - | - | < 1 nm | - | - |
| Example 106 | Re-106 | 3 | 316 ppb | 3 | 12 ppb | (3) | 2 | 523 | - | - | - | < 1 nm | - | - |
| Comparative Example 101 | Re-107 | 3 | 102 ppm | 3 | 978 ppt | (3) | 2 | 185 | - | - | - | 15 nm | - | - |

From the results of Table 5, it is clear that the rectangularity in the cross-sectional shape of a pattern formed with the resist compositions of Examples is excellent ("Shape": see [B column]), and a dimensional variation of the line width of the pattern thus formed is less likely to occur even in a case where the resist composition is used after the lapse of time from the preparation thereof ("Change in line width after lapse of one month": see [G column]).

From the results of Table 5, it is clear that the resist compositions of Comparative Examples do not satisfy desired requirements.

[Preparation of Resist Composition for EUV Exposure and Pattern Formation]

[Preparation of Resist Composition for EUV Exposure]

<Preparation of Resist Compositions Re-201 to Re-203>

Various components shown in Table 6 were mixed, and a mixed liquid thus obtained was first filtered through a polyethylene-made filter having a pore diameter of 50 nm, a nylon-made filter having a pore diameter of 10 nm, and finally a polyethylene-made filter having a pore diameter of 5 nm in this order. Further, resist compositions Re-201 to Re-203 were prepared by adjusting the number of times of filtration described above to appropriately adjust the content of the metal atoms.

[Table 6]

| | Resist composition | | | | | | | | | |
|---|---|---|---|---|---|---|---|---|---|---|
| | Acid-decomposable resin | | Photoacid generator | | Acid diffusion control agent | | Surfactant | | Solvent | |
| | Type | Content [parts by mass] | Type | Content [parts by mass] | Type | Content [parts by mass] | Type | Content [parts by mass] | Type | Content [parts by mass] |
| Re-201 | A-48 | 100 | P-7 | 15 | Q-1 | 2 | H-1 | 0.2 | F-1/F-4 | 2,530/400 |
| Re-202 | A-50 | 100 | P-12 | 15 | Q-4 | 1 | H-1 | 0.2 | F-1/F-4 | 2,530/400 |
| Re-203 | A-48 | 100 | P-X | 15 | Q-1 | 2 | H-1 | 0.2 | F-1/F-4 | 2,530/400 |

[Identification of Content of Halogen-Based Solvent]

The content of the halogen-based solvent in Examples and Comparative Examples was identified by the same method as in Example 1 described above. The results are shown in Table 7.

[Identification of Content of Metal Atoms]

The content of the metal atoms in Examples and Comparative Examples was identified by the same method as in Example 1 described above. The results are shown in Table 7.

[EUV Exposure Pattern Formation and Evaluation]

<Pattern Formation (6): Positive Pattern Formation>

AL412 (manufactured by Brewer Science, inc.) was applied onto a silicon wafer and baked at 205°C for 60 seconds to form an underlayer film having a film thickness of 30 nm. The resist composition shown in Table 6 was applied thereon and pre-baked (PB) at 120°C for 60 seconds to form a positive-tone resist film having a film thickness of 30 nm.

The resist film was subjected to patternwise irradiation using an EUV exposure device (manufactured by Exitech Ltd., Micro Exposure Tool, NA 0.3, Quadrupol, outer sigma 0.68, inner sigma 0.36). Further, as a reticle, a mask having a line size = 40 nm and a line:space = 1: 1 was used.

The resist film after the exposure was post-exposure baked (PEB) at 120°C for 60 seconds, developed with an aqueous tetramethylammonium hydroxide solution (TMAH, 2.38%-by-mass) for 30 seconds, and then rinsed with pure water for 30 seconds. A line-and-space pattern having a pitch of 80 nm and a line width of 40 nm (space width: 40 nm) was obtained by rotating the silicon wafer at a rotation speed of 4,000 rpm for 30 seconds and baking at 90°C for 60 seconds.

<Pattern Formation (7): Negative Pattern Formation>

Pattern Formation (7) was carried out by the same method as Pattern Formation (6), except that a pattern was formed using a negative-tone developer (butyl acetate).

(Evaluation)

The shape after pattern formation ([B] column), the number (pieces) of defects after pattern formation ([C] column), the change (nm) in the line width after the lapse of one month ([G] column), and the number (pieces) of defects after the lapse of one month ([H] column) were evaluated by the same method as for the ArF exposure.

Table 7 is shown below.

In the "Content of halogen-based solvent" column in Table 7, "Number of times of crystallization of compound" is intended to be the number of purification steps by crystallization during the synthesis of the compound (photoacid generator). In addition, "Content" is intended to be the content of the halogen-based solvent with respect to the total mass of the resist composition.

Furthermore, it is confirmed that halogen-based solvents other than methylene chloride are present at a detection limit value or less.

In Table 7, in the "Content of metal atoms" column, "Number of times of filtration" is intended to be "Number of cycles" in a case where filtration through a polyethylene-made filter having a pore diameter of 50 nm at first, then through a nylon-made filter having a pore diameter of 10 nm, and finally through a polyethylene-made filter having a pore diameter of 5 nm in this order is taken as one cycle. In addition, "Content" is intended to be the content of the metal atoms with respect to the total mass of the resist composition.

[A] column in Table 7: Indicates which of the pattern forming methods (6) and (7) was carried out to form a pattern, with regard to a pattern forming method.

The [B] to [I] columns in Table 7 have the same definitions as for the evaluation performed at the time of ArF exposure, and specific evaluation methods thereof are as described above.

"-" in Table 7 is intended to be not measured.

In Table 7, in the "Content of halogen-based solvent" column and the "Content of metal atoms" column, ppt, ppb, and ppm are all based on mass.

Furthermore, the content (% by mass) of the halogen-based solvent with respect to the total mass of each of resist compositions shown in Table 7 and the content (% by mass) of the halogen-based solvent with respect to the total mass of the film in the pre-baked (PB) resist film formed by each of the resist compositions were compared, and the content of the halogen-based solvent with respect to the total mass of the film in the resist film was an amount of 20% to 100% of the content of the halogen-based solvent with respect to the total mass of the composition in the resist composition.

[Table 7]

| | Resist composition | Content of halogen-based solvent | | Content of metal atoms | | Pattern forming method [A] | Shape [B] | Number [pieces] of defects after pattern formation [C] | Shape after etching [D] | Number [pieces] of defects after etching [E] | Difference [pieces] in number of defects between before and after etching [F] ([E] - [C]) | Change [nm] in line width after lapse of one month [G] | Number [pieces] of defects after lapse of one month [H] | Deterioration number [pieces] of defects over time [I] ([H] - [C]) |
|---|---|---|---|---|---|---|---|---|---|---|---|---|---|---|
| | | Number of times of crystallization of compound (photoacid generator) | Content | Number of times of filtration | Content | | | | | | | | | |
| Example 201 | Re-201 | 3 | 222 ppb | 3 | 320 ppt | (6) | 2 | 94 | - | - | - | < 1 nm | 369 | 275 |
| Example 202 | Re-202 | 3 | 189 ppb | 3 | 684 ppt | (7) | 2 | 128 | - | - | - | < 1 nm | 392 | 264 |
| Comparative Example 201 | Re-203 | 3 | 213 ppm | 3 | 300 ppt | (6) | 2 | 167 | - | - | - | 6 nm | 18,664 | 18,497 |

From the results of Table 7, it is clear that the rectangularity in the cross-sectional shape of a pattern formed with the resist compositions of Examples is excellent ("Shape": see [B column]), and a dimensional variation of the line width of a pattern thus formed hardly occurs even in a case where the resist composition is used after the lapse of time from the preparation thereof ("Change in line width after lapse of one month": see [G column]). Further, according to the resist compositions of Examples, it is clear that the number of defects deteriorated over time ([see I column]) can be reduced.

From the results of Table 7, it is clear that the resist compositions of Comparative Examples do not satisfy desired requirements.

[Preparation of Resist Composition for EB Exposure and Pattern Formation]

[Preparation of Resist Composition for EB Exposure]

<Preparation of Resist Compositions Re-301 to Re-303>

Various components shown in Table 8 were mixed and a mixed liquid thus obtained was then filtered through a polytetrafluoroethylene filter having a pore diameter of 0.03 μm. Further, resist compositions Re-301 to Re-303 were prepared by adjusting the number of times of filtration described above to appropriately adjust the content of the metal atoms.

[Table 8]

| | Resist composition | | | | | | | | | | | |
|---|---|---|---|---|---|---|---|---|---|---|---|---|
| | Acid-decomposable resin | | Photoacid generator | | Acid diffusion control agent | | Surfactant | | Crosslinking agent | | Solvent | |
| | Type | Content [parts by mass] | Type | Content [parts by mass] | Type | Content [parts by mass] | Type | Content [parts by mass] | Type | Content [parts by mass] | Type | Content [parts by mass] |
| Re-301 | A-45 | 100 | P-5 | 12 | Q-1 | 2 | H-1 | 0.2 | G-1 | 20 | F-1/F-4 | 2,530/400 |
| Re-302 | A-46 | 100 | P-11 | 12 | Q-3 | 1 | H-1 | 0.2 | - | - | F-1/F-4 | 2,530/400 |
| Re-303 | A-46 | 100 | P-X | 12 | Q-1 | 2 | H-1 | 0.2 | - | - | F-1/F-4 | 2,530/400 |

[Identification of Content of Halogen-Based Solvent]

The content of the halogen-based solvent in Examples and Comparative Examples was identified by the same method as in Example 1 described above. The results are shown in Table 9.

[Identification of Content of Metal Atoms]

The content of the metal atoms in Examples and Comparative Examples was identified by the same method as in Example 1 described above. The results are shown in Table 9.

[EB Exposure Pattern Formation and Evaluation]

<Pattern Formation (8)>

The resist composition shown in Table 8 was applied onto a 6-inch wafer using a spin coater Mark8 manufactured by Tokyo Electron Limited, and pre-baked (PB) on a hot plate at 110°C for 90 seconds to obtain a resist film having a film thickness of 80 nm.

This resist film was subjected to patternwise irradiation using an electron beam lithography device (ELS-7500 manufactured by Elionix Co., Ltd., acceleration voltage of 50 KeV). Further, as a reticle, a mask having a line size = 100 nm and a line: space =1:1 was used. After irradiation, the film was pre-baked (PEB) on a hot plate at 110°C for 90 seconds, immersed in a 2.38-% by-mass aqueous tetramethylammonium hydroxide solution as a developer for 60 seconds, then rinsed with pure water for 30 seconds, and dried to obtain a line-and-space pattern having a pitch of 100 nm and a line width of 100 nm (space width of 100 nm).

(Evaluation)

The shape after pattern formation ([B] column), the number (pieces) of defects after pattern formation ([C] column), and the change (nm) in the line width after the lapse of one month ([G] column) were evaluated by the same method as for the ArF exposure.

Table 9 is shown below.

In the "Content of halogen-based solvent" column in Table 9, "Number of times of crystallization of compound" is intended to be the number of purification steps by crystallization during the synthesis of the compound (photoacid generator). In addition, "Content" is intended to be the content of the halogen-based solvent with respect to the total mass of the resist composition.

Furthermore, it is confirmed that halogen-based solvents other than methylene chloride are present at a detection limit value or less.

In Table 9, in the "Content of metal atoms" column, "Number of times of filtration" is intended to mean the number of times of filtration filtered with a polytetrafluoroethylene filter having a pore size of 0.03 μm. In addition, "Content" is intended to be the content of the metal atoms with respect to the total mass of the resist composition.

[A] column in Table 9: Indicates which of the pattern forming method (8) was carried out to form a pattern, with regard to a pattern forming method.

The [B] to [I] columns in Table 9 have the same definitions as for the evaluation performed at the time of ArF exposure, and specific evaluation methods thereof are as described above.

"-" in Table 9 is intended to be not measured.

In Table 9, in the "Content of halogen-based solvent" column and the "Content of metal atoms" column, ppt, ppb, and ppm are all based on mass.

The content (% by mass) of the halogen-based solvent with respect to the total mass of each of resist compositions shown in Table 9 and the content (% by mass) of the halogen-based solvent with respect to the total mass of the film in the pre-baked (PB) resist film formed by each of the resist compositions was compared, and the content of the halogen-based solvent with respect to the total mass of the film in the resist film was an amount of 20% to 100% of the content of the halogen-based solvent with respect to the total mass of the composition in the resist composition.

[Table 9]

| | Resist composition | Content of halogen-based solvent | | Content of metal atoms | | Pattern forming method [A] | Shape [B] | Number [pieces] of defects after pattern formation [C] | Shape after etching [D] | Number [pieces]of defects after etching [E] | Difference [pieces] in number of defects between before and after etching [F] ([E] - [C]) | Change [nm] in line width after lapse of one month [G] | Number [pieces] of defects after lapse of one month [H] | Deterioration number [pieces] of defects over time [I] ([H] - [C]) |
|---|---|---|---|---|---|---|---|---|---|---|---|---|---|---|
| | | Number of times of crystallization of compound (photoacid generator) | Content | Number of times of filtration | Content | | | | | | | | | |
| Example 301 | Re-301 | 3 | 211 ppb | 3 | 456 ppt | (8) | 2 | 246 | - | - | - | < 1 nm | - | - |
| Example 302 | Re-302 | 3 | 135 ppb | 3 | 189 ppt | (8) | 2 | 187 | - | - | - | < 1 nm | - | - |
| Comparative Example 301 | Re-303 | 3 | 213 ppm | 3 | 258 ppt | (8) | 2 | 341 | - | - | - | 16 nm | - | - |

From the results of Table 9, it is clear that the rectangularity in the cross-sectional shape of a pattern formed with the resist compositions of Examples is excellent ("Shape": see [B column]), and a dimensional variation of the line width of a pattern thus formed hardly occurs even in a case where the resist composition is used after the lapse of time from the preparation thereof ("Change in line width after lapse of one month": see [G column]).
From the results of Table 9, it is clear that the resist compositions of Comparative Examples do not satisfy desired requirements.

Explanation of References

10: pattern
X: angle

## Claims

1. An actinic ray-sensitive or radiation-sensitive resin composition comprising:

   a resin having a polarity that increases through decomposition by an action of an acid;
   a compound that generates an acid upon irradiation with actinic rays or radiation; and
   a halogen-based solvent,
   wherein a content of the halogen-based solvent is from 1 ppb by mass to 50 ppm by mass with respect to a total mass of the composition.

2. The actinic ray-sensitive or radiation-sensitive resin composition according to claim 1,
   wherein the content of the halogen-based solvent is from 1 ppb by mass to 10 ppm by mass with respect to the total mass of the composition.

3. The actinic ray-sensitive or radiation-sensitive resin composition according to claim 1 or 2,
   wherein the content of the halogen-based solvent is from 1 ppb by mass to 1 ppm by mass with respect to the total mass of the composition.

4. The actinic ray-sensitive or radiation-sensitive resin composition according to any one of claims 1 to 3, further comprising metal atoms,
   wherein a content of the metal atoms is from 1 ppt by mass to 30 ppb by mass with respect to the total mass of the composition.

5. The actinic ray-sensitive or radiation-sensitive resin composition according to claim 4,
   wherein the content of the metal atoms is from 1 ppt by mass to 10 ppb by mass with respect to the total mass of the composition.

6. The actinic ray-sensitive or radiation-sensitive resin composition according to claim 4 or 5,
   wherein the content of the metal atoms is from 1 ppt by mass to 1,000 ppt by mass with respect to the total mass of the composition.

7. The actinic ray-sensitive or radiation-sensitive resin composition according to any one of claims 1 to 6,

   wherein the resin includes one or more selected from the group consisting of Resins X1 to X3,
   Resin X1: a resin including a repeating unit A derived from one or more monomers selected from the following monomer group A and a repeating unit B derived from one or more monomers selected from the following monomer group B,
   Resin X2: a resin including a repeating unit A derived from one or more monomers selected from the following monomer group A, a repeating unit B derived from one or more monomers selected from the following monomer group B, and a repeating unit C derived from one or more monomers selected from the following monomer group C, and
   Resin X3: a resin including a repeating unit including an aromatic ring, and at least one repeating unit of a repeating unit A derived from one or more monomers selected from the following monomer group A or a repeating

unit B derived from one or more monomers selected from the following monomer group B,
Monomer group A:

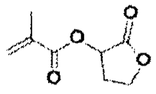
(a-1)
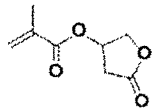
(a-2)
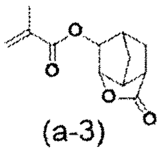
(a-3)
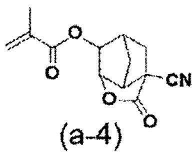
(a-4)
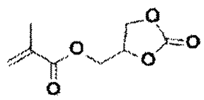
(a-5)

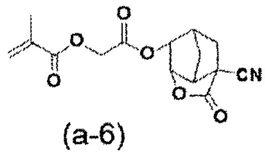
(a-6)
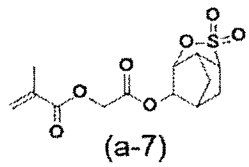
(a-7)
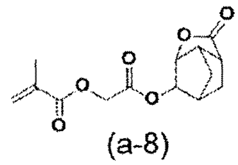
(a-8)

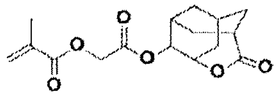
(a-9)
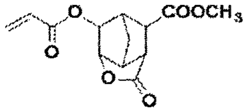
(a-10)
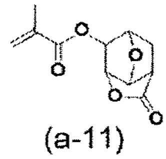
(a-11)
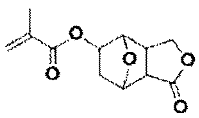
(a-12)

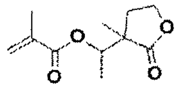
(a-13)
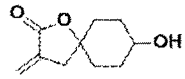
(a-14)
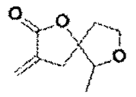
(a-15)
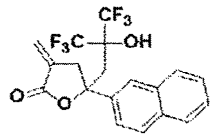
(a-16)

Monomer group B:

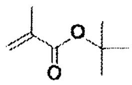
(b-1)
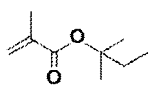
(b-2)
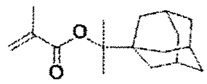
(b-3)
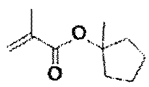
(b-4)
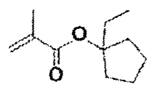
(b-5)

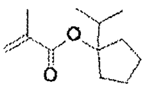
(b-6)
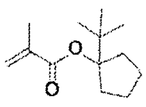
(b-7)
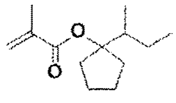
(b-8)
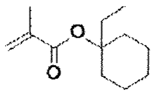
(b-9)
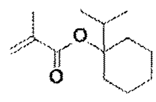
(b-10)

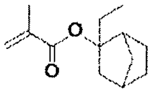
(b-11)
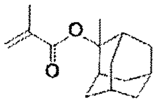
(b-12)
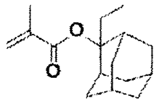
(b-13)
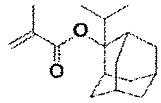
(b-14)
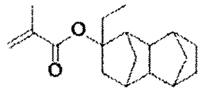
(b-15)

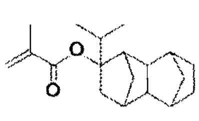
(b-16)
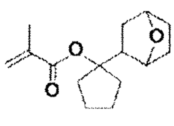
(b-17)
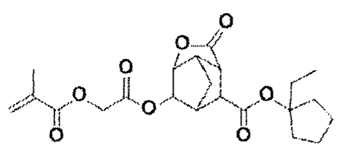
(b-18)

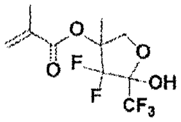
(b-19)

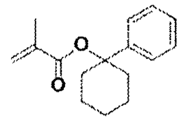
(b-20)

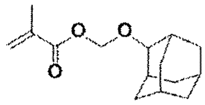
(b-21)

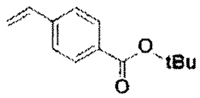
(b-22)

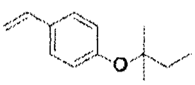
(b-23)

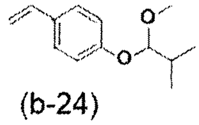
(b-24)

Monomer group C:

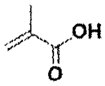
(c-1)

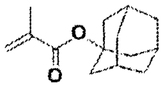
(c-2)

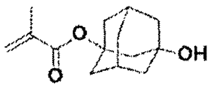
(c-3)

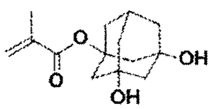
(c-4)

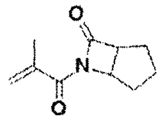
(c-5)

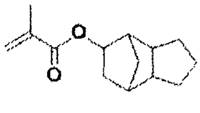
(c-6)

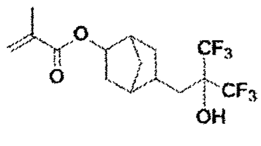
(c-7)

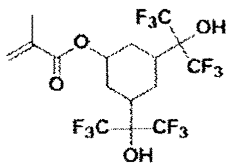
(c-8)

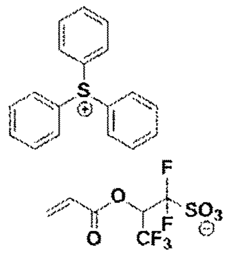
(c-9)

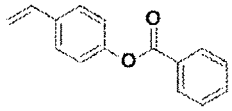
(c-10)

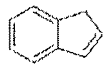
(c-11)

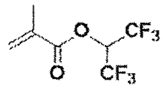
(c-12)

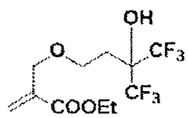
(c-13)

.

**8.** The actinic ray-sensitive or radiation-sensitive resin composition according to claim 7,

wherein the monomer group A is the following monomer group A1,
Monomer group A1:

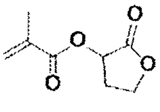
(a-1)

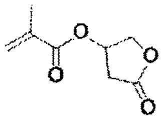
(a-2)

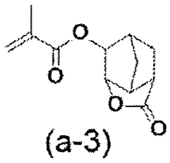
(a-3)

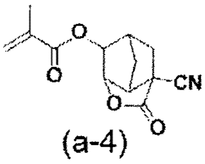
(a-4)

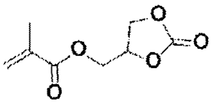
(a-5)

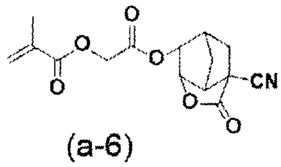
(a-6)

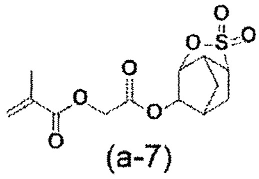
(a-7)

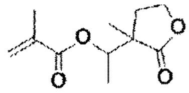
(a-13)

**9.** The actinic ray-sensitive or radiation-sensitive resin composition according to claim 7 or 8,

wherein the monomer group B is the following monomer group B1,
Monomer group B1:

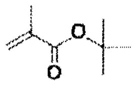
(b-1)

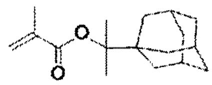
(b-3)

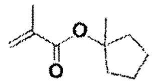
(b-4)

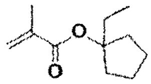
(b-5)

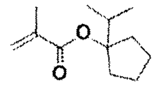
(b-6)

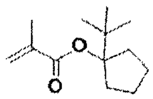
(b-7)

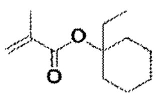
(b-9)

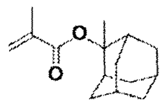
(b-12)

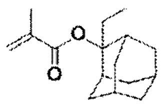
(b-13)

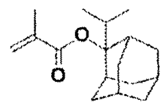
(b-14) .

**10.** The actinic ray-sensitive or radiation-sensitive resin composition according to any one of claims 7 to 9,

wherein the monomer group C is the following monomer group C1,
Monomer group C1:

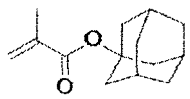
(c-2)

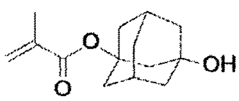
(c-3) .

**11.** The actinic ray-sensitive or radiation-sensitive resin composition according to any one of claims 7 to 10, wherein the repeating unit including an aromatic ring includes a repeating unit derived from at least one monomer of Formula (d-1) or Formula (d-2),

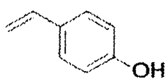
(d-1)

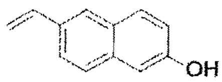
(d-2) .

**12.** The actinic ray-sensitive or radiation-sensitive resin composition according to any one of claims 1 to 11, wherein the resin is a resin selected from the group consisting of Formula (A-1), Formula (A-3), Formula (A-4), Formula (A-6), Formula (A-8), Formula (A-12), Formula (A-13), Formula (A-14), Formula (A-16), Formula (A-19), Formula (A-41), Formula (A-42), Formula (A-43), Formula (A-46), and Formula (A-48),

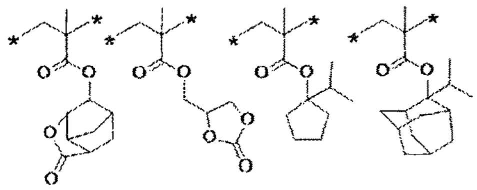

(A-1)

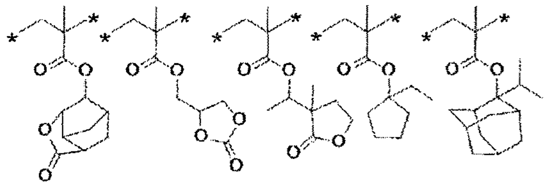

(A-3)

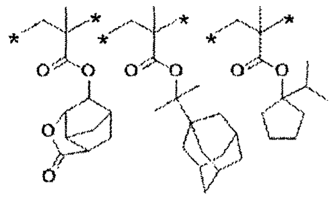

(A-4)

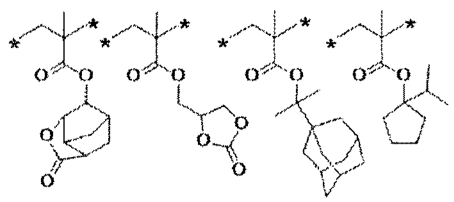

(A-6)

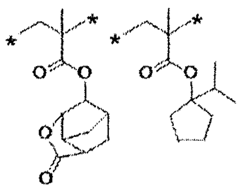

(A-8)

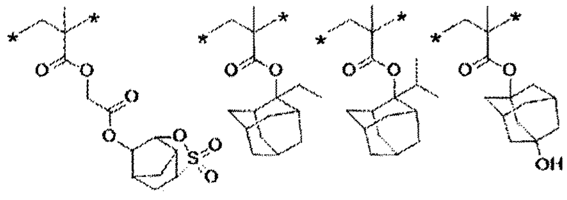

(A-12)

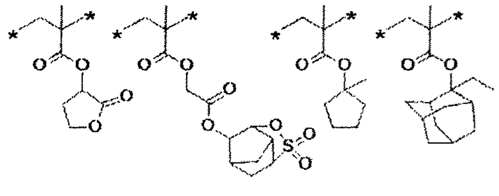

(A-13)

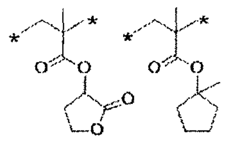
(A-14)

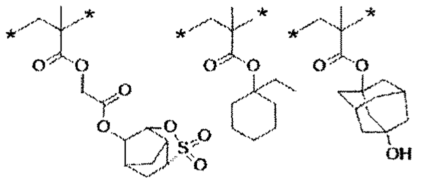
(A-16)

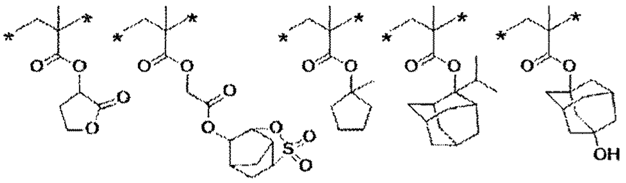
(A-19)

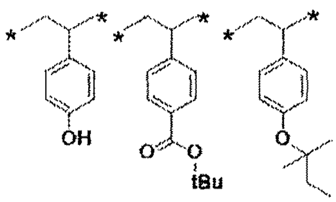
(A-41)

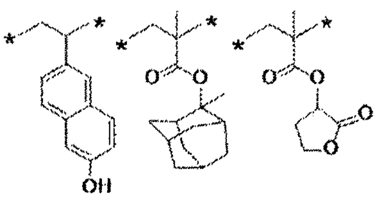
(A-42)

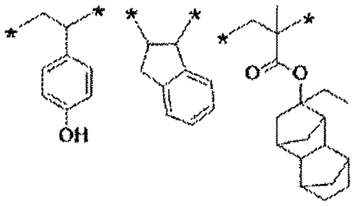
(A-43)

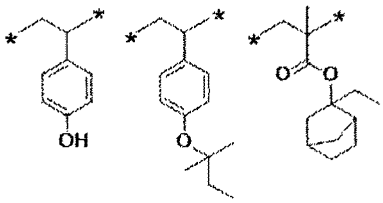
(A-46)

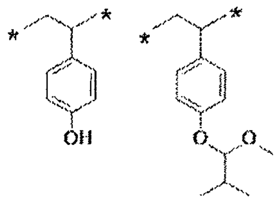

(A-48)

.

**13.** The actinic ray-sensitive or radiation-sensitive resin composition according to any one of claims 1 to 12, wherein the compound that generates an acid upon irradiation with actinic rays or radiation includes one or more compounds selected from the group consisting of Formulae (P-1) to (P-14),

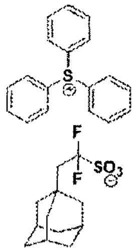

(P-1)

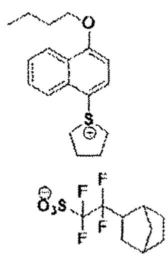

(P-2)

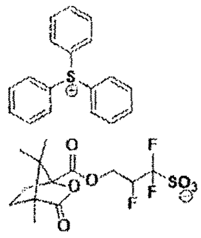

(P-3)

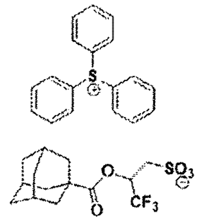

(P-4)

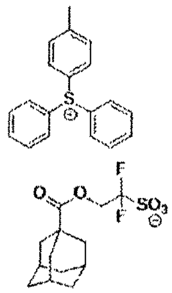

(P-5)

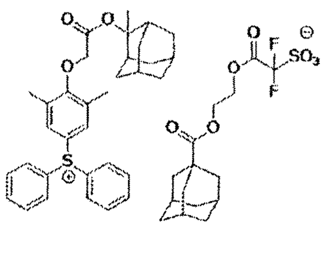

(P-6

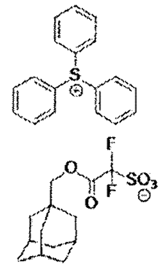

(P-7)

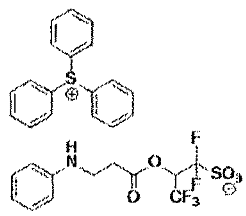

(P-8)

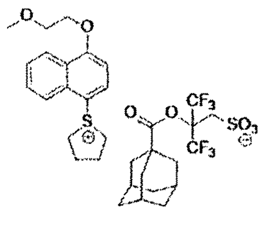

(P-9)

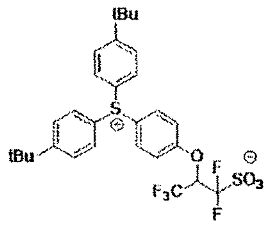

(P-10)

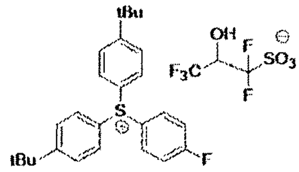

(P-11)

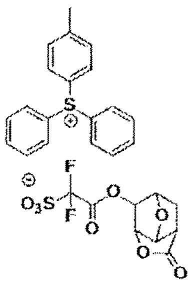

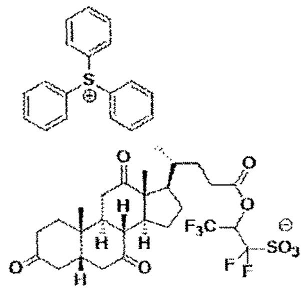

(P-12)

(P-13)

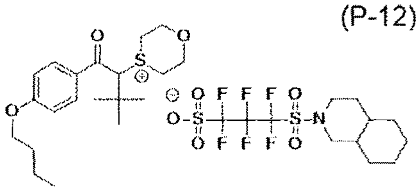

(P-14)

14. The actinic ray-sensitive or radiation-sensitive resin composition according to any one of claims 1 to 13, further comprising an acid diffusion control agent.

15. The actinic ray-sensitive or radiation-sensitive resin composition according to any one of claims 1 to 14, wherein the actinic ray-sensitive or radiation-sensitive resin composition includes methylene chloride as the halogen-based solvent.

16. A resist film obtained using the actinic ray-sensitive or radiation-sensitive resin composition according to any one of claims 1 to 15.

17. A pattern forming method comprising:

a step of forming a resist film on a substrate, using the actinic ray-sensitive or radiation-sensitive resin composition according to any one of claims 1 to 15;
a step of exposing the resist film; and
a step of developing the exposed resist film using a developer to form a pattern.

18. A method for manufacturing an electronic device, comprising the pattern forming method according to claim 17.

FIG. 1

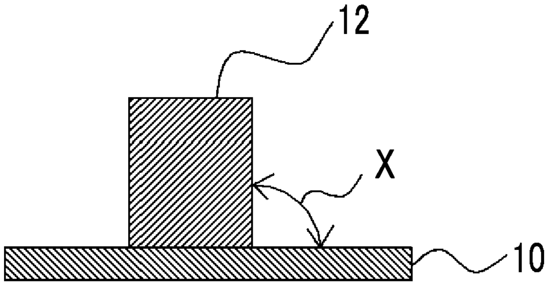


FIG. 2

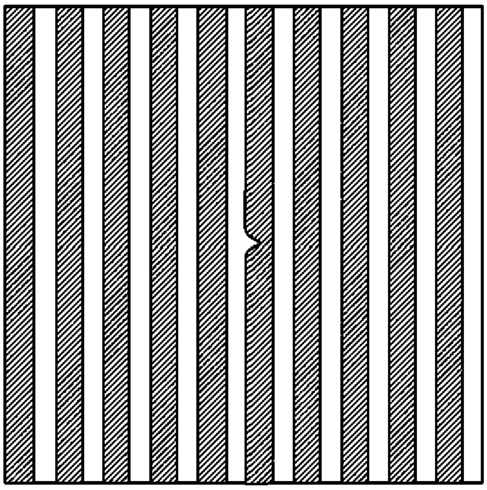

FIG. 3

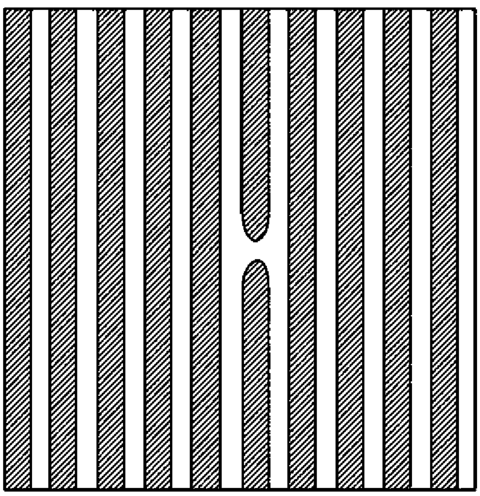

## INTERNATIONAL SEARCH REPORT

International application No.
PCT/JP2019/044308

A. CLASSIFICATION OF SUBJECT MATTER
C08F 220/28(2006.01)i; G03F 7/004(2006.01)i; G03F 7/038(2006.01)i; G03F 7/039(2006.01)i; G03F 7/20(2006.01)i
FI: G03F7/004 501; G03F7/039 601; G03F7/038 601; C08F220/28; G03F7/20 501; G03F7/20 521
According to International Patent Classification (IPC) or to both national classification and IPC

B. FIELDS SEARCHED
Minimum documentation searched (classification system followed by classification symbols)
C08F220/28; G03F7/004; G03F7/038; G03F7/039; G03F7/20

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2014-130280 A (FUJIFILM CORPORATION) 10.07.2014 (2014-07-10) claims 1, 7, 10, 12, 14, paragraphs [0135]-[0271], [0452], examples | 1, 7-18<br>2-6 |
| A | JP 2018-072358 A (FUJIFILM CORPORATION) 10.05.2018 (2018-05-10) paragraph [0534] | 13 |
| A | WO 2017/115606 A1 (FUJIFILM CORPORATION) 06.07.2017 (2017-07-06) paragraph [0092] | 1-18 |

☐ Further documents are listed in the continuation of Box C.  ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24 January 2020 (24.01.2020) | 04 February 2020 (04.02.2020) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2019/044308

| Patent Documents referred in the Report | Publication Date | Patent Family | Publication Date |
|---|---|---|---|
| JP 2014-130280 A | 10 Jul. 2014 | US 2015/0277225 A1 claims 1, 7, 10, 12, 14, paragraphs [0199]-[0373], [0627], examples<br>WO 2014/103644 A1<br>TW 201426174 A<br>KR 10-2015-0080625 A | |
| JP 2018-072358 A | 10 May 2018 | WO 2016/140000 A1<br>TW 201632990 A | |
| WO 2017/115606 A1 | 06 Jul. 2017 | TW 201736952 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011227509 A
- JP 2014041327 A
- US 20160070167 A1
- US 20150004544 A1
- US 20160237190 A1
- US 20160274458 A1
- US 20120135348 A1
- US 20150309408 A1
- US 20120251948 A1
- JP 2014010245 A
- JP 2011248019 A
- JP 2010175859 A
- JP 2012032544 A
- US 20080248425 A
- JP 2002090991 A
- US 20160147154 A1
- US 20160282720 A1
- JP 4122938 A
- JP H04122938 A
- JP 2028531 A
- JP H02028531 A
- US 4916210 A
- EP 219294 B
- JP 2014059543 A
- JP 2013061648 A
- JP 2009267112 A
- WO 2014002808 A
- JP 2004235468 A
- US 20100020297 A
- JP 2008083384 A
- JP 3270227 A
- JP H03270227 A
- JP 2013164509 A
- JP 2006184109 A


### Non-patent literature cited in the description


- Chemical Handbook (II). Chemical Society of Japan, Maruzen Company, Ltd, 1993
- *Proceeding of SPIE,* 1996, vol. 2724, 355
- *Journal of The International Society for Optical Engineering (Proc. of SPIE),* 2008, vol. 6924, 692420
- Chapter 4 Etching. Semiconductor Process Text Book. SEMI Japan, 2007
- EUV Resist Curing Technique for LWR Reduction and Etch Selectivity Enhancement. *Proc. of SPIE*
- *ACS Nano,* vol. 4 (8), 4815-4823